# EUROPEAN PATENT APPLICATION

(11) **EP 4 645 389 A1**
(43) Date of publication of application: **05.11.2025**
(21) Application number: 23911859.9
(22) Date of filing: 20.12.2023
(51) Int. Cl.: H01L 27/146

(54) **LIGHT DETECTION DEVICE AND ELECTRONIC EQUIPMENT**

(30) Priority: 27.12.2022 JP 2022210858
(71) Applicant: Sony Semiconductor Solutions Corporation, Atsugi-shi, Kanagawa 243-0014 (JP)
(72) Inventor: TAKASE, Hiroaki, Atsugi-shi, Kanagawa 243-0014 (JP); SAITO, Hiroshi, Atsugi-shi, Kanagawa 243-0014 (JP); IKEHARA, Shigehiro, Atsugi-shi, Kanagawa 243-0014 (JP); MIYANAMI, Yuki, Atsugi-shi, Kanagawa 243-0014 (JP); FUKUDA, Makoto, Atsugi-shi, Kanagawa 243-0014 (JP); KOJIMA, Takashi, Atsugi-shi, Kanagawa 243-0014 (JP); MATSUGAI, Hiroyasu, Atsugi-shi, Kanagawa 243-0014 (JP); ISHII, Yoshiyuki, Atsugi-shi, Kanagawa 243-0014 (JP); OSHIYAMA, Itaru, Atsugi-shi, Kanagawa 243-0014 (JP); NOGUCHI, Sayato, Atsugi-shi, Kanagawa 243-0014 (JP); UESAKA, Jumpei, Atsugi-shi, Kanagawa 243-0014 (JP); TAKASE, Masayuki, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/045589
(87) International publication number: WO 2024/143079

(57) **Abstract**

A photodetector according to an embodiment of the present disclosure includes: a lens on which light is incident; a first photoelectric conversion section that photoelectrically converts light transmitted through the lens; a second photoelectric conversion section provided next to the first photoelectric conversion section and photoelectrically converting light transmitted through the lens; and a first light-guiding member provided above the first photoelectric conversion section and having a refractive index higher than a refractive index of an adjacent medium.

## Description

### Technical Field

The present disclosure relates to a photodetector and an electronic apparatus.

### Background Art

A device has been proposed which includes a pixel including two photoelectric conversion sections for one microlens, and a light-blocking member provided between the two photoelectric conversion sections, and which performs focus detection in a pupil division phase difference system (PTL 1).

### Citation List

### Patent Literature

PTL 1: Japanese Unexamined Patent Application Publication No. 2022-31322

### Summary of the Invention

It is required, in a device to detect light, to suppress deterioration in accuracy of photodetection.

It is desirable to provide a photodetector that makes it possible to suppress deterioration in accuracy of photodetection.

A photodetector according to an embodiment of the present disclosure includes: a lens on which light is incident; a first photoelectric conversion section that photoelectrically converts light transmitted through the lens; a second photoelectric conversion section provided next to the first photoelectric conversion section and photoelectrically converting light transmitted through the lens; and a first light-guiding member provided above the first photoelectric conversion section and having a refractive index higher than a refractive index of an adjacent medium.

An electronic apparatus according to an embodiment of the present disclosure includes: an optical system; and a photodetector that receives light transmitted through the optical system. The photodetector includes a lens on which light is incident, a first photoelectric conversion section that photoelectrically converts light transmitted through the lens, a second photoelectric conversion section provided next to the first photoelectric conversion section and photoelectrically converting light transmitted through the lens, and a first light-guiding member provided above the first photoelectric conversion section and having a refractive index higher than a refractive index of an adjacent medium.

### Brief Description of the Drawings

[FIG. 1] FIG. 1 is a block diagram illustrating an example of a schematic configuration of an imaging device which is an example of a photodetector according to a first embodiment of the present disclosure.
[FIG. 2] FIG. 2 is a diagram illustrating an example of a pixel section of an imaging device according to the first embodiment of the present disclosure.
[FIG. 3] FIG. 3 is a diagram illustrating an example of a cross-sectional configuration of the imaging device according to the first embodiment of the present disclosure.
[FIG. 4] FIG. 4 is a diagram illustrating an example of a planar configuration of the imaging device according to the first embodiment of the present disclosure.
[FIG. 5] FIG. 5 is a diagram illustrating an example of the cross-sectional configuration of the imaging device according to the first embodiment of the present disclosure.
[FIG. 6] FIG. 6 is a diagram illustrating an example of the planar configuration of the imaging device according to the first embodiment of the present disclosure.
[FIG. 7] FIG. 7 is a diagram illustrating an example of the cross-sectional configuration of the imaging device according to the first embodiment of the present disclosure.
[FIG. 8A] FIG. 8A is a diagram illustrating an example of a method of manufacturing the imaging device according to the first embodiment of the present disclosure.
[FIG. 8B] FIG. 8B is a diagram illustrating an example of the method of manufacturing the imaging device according to the first embodiment of the present disclosure.
[FIG. 8C] FIG. 8C is a diagram illustrating an example of the method of manufacturing the imaging device according to the first embodiment of the present disclosure.
[FIG. 8D] FIG. 8D is a diagram illustrating an example of the method of manufacturing the imaging device according to the first embodiment of the present disclosure.
[FIG. 8E] FIG. 8E is a diagram illustrating an example of the method of manufacturing the imaging device according to the first embodiment of the present disclosure.
[FIG. 8F] FIG. 8F is a diagram illustrating an example of the method of manufacturing the imaging device according to the first embodiment of the present disclosure.
[FIG. 9] FIG. 9 is a diagram illustrating another example of the cross-sectional configuration of the imaging device according to the first embodiment of the present disclosure.
[FIG. 10] FIG. 10 is a diagram illustrating an example of a cross-sectional configuration of an imaging device according to a second embodiment of the present disclosure.
[FIG. 11A] FIG. 11A is a diagram illustrating an example of a method of manufacturing the imaging device according to the second embodiment of the present disclosure.
[FIG. 11B] FIG. 11B is a diagram illustrating an example of the method of manufacturing the imaging device according to the second embodiment of the present disclosure.
[FIG. 11C] FIG. 11C is a diagram illustrating an example of the method of manufacturing the imaging device according to the second embodiment of the present disclosure.
[FIG. 11D] FIG. 11D is a diagram illustrating an example of the method of manufacturing the imaging device according to the second embodiment of the present disclosure.
[FIG. 12] FIG. 12 is a diagram illustrating an example of a cross-sectional configuration of an imaging device according to a third embodiment of the present disclosure.
[FIG. 13] FIG. 13 is a diagram illustrating another example of the cross-sectional configuration of the imaging device according to the third embodiment of the present disclosure.
[FIG. 14] FIG. 14 is a diagram illustrating another example of the cross-sectional configuration of the imaging device according to the third embodiment of the present disclosure.
[FIG. 15] FIG. 15 is a diagram illustrating an example of a cross-sectional configuration of an imaging device according to Modification Example 1 of the present disclosure.
[FIG. 16] FIG. 16 is a diagram illustrating an example of a planar configuration of the imaging device according to Modification Example 1 of the present disclosure.
[FIG. 17] FIG. 17 is a diagram illustrating another example of the cross-sectional configuration of the imaging device according to Modification Example 1 of the present disclosure.
[FIG. 18] FIG. 18 is a diagram illustrating another example of the planar configuration of the imaging device according to Modification Example 1 of the present disclosure.
[FIG. 19] FIG. 19 is a diagram illustrating another example of the cross-sectional configuration of the imaging device according to Modification Example 1 of the present disclosure.
[FIG. 20] FIG. 20 is a diagram illustrating another example of the planar configuration of the imaging device according to Modification Example 1 of the present disclosure.
[FIG. 21] FIG. 21 is a diagram illustrating an example of an arrangement of pixels of an imaging device according to Modification Example 2 of the present disclosure.
[FIG. 22A] FIG. 22A is a diagram illustrating an example of a planar configuration of the imaging device according to Modification Example 2 of the present disclosure.
[FIG. 22B] FIG. 22B is a diagram illustrating another example of the planar configuration of the imaging device according to Modification Example 2 of the present disclosure.
[FIG. 22C] FIG. 22C is a diagram illustrating another example of the planar configuration of the imaging device according to Modification Example 2 of the present disclosure.
[FIG. 22D] FIG. 22D is a diagram illustrating another example of the planar configuration of the imaging device according to Modification Example 2 of the present disclosure.
[FIG. 22E] FIG. 22E is a diagram illustrating another example of the planar configuration of the imaging device according to Modification Example 2 of the present disclosure.
[FIG. 22F] FIG. 22F is a diagram illustrating another example of the planar configuration of the imaging device according to Modification Example 2 of the present disclosure.
[FIG. 22G] FIG. 22G is a diagram illustrating another example of the planar configuration of the imaging device according to Modification Example 2 of the present disclosure.
[FIG. 22H] FIG. 22H is a diagram illustrating another example of the planar configuration of the imaging device according to Modification Example 2 of the present disclosure.
[FIG. 22I] FIG. 22I is a diagram illustrating another example of the planar configuration of the imaging device according to Modification Example 2 of the present disclosure.
[FIG. 22J] FIG. 22J is a diagram illustrating another example of the planar configuration of the imaging device according to Modification Example 2 of the present disclosure.
[FIG. 23] FIG. 23 is a diagram illustrating an example of an arrangement of pixels of an imaging device according to Modification Example 3 of the present disclosure.
[FIG. 24A] FIG. 24A is a diagram illustrating an example of a planar configuration of the imaging device according to Modification Example 3 of the present disclosure.
[FIG. 24B] FIG. 24B is a diagram illustrating another example of the planar configuration of the imaging device according to Modification Example 3 of the present disclosure.
[FIG. 24C] FIG. 24C is a diagram illustrating another example of the planar configuration of the imaging device according to Modification Example 3 of the present disclosure.
[FIG. 24D] FIG. 24D is a diagram illustrating another example of the planar configuration of the imaging device according to Modification Example 3 of the present disclosure.
[FIG. 24E] FIG. 24E is a diagram illustrating another example of the planar configuration of the imaging device according to Modification Example 3 of the present disclosure.
[FIG. 24F] FIG. 24F is a diagram illustrating another example of the planar configuration of the imaging device according to Modification Example 3 of the present disclosure.
[FIG. 25A] FIG. 25A is a diagram illustrating another example of the planar configuration of the imaging device according to Modification Example 3 of the present disclosure.
[FIG. 25B] FIG. 25B is a diagram illustrating another example of the planar configuration of the imaging device according to Modification Example 3 of the present disclosure.
[FIG. 25C] FIG. 25C is a diagram illustrating another example of the planar configuration of the imaging device according to Modification Example 3 of the present disclosure.
[FIG. 26] FIG. 26 is a diagram illustrating an example of a cross-sectional configuration of an imaging device according to Modification Example 4 of the present disclosure.
[FIG. 27] FIG. 27 is a diagram illustrating another example of the cross-sectional configuration of the imaging device according to Modification Example 4 of the present disclosure.
[FIG. 28A] FIG. 28A is a diagram illustrating an example of a method of manufacturing the imaging device according to Modification Example 4 of the present disclosure.
[FIG. 28B] FIG. 28B is a diagram illustrating an example of the method of manufacturing the imaging device according to Modification Example 4 of the present disclosure.
[FIG. 28C] FIG. 28C is a diagram illustrating an example of the method of manufacturing the imaging device according to Modification Example 4 of the present disclosure.
[FIG. 28D] FIG. 28D is a diagram illustrating an example of the method of manufacturing the imaging device according to Modification Example 4 of the present disclosure.
[FIG. 29] FIG. 29 is a diagram illustrating an example of a cross-sectional configuration of an imaging device according to Modification Example 5 of the present disclosure.
[FIG. 30] FIG. 30 is a diagram illustrating another example of the cross-sectional configuration of the imaging device according to Modification Example 5 of the present disclosure.
[FIG. 31A] FIG. 31A is a diagram illustrating an example of a method of manufacturing the imaging device according to Modification Example 5 of the present disclosure.
[FIG. 31B] FIG. 31B is a diagram illustrating an example of the method of manufacturing the imaging device according to Modification Example 5 of the present disclosure.
[FIG. 31C] FIG. 31C is a diagram illustrating an example of the method of manufacturing the imaging device according to Modification Example 5 of the present disclosure.
[FIG. 32] FIG. 32 is a diagram illustrating an example of a cross-sectional configuration of an imaging device according to Modification Example 6 of the present disclosure.
[FIG. 33A] FIG. 33A is a diagram illustrating an example of a method of manufacturing the imaging device according to Modification Example 6 of the present disclosure.
[FIG. 33B] FIG. 33B is a diagram illustrating an example of the method of manufacturing the imaging device according to Modification Example 6 of the present disclosure.
[FIG. 34] FIG. 34 is a diagram illustrating an example of a cross-sectional configuration of an imaging device according to Modification Example 7 of the present disclosure.
[FIG. 35] FIG. 35 is a diagram illustrating another example of the cross-sectional configuration of the imaging device according to Modification Example 7 of the present disclosure.
[FIG. 36A] FIG. 36A is a diagram illustrating an example of a method of manufacturing the imaging device according to Modification Example 7 of the present disclosure.
[FIG. 36B] FIG. 36B is a diagram illustrating an example of the method of manufacturing the imaging device according to Modification Example 7 of the present disclosure.
[FIG. 36C] FIG. 36C is a diagram illustrating an example of the method of manufacturing the imaging device according to Modification Example 7 of the present disclosure.
[FIG. 36D] FIG. 36D is a diagram illustrating an example of the method of manufacturing the imaging device according to Modification Example 7 of the present disclosure.
[FIG. 36E] FIG. 36E is a diagram illustrating an example of the method of manufacturing the imaging device according to Modification Example 7 of the present disclosure.
[FIG. 37] FIG. 37 is a diagram illustrating an example of a cross-sectional configuration of an imaging device according to Modification Example 8 of the present disclosure.
[FIG. 38] FIG. 38 is a diagram illustrating another example of the cross-sectional configuration of the imaging device according to Modification Example 8 of the present disclosure.
[FIG. 39] FIG. 39 is a diagram illustrating another example of the cross-sectional configuration of the imaging device according to Modification Example 8 of the present disclosure.
[FIG. 40A] FIG. 40A is a diagram illustrating an example of an arrangement of pixels of an imaging device according to Modification Example 9 of the present disclosure.
[FIG. 40B] FIG. 40B is a diagram illustrating an example of the arrangement of pixels of the imaging device according to Modification Example 9 of the present disclosure.
[FIG. 40C] FIG. 40C is a diagram illustrating an example of the arrangement of pixels of the imaging device according to Modification Example 9 of the present disclosure.
[FIG. 40D] FIG. 40D is a diagram illustrating an example of the arrangement of pixels of the imaging device according to Modification Example 9 of the present disclosure.
[FIG. 40E] FIG. 40E is a diagram illustrating an example of the arrangement of pixels of the imaging device according to Modification Example 9 of the present disclosure.
[FIG. 40F] FIG. 40F is a diagram illustrating an example of the arrangement of pixels of the imaging device according to Modification Example 9 of the present disclosure.
[FIG. 40G] FIG. 40G is a diagram illustrating an example of the arrangement of pixels of the imaging device according to Modification Example 9 of the present disclosure.
[FIG. 40H] FIG. 40H is a diagram illustrating an example of the arrangement of pixels of the imaging device according to Modification Example 9 of the present disclosure.
[FIG. 40I] FIG. 40I is a diagram illustrating an example of the arrangement of pixels of the imaging device according to Modification Example 9 of the present disclosure.
[FIG. 40J] FIG. 40J is a diagram illustrating an example of the arrangement of pixels of the imaging device according to Modification Example 9 of the present disclosure.
[FIG. 41] FIG. 41 is a diagram illustrating an example of a cross-sectional configuration of an imaging device according to Modification Example 10 of the present disclosure.
[FIG. 42A] FIG. 42A is a diagram illustrating another example of the cross-sectional configuration of the imaging device according to Modification Example 10 of the present disclosure.
[FIG. 42B] FIG. 42B is a diagram illustrating another example of the cross-sectional configuration of the imaging device according to Modification Example 10 of the present disclosure.
[FIG. 43] FIG. 43 is a diagram illustrating an example of a cross-sectional configuration of an imaging device according to a fourth embodiment of the present disclosure.
[FIG. 44] FIG. 45 is a diagram illustrating another example of the cross-sectional configuration of the imaging device according to the fourth embodiment of the present disclosure.
[FIG. 45A] FIG. 45A is a diagram illustrating an example of a method of manufacturing the imaging device according to the fourth embodiment of the present disclosure.
[FIG. 45B] FIG. 45B is a diagram illustrating an example of the method of manufacturing the imaging device according to the fourth embodiment of the present disclosure.
[FIG. 45C] FIG. 45C is a diagram illustrating an example of the method of manufacturing the imaging device according to the fourth embodiment of the present disclosure.
[FIG. 45D] FIG. 45D is a diagram illustrating an example of the method of manufacturing the imaging device according to the fourth embodiment of the present disclosure.
[FIG. 45E] FIG. 45E is a diagram illustrating an example of the method of manufacturing the imaging device according to the fourth embodiment of the present disclosure.
[FIG. 45F] FIG. 45F is a diagram illustrating an example of the method of manufacturing the imaging device according to the fourth embodiment of the present disclosure.
[FIG. 45G] FIG. 45G is a diagram illustrating an example of the method of manufacturing the imaging device according to the fourth embodiment of the present disclosure.
[FIG. 46] FIG. 46 is a diagram illustrating another example of the cross-sectional configuration of the imaging device according to the fourth embodiment of the present disclosure.
[FIG. 47] FIG. 47 is a diagram illustrating another example of the cross-sectional configuration of the imaging device according to the fourth embodiment of the present disclosure.
[FIG. 48A] FIG. 48A is a diagram illustrating another example of the method of manufacturing the imaging device according to the fourth embodiment of the present disclosure.
[FIG. 48B] FIG. 48B is a diagram illustrating another example of the method of manufacturing the imaging device according to the fourth embodiment of the present disclosure.
[FIG. 48C] FIG. 48C is a diagram illustrating another example of the method of manufacturing the imaging device according to the fourth embodiment of the present disclosure.
[FIG. 48D] FIG. 48D is a diagram illustrating another example of the method of manufacturing the imaging device according to the fourth embodiment of the present disclosure.
[FIG. 48E] FIG. 48E is a diagram illustrating another example of the method of manufacturing the imaging device according to the fourth embodiment of the present disclosure.
[FIG. 48F] FIG. 48F is a diagram illustrating another example of the method of manufacturing the imaging device according to the fourth embodiment of the present disclosure.
[FIG. 48G] FIG. 48G is a diagram illustrating another example of the method of manufacturing the imaging device according to the fourth embodiment of the present disclosure.
[FIG. 48H] FIG. 48H is a diagram illustrating another example of the method of manufacturing the imaging device according to the fourth embodiment of the present disclosure.
[FIG. 49] FIG. 49 is a diagram illustrating an example of a cross-sectional configuration of an imaging device according to a fifth embodiment of the present disclosure.
[FIG. 50] FIG. 50 is a diagram illustrating an example of a cross-sectional configuration of the imaging device according to the fifth embodiment of the present disclosure.
[FIG. 51A] FIG. 51A is a diagram illustrating another example of the method of manufacturing the imaging device according to the fifth embodiment of the present disclosure.
[FIG. 51B] FIG. 51B is a diagram illustrating another example of the method of manufacturing the imaging device according to the fifth embodiment of the present disclosure.
[FIG. 51C] FIG. 51C is a diagram illustrating another example of the method of manufacturing the imaging device according to the fifth embodiment of the present disclosure.
[FIG. 51D] FIG. 51D is a diagram illustrating another example of the method of manufacturing the imaging device according to the fifth embodiment of the present disclosure.
[FIG. 51E] FIG. 51E is a diagram illustrating another example of the method of manufacturing the imaging device according to the fifth embodiment of the present disclosure.
[FIG. 51F] FIG. 51F is a diagram illustrating another example of the method of manufacturing the imaging device according to the fifth embodiment of the present disclosure.
[FIG. 51G] FIG. 51G is a diagram illustrating another example of the method of manufacturing the imaging device according to the fifth embodiment of the present disclosure.
[FIG. 51H] FIG. 51H is a diagram illustrating another example of the method of manufacturing the imaging device according to the fifth embodiment of the present disclosure.
[FIG. 51I] FIG. 51I is a diagram illustrating another example of the method of manufacturing the imaging device according to the fifth embodiment of the present disclosure.
[FIG. 51J] FIG. 51J is a diagram illustrating another example of the method of manufacturing the imaging device according to the fifth embodiment of the present disclosure.
[FIG. 51K] FIG. 51K is a diagram illustrating another example of the method of manufacturing the imaging device according to the fifth embodiment of the present disclosure.
[FIG. 51L] FIG. 51L is a diagram illustrating another example of the method of manufacturing the imaging device according to the fifth embodiment of the present disclosure.
[FIG. 51M] FIG. 51M is a diagram illustrating another example of the method of manufacturing the imaging device according to the fifth embodiment of the present disclosure.
[FIG. 51N] FIG. 51N is a diagram illustrating another example of the method of manufacturing the imaging device according to the fifth embodiment of the present disclosure.
[FIG. 52] FIG. 52 is a diagram illustrating an example of a cross-sectional configuration of an imaging device according to Modification Example 10 of the present disclosure.
[FIG. 53] FIG. 53 is a diagram illustrating an example of a cross-sectional configuration of the imaging device according to Modification Example 10 of the present disclosure.
[FIG. 54A] FIG. 54A is a diagram illustrating an example of a method of manufacturing the imaging device according to Modification Example 10 of the present disclosure.
[FIG. 54B] FIG. 54B is a diagram illustrating an example of the method of manufacturing the imaging device according to Modification Example 10 of the present disclosure.
[FIG. 54C] FIG. 54C is a diagram illustrating an example of the method of manufacturing the imaging device according to Modification Example 10 of the present disclosure.
[FIG. 54D] FIG. 54D is a diagram illustrating an example of the method of manufacturing the imaging device according to Modification Example 10 of the present disclosure.
[FIG. 54E] FIG. 54E is a diagram illustrating an example of the method of manufacturing the imaging device according to Modification Example 10 of the present disclosure.
[FIG. 54F] FIG. 54F is a diagram illustrating an example of the method of manufacturing the imaging device according to Modification Example 10 of the present disclosure.
[FIG. 54G] FIG. 54G is a diagram illustrating an example of the method of manufacturing the imaging device according to Modification Example 10 of the present disclosure.
[FIG. 54H] FIG. 54H is a diagram illustrating an example of the method of manufacturing the imaging device according to Modification Example 10 of the present disclosure.
[FIG. 54I] FIG. 54I is a diagram illustrating an example of the method of manufacturing the imaging device according to Modification Example 10 of the present disclosure.
[FIG. 55] FIG. 55 is a diagram illustrating an example of a cross-sectional configuration of an imaging device according to Modification Example 11 of the present disclosure.
[FIG. 56] FIG. 56 is a diagram illustrating an example of the cross-sectional configuration of the imaging device according to Modification Example 11 of the present disclosure.
[FIG. 57] FIG. 57 is a diagram illustrating another example of the cross-sectional configuration of the imaging device according to Modification Example 11 of the present disclosure.
[FIG. 58A] FIG. 58A is a diagram illustrating an example of a method of manufacturing the imaging device according to Modification Example 11 of the present disclosure.
[FIG. 58B] FIG. 58B is a diagram illustrating an example of the method of manufacturing the imaging device according to Modification Example 11 of the present disclosure.
[FIG. 58C] FIG. 58C is a diagram illustrating an example of the method of manufacturing the imaging device according to Modification Example 11 of the present disclosure.
[FIG. 58D] FIG. 58D is a diagram illustrating an example of the method of manufacturing the imaging device according to Modification Example 11 of the present disclosure.
[FIG. 58E] FIG. 58E is a diagram illustrating an example of the method of manufacturing the imaging device according to Modification Example 11 of the present disclosure.
[FIG. 58F] FIG. 58F is a diagram illustrating an example of the method of manufacturing the imaging device according to Modification Example 11 of the present disclosure.
[FIG. 58G] FIG. 58G is a diagram illustrating an example of the method of manufacturing the imaging device according to Modification Example 11 of the present disclosure.
[FIG. 58H] FIG. 58H is a diagram illustrating an example of the method of manufacturing the imaging device according to Modification Example 11 of the present disclosure.
[FIG. 59] FIG. 59 is a diagram illustrating an example of a cross-sectional configuration of an imaging device according to Modification Example 12 of the present disclosure.
[FIG. 60] FIG. 60 is a diagram illustrating an example of the cross-sectional configuration of the imaging device according to Modification Example 12 of the present disclosure.
[FIG. 61] FIG. 61 is a diagram illustrating another example of the cross-sectional configuration of the imaging device according to Modification Example 12 of the present disclosure.
[FIG. 62A] FIG. 62A is a diagram illustrating an example of a method of manufacturing the imaging device according to Modification Example 12 of the present disclosure.
[FIG. 62B] FIG. 62B is a diagram illustrating an example of the method of manufacturing the imaging device according to Modification Example 12 of the present disclosure.
[FIG. 62C] FIG. 62C is a diagram illustrating an example of the method of manufacturing the imaging device according to Modification Example 12 of the present disclosure.
[FIG. 62D] FIG. 62D is a diagram illustrating an example of the method of manufacturing the imaging device according to Modification Example 12 of the present disclosure.
[FIG. 62E] FIG. 62E is a diagram illustrating an example of the method of manufacturing the imaging device according to Modification Example 12 of the present disclosure.
[FIG. 62F] FIG. 62F is a diagram illustrating an example of the method of manufacturing the imaging device according to Modification Example 12 of the present disclosure.
[FIG. 62G] FIG. 62G is a diagram illustrating an example of the method of manufacturing the imaging device according to Modification Example 12 of the present disclosure.
[FIG. 62H] FIG. 62H is a diagram illustrating an example of the method of manufacturing the imaging device according to Modification Example 12 of the present disclosure.
[FIG. 62I] FIG. 62I is a diagram illustrating an example of the method of manufacturing the imaging device according to Modification Example 12 of the present disclosure.
[FIG. 62J] FIG. 62J is a diagram illustrating an example of the method of manufacturing the imaging device according to Modification Example 12 of the present disclosure.
[FIG. 63] FIG. 63 is a diagram illustrating an example of a cross-sectional configuration of an imaging device according to a sixth embodiment of the present disclosure.
[FIG. 64] FIG. 64 is a diagram illustrating an example of a cross-sectional configuration of the imaging device according to the sixth embodiment of the present disclosure.
[FIG. 65] FIG. 65 is a diagram illustrating an example of a cross-sectional configuration of an imaging device according to Modification Example 13 of the present disclosure.
[FIG. 66] FIG. 66 is a diagram illustrating an example of a cross-sectional configuration of an imaging device according to Modification Example 14 of the present disclosure.
[FIG. 67] FIG. 67 is a diagram illustrating an example of a cross-sectional configuration of an imaging device according to Modification Example 15 of the present disclosure.
[FIG. 68] FIG. 68 is a diagram illustrating an example of a cross-sectional configuration of an imaging device according to Modification Example 16 of the present disclosure.
[FIG. 69] FIG. 69 is a diagram illustrating another example of the cross-sectional configuration of the imaging device according to Modification Example 16 of the present disclosure.
[FIG. 70] FIG. 70 is a diagram illustrating another example of the cross-sectional configuration of the imaging device according to Modification Example 16 of the present disclosure.
[FIG. 71] FIG. 71 is a diagram illustrating another example of the cross-sectional configuration of the imaging device according to Modification Example 16 of the present disclosure.
[FIG. 72] FIG. 72 is a diagram illustrating another example of the cross-sectional configuration of the imaging device according to Modification Example 16 of the present disclosure.
[FIG. 73] FIG. 73 is a diagram illustrating another example of the cross-sectional configuration of the imaging device according to Modification Example 16 of the present disclosure.
[FIG. 74] FIG. 74 is a diagram illustrating an example of a cross-sectional configuration of an imaging device according to Modification Example 17 of the present disclosure.
[FIG. 75] FIG. 75 is a diagram illustrating another example of the cross-sectional configuration of the imaging device according to Modification Example 17 of the present disclosure.
[FIG. 76] FIG. 76 is a diagram illustrating another example of the cross-sectional configuration of the imaging device according to Modification Example 17 of the present disclosure.
[FIG. 77] FIG. 77 is a diagram illustrating another example of the cross-sectional configuration of the imaging device according to Modification Example 17 of the present disclosure.
[FIG. 78] FIG. 78 is a diagram illustrating another example of the cross-sectional configuration of the imaging device according to Modification Example 17 of the present disclosure.
[FIG. 79] FIG. 79 is a diagram illustrating another example of the cross-sectional configuration of the imaging device according to Modification Example 17 of the present disclosure.
[FIG. 80] FIG. 80 is an explanatory diagram of a configuration example of an imaging device according to a seventh embodiment of the present disclosure.
[FIG. 81] FIG. 81 is a diagram illustrating an example of a cross-sectional configuration of the imaging device according to the seventh embodiment of the present disclosure.
[FIG. 82A] FIG. 82A is a diagram illustrating an example of a method of manufacturing the imaging device according to the seventh embodiment of the present disclosure.
[FIG. 82B] FIG. 82B is a diagram illustrating an example of the method of manufacturing the imaging device according to the seventh embodiment of the present disclosure.
[FIG. 82C] FIG. 82C is a diagram illustrating an example of the method of manufacturing the imaging device according to the seventh embodiment of the present disclosure.
[FIG. 82D] FIG. 82D is a diagram illustrating an example of the method of manufacturing the imaging device according to the seventh embodiment of the present disclosure.
[FIG. 83A] FIG. 83A is a diagram illustrating another example of the method of manufacturing the imaging device according to the seventh embodiment of the present disclosure.
[FIG. 83B] FIG. 83B is a diagram illustrating another example of the method of manufacturing the imaging device according to the seventh embodiment of the present disclosure.
[FIG. 83C] FIG. 83C is a diagram illustrating another example of the method of manufacturing the imaging device according to the seventh embodiment of the present disclosure.
[FIG. 83D] FIG. 83D is a diagram illustrating another example of the method of manufacturing the imaging device according to the seventh embodiment of the present disclosure.
[FIG. 83E] FIG. 83E is a diagram illustrating another example of the method of manufacturing the imaging device according to the seventh embodiment of the present disclosure.
[FIG. 84] FIG. 84 is a diagram illustrating an example of a cross-sectional configuration of an imaging device according to Modification Example 18 of the present disclosure.
[FIG. 85] FIG. 85 is a diagram illustrating another example of the cross-sectional configuration of the imaging device according to Modification Example 18 of the present disclosure.
[FIG. 86] FIG. 86 is a diagram illustrating another example of the cross-sectional configuration of the imaging device according to Modification Example 18 of the present disclosure.
[FIG. 87] FIG. 87 is a diagram illustrating another example of the cross-sectional configuration of the imaging device according to Modification Example 18 of the present disclosure.
[FIG. 88] FIG. 88 is a diagram illustrating another example of the cross-sectional configuration of the imaging device according to Modification Example 18 of the present disclosure.
[FIG. 89] FIG. 89 is a diagram illustrating an example of a cross-sectional configuration of an imaging device according to Modification Example 19 of the present disclosure.
[FIG. 90] FIG. 90 is an explanatory diagram of a configuration example of an imaging device according to Modification Example 20 of the present disclosure.
[FIG. 91] FIG. 91 is an explanatory diagram of the configuration example of the imaging device according to Modification Example 20 of the present disclosure.
[FIG. 92] FIG. 92 is a block diagram illustrating a configuration example of an electronic apparatus including the imaging device.
[FIG. 93] FIG. 93 is a block diagram depicting an example of schematic configuration of a vehicle control system.
[FIG. 94] FIG. 94 is a diagram of assistance in explaining an example of installation positions of an outside-vehicle information detecting section and an imaging section.
[FIG. 95] FIG. 95 is a view depicting an example of a schematic configuration of an endoscopic surgery system.
[FIG. 96] FIG. 96 is a block diagram depicting an example of a functional configuration of a camera head and a camera control unit (CCU).

### Modes for Carrying Out the Invention

Hereinafter, a description is given in detail of embodiments of the present disclosure with reference to the drawings. It is to be noted that the description is given in the following order.
1. First Embodiment
2. Second Embodiment
3. Third Embodiment
4. Modification Examples
5. Fourth Embodiment
6. Fifth Embodiment
7. Sixth Embodiment
8. Seventh Embodiment
9. Application Example
10. Practical Application Examples

### <1. First Embodiment>

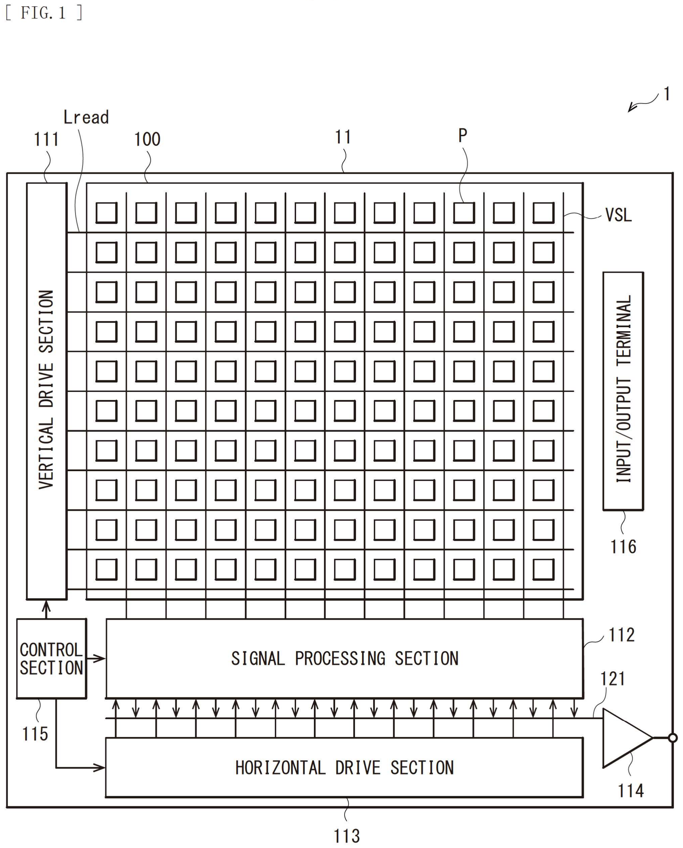

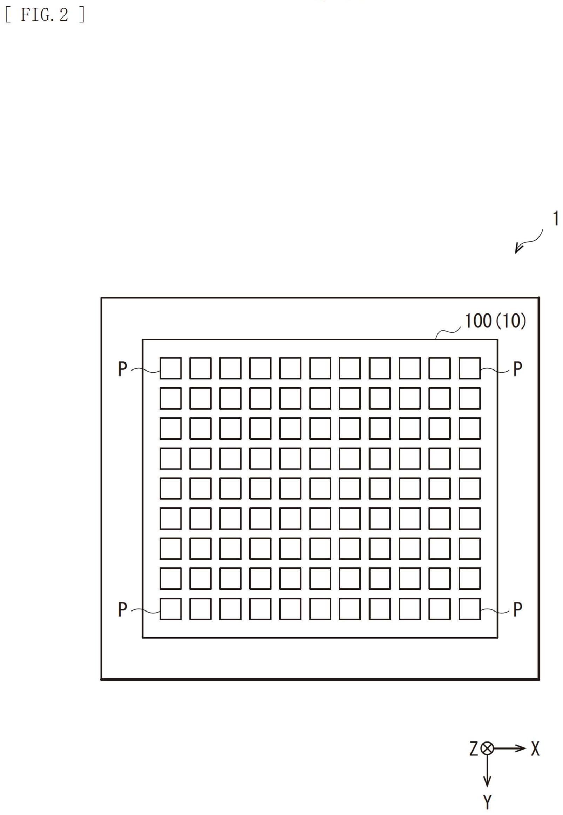

FIG. 1 is a block diagram illustrating an example of a schematic configuration of an imaging device which is an example of a photodetector according to a first embodiment of the present disclosure. FIG. 2 is a diagram illustrating an example of a pixel section of the imaging device according to the first embodiment. The photodetector is a device that is able to detect incoming light. An imaging device 1, which is a photodetector, can receive light transmitted through an optical system and generate a signal. The imaging device 1 (photodetector) includes a plurality of pixels P each including a photoelectric conversion section (photoelectric conversion element), and is configured to photoelectrically convert incident light and generate a signal.

The photoelectric conversion section of each of the pixels P is, for example, a photodiode, and is configured to be able to photoelectrically convert light. As illustrated in FIG. 2, the imaging device 1 includes, as an imaging area, a region (a pixel section 100) in which the plurality of pixels P are two-dimensionally arranged in matrix.

The imaging device 1 takes in incident light (image light) from a subject via an optical system (unillustrated) including an optical lens. The imaging device 1 captures an image of the subject formed by the optical lens. The imaging device 1 photoelectrically converts received light to generate a pixel signal. The imaging device 1 is, for example, a CMOS (Complementary Metal Oxide Semiconductor) image sensor. The imaging device 1 is usable for an electronic apparatus such as a digital still camera, a video camera, or a mobile phone.

It is to be noted that, as illustrated in FIG. 2, a direction in which light from the subject is incident is defined as a Z-axis direction; a right-left direction on the sheet orthogonal to the Z-axis direction is defined as an X-axis direction; and an up-down direction on the sheet orthogonal to the Z-axis direction and the X-axis direction is defined as a Y-axis direction. In the following drawings, the arrow directions in FIG. 2 may be used, in some cases, as a standard to express a direction.

As in the example illustrated in FIG. 1, the imaging device 1 includes, in a peripheral region of the pixel section 100, for example, a vertical drive section 111, a signal processing section 112, a horizontal drive section 113, an output section 114, a control section 115, and an input/output terminal 116. In addition, the imaging device 1 is provided with a plurality of pixel drive lines Lread and a plurality of vertical signal lines VSL.

In the pixel section 100, in the example illustrated in FIG. 1, the plurality of pixel drive lines Lread are wired for respective pixel rows each configured by the plurality of pixels P arranged in a horizontal direction (row direction). The pixel drive line Lread is a signal line that is able to transmit a signal to drive the pixel P. The pixel drive line Lread is configured to transmit a drive signal to read a signal from the pixel P.

In addition, in the pixel section 100, vertical signal lines VSL are wired for respective pixel columns each configured by a plurality of pixels P arranged in a vertical direction (column direction). The vertical signal line VSL is a signal line that is able to transmit a signal from the pixel P. The vertical signal line VSL is configured to transmit a signal outputted from the pixel P.

The vertical drive section 111 is a drive circuit, and is configured by, for example, a buffer, a shift register, an address decoder, and the like. The vertical drive section 111 is configured to be able to drive each of the pixels P of the pixel section 100. The vertical drive section 111 generates a signal to drive the pixel P, and outputs the signal to each of the pixels P of the pixel section 100 via the pixel drive line Lread. The vertical drive section 111 generates, for example, a signal to control the transfer transistor, a signal to control the reset transistor, or the like, and supplies the signal to each of the pixels P by the pixel drive line Lread.

The signal processing section 112 is configured to be able to execute signal processing of an inputted pixel signal. The signal processing section 112 is a signal processing circuit, and includes, for example, a load circuit part, an AD (Analog-to-Digital) converter part, a horizontal selection switch, and the like. The signal outputted from each of the pixels P selected and scanned by the vertical drive section 111 is inputted to the signal processing section 112 via the vertical signal line VSL. The signal processing section 112 performs signal processing such as CDS (Correlated Double Sampling: correlated double sampling) and AD conversion of the signal of the pixel P.

The horizontal drive section 113 is a drive circuit, and is configured by, for example, a buffer, a shift register, an address decoder, and the like. The horizontal drive section 113 is configured to be able to drive the horizontal selection switch of the signal processing section 112. The horizontal drive section 113 sequentially drives horizontal selection switches of the signal processing section 112 while scanning. Signals of the respective pixels P transmitted through the respective vertical signal lines VSL are subjected to signal processing by the signal processing section 112, and are sequentially outputted to a horizontal signal line 121 by selective scanning by the horizontal drive section 113.

The output section 114 is configured to perform signal processing on an inputted signal to output a signal. The output section 114 is an output circuit, and performs signal processing on the pixel signal inputted sequentially from the signal processing section 112 via the horizontal signal line 121, and outputs the processed pixel signal. The output section 114 can perform, for example, buffering, black level adjustment, column variation correction, various types of digital signal processing, and the like.

The control section 115 is configured to be able to control each section of the imaging device 1. The control section 115 can receive a clock supplied from the outside of a semiconductor substrate 11, data ordering an operation mode, or the like, and output data such as internal information on the imaging device 1.

The control section 115 is a control circuit, and includes, for example, a timing generator configured to be able to generate various timing signals. The control section 115 controls driving of peripheral circuits such as the vertical drive section 111, the signal processing section 112, and the horizontal drive section 113 on the basis of the various timing signals generated by the timing generator. The input/output terminal 116 exchanges signals with the outside.

It is to be noted that the vertical drive section 111, the signal processing section 112, the horizontal drive section 113, the horizontal signal line 121, the output section 114, the control section 115, and the like may be provided in the semiconductor substrate 11, or may be provided in another substrate. The imaging device 1 may have a structure (stacked structure) configured by stacking a plurality of substrates.

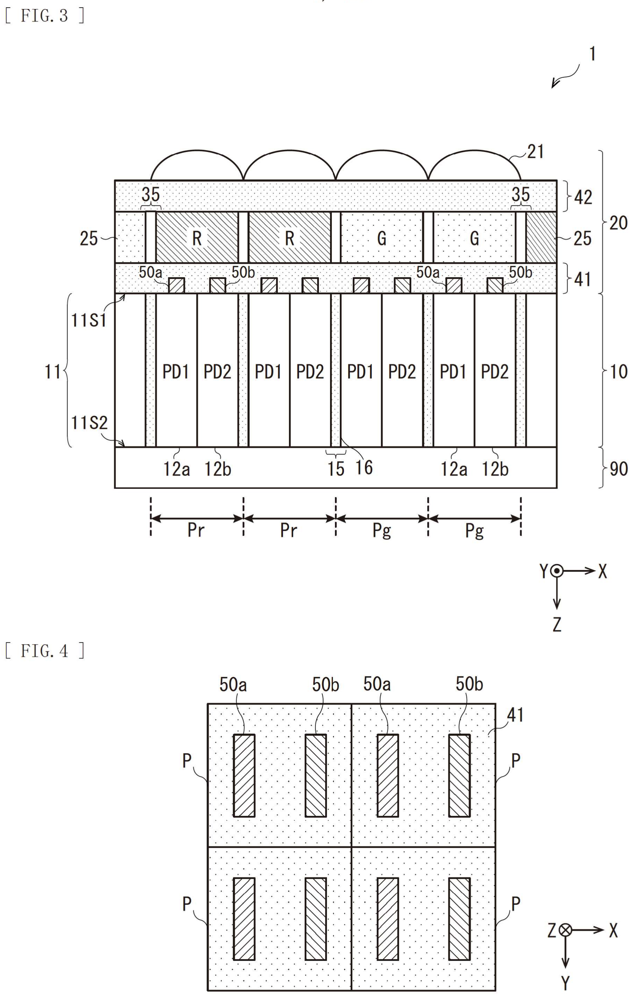

FIG. 3 is a diagram illustrating an example of a cross-sectional configuration of the imaging device according to the first embodiment. FIG. 3 illustrates an example of a schematic cross-sectional configuration of the imaging device 1. In addition, FIG. 4 is a diagram illustrating an example of a planar configuration of the imaging device according to the first embodiment. As in the example illustrated in FIG. 3, the imaging device 1 includes a light-receiving section 10 and a light-guiding section 20. The light-receiving section 10 includes a semiconductor substrate 11 having a first surface 11S1 and a second surface 11S2 opposed to each other. The semiconductor substrate 11 is configured by, for example, a silicon substrate.

The light-guiding section 20 is provided on a side of the first surface 11S1 of the semiconductor substrate 11. A multilayer wiring layer 90 is provided on a side of the second surface 11S2 of the semiconductor substrate 11. The imaging device 1 has a configuration in which the light-receiving section 10, the light-guiding section 20, and the multilayer wiring layer 90 are stacked in a Z-axis direction. The light-guiding section 20 is provided on a side on which light from the optical system is incident, and the multilayer wiring layer 90 is provided on a side opposite to the side on which light is incident. The imaging device 1 is a so-called back-illuminated imaging device.

In the example illustrated in FIG. 3, the pixel P of the imaging device 1 includes a first photoelectric conversion section 12a, a second photoelectric conversion section 12b, and a readout circuit (unillustrated). The first photoelectric conversion section 12a (first photoelectric conversion element) is configured to be able to generate electric charge by photoelectric conversion. The first photoelectric conversion section 12a is a first photodiode (PD1), and converts incoming light into electric charge. The first photoelectric conversion section 12a performs photoelectric conversion to generate electric charge corresponding to a received light amount.

The second photoelectric conversion section 12b (second photoelectric conversion element) is configured to be able to generate electric charge by photoelectric conversion. The second photoelectric conversion section 12b is a second photodiode (PD2), and converts incoming light into electric charge. The second photoelectric conversion section 12b performs photoelectric conversion to generate electric charge corresponding to a received light amount.

In the light-receiving section 10, a plurality of first photoelectric conversion sections 12a and a plurality of second photoelectric conversion sections 12b are provided along the first surface 11S1 and the second surface 11S2 of the semiconductor substrate 11. For example, the plurality of first photoelectric conversion sections 12a and the plurality of second photoelectric conversion sections 12b are embedded and formed in the semiconductor substrate 11.

The readout circuit of the pixel P is configured to be able to output a first pixel signal based on electric charge generated by a first photoelectric conversion section 12a and a second pixel signal based on electric charge generated by a second photoelectric conversion section 12b. The readout circuit includes, for example, a transfer transistor, a floating diffusion (FD), a reset transistor, an amplification transistor, and the like. The readout circuit is configured to be able to read the first pixel signal and the second pixel signal to the vertical signal line VSL (see FIG. 1).

The vertical drive section 111 (see FIG. 1) controls the readout circuit of each of the pixels P to thereby cause each of the pixels P to output a pixel signal to the vertical signal line VSL. The vertical drive section 111 is a pixel control section configured to be able to control pixels, and can perform control to read the pixel signal from each of the pixels P. It is to be noted that the vertical drive section 111 and the control section 115 can also be collectively referred to as the pixel control section.

For example, the vertical drive section 111, which is the pixel control section, is able to read the first pixel signal based on electric charge photoelectrically converted by the first photoelectric conversion section 12a and the second pixel signal based on electric charge photoelectrically converted by the second photoelectric conversion section 12b. In addition, the vertical drive section 111 can read a pixel signal corresponding to electric charge obtained by adding electric charge converted by a first photoelectric conversion section 12a and electric charge converted by a second photoelectric conversion section 12b.

The multilayer wiring layer 90 provided on the side of the second surface 11S2 of the semiconductor substrate 11 has a configuration in which, for example, a plurality of wiring layer are stacked with an interlayer insulating layer interposed therebetween. The wiring layer of the multilayer wiring layer 90 is formed using, for example, aluminum (Al), copper (Cu), tungsten (W), or the like. The interlayer insulating layer is formed using, for example, silicon oxide (SiOx), silicon nitride (SiNx), silicon oxynitride (SiOxNy), or the like.

The above-described readout circuit can be formed in the semiconductor substrate 11 and the multilayer wiring layer 90, for example. It is to be noted that the vertical drive section 111, the signal processing section 112, the horizontal drive section 113, the output section 114, the control section 115, and the like described above can be formed in a substrate different from the semiconductor substrate 11 or in the semiconductor substrate 11 and the multilayer wiring layer 90.

The light-guiding section 20 is stacked on the light-receiving section 10 in a thickness direction orthogonal to the first surface 11S1 of the semiconductor substrate 11. The light-guiding section 20 includes a lens section 21 and a color filter 25, and guides light incident from above to a side of the light-receiving section 10. The lens section 21 is an optical member also called an on-chip lens.

The lens section 21 is provided above the color filter, for example, for each pixel P or for each plurality of pixels P. Light from a subject is incident on the lens section 21 via an optical system such as an imaging lens. The first photoelectric conversion section 12a and the second photoelectric conversion section 12b photoelectrically convert light incident via the lens section 21 and the color filter 25.

The color filter 25 is configured to selectively transmit light of a particular wavelength region of the incoming light. The plurality of pixels P provided in the pixel section 100 of the imaging device 1 includes a plurality of pixels Pr provided with the color filter 25 that transmits red (R) light, a plurality of pixels Pg provided with the color filter 25 that transmits green (G) light, and a plurality of pixels Pb provided with the color filter 25 that transmits blue (B) light.

In the pixel section 100, the plurality of pixels Pr, the plurality of pixels Pg, and the plurality of pixels Pb are repeatedly arranged. The pixel Pr, the pixel Pg, and the pixel Pb generate a pixel signal of an R component, a pixel signal of a G component, and a pixel signal of a B component, respectively. The imaging device 1 is able to obtain pixel signals of RGB.

It is to be noted that the filter provided for the pixels P of the pixel section 100 is not limited to a color filter of a primary color system (RGB), and may be a color filter of a complementary color system such as Cy (cyan), Mg (magenta), or Ye (yellow), for example. In addition, a color filter corresponding to W (white), i.e., a filter that transmits light beams of all wavelength regions of incident light may be arranged. The color filter 25 may be a filter that transmits infrared light.

In the present embodiment, one lens section 21 is provided for the first photoelectric conversion section 12a and the second photoelectric conversion section 12b of the pixel P. The first photoelectric conversion section 12a and the second photoelectric conversion section 12b receive light having passed through regions of different optical systems such as imaging lenses to allow pupil division to be performed. Therefore, using the first pixel signal and the second pixel signal enables phase difference data (phase difference information) to be obtained. Using the phase difference data enables phase difference AF (Auto Focus) to be performed.

The pixel P of the imaging device 1 is a pixel usable for detection of a phase difference, and can also be referred to as a phase difference pixel. As described above, the pixel P is configured to be able to output the first pixel signal and the second pixel signal, as a signal to be used for detection of a phase difference. In addition, in the present embodiment, the pixels P, which are the phase difference pixels, are repeatedly provided across the entire surface of an imaging plane of the imaging device 1, i.e., across the entire pixel section 100. It is possible to obtain phase difference data across the entire surface of the imaging plane of the imaging device 1, and thus to perform high-precision AF (auto-focus).

In addition, it is possible to perform signal processing on pixel signals outputted from respective pixels of the pixel Pr, the pixel Pg, and the pixel Pb, and thus to generate image data. In this case, image data may be generated using pixel signals based on electric charge obtained by adding the electric charge photoelectrically converted by the first photoelectric conversion section 12a and the electric charge photoelectrically converted by the second photoelectric conversion section 12b. It is possible, in the imaging device 1, to obtain a pixel signal for image generation across the entire surface of the imaging plane, and thus to suppress deterioration in image quality of an image.

As illustrated in FIG. 3, the imaging device 1 includes a separation section 15, a first insulating layer 41, a second insulating layer 42, a light-guiding wall 35, a first light-guiding member 50a, and a second light-guiding member 50b. The separation section 15 is provided between the photoelectric conversion sections adjacent to each other (between the first photoelectric conversion section 12a and the second photoelectric conversion section 12b, in the example illustrated in FIG. 3) to separate the photoelectric conversion sections from each other. The separation section 15 includes a trench 16 (groove), and is provided to surround each of the first photoelectric conversion section 12a and the second photoelectric conversion section 12b in the semiconductor substrate 11.

The separation section 15 including the trench 16 is provided to penetrate the semiconductor substrate 11, for example, as in the example illustrated in FIG. 3. An oxide film (e.g., silicone oxide film), a polysilicon (Poly-Si), an air gap (cavity), or the like is provided inside the trench 16. In the example illustrated in FIG. 3, the trench 16 (groove) is formed between the first photoelectric conversion section 12a and the second photoelectric conversion section 12b adjacent to each other, and an oxide film is embedded in the trench 16. Providing the separation section 15 suppresses leakage of light to the pixels P therearound.

The first insulating layer 41 is provided between a layer provided with the first photoelectric conversion section 12a and the second photoelectric conversion section 12b and a layer provided with the color filter 25. In addition, the second insulating layer 42 is provided between the layer provided with the color filter 25 and a layer provided with the lens section 21.

The first insulating layer 41 and the second insulating layer 42 are each formed by, for example, a monolayer film including one of an oxide film (e.g., silicon oxide film), a nitride film (e.g., silicon nitride film), an oxynitride film, and the like, or a stacked film including two or more thereof. As an example, the first insulating layer 41 and the second insulating layer 42 are formed using silicon dioxide (SiO₂). It is to be noted that each of the first insulating layer 41 and the second insulating layer 42 can also be referred to as a planarization layer (planarization film).

The light-guiding wall 35 is provided between the color filters 25 adjacent to each other. The light-guiding wall 35 is provided to surround, for example, four sides of the color filter 25. As in the example illustrated in FIG. 3, the light-guiding wall 35 is a wall-shaped structure. The light-guiding wall 35 is positioned at the sides of the color filter 25, and has a refractive index lower than a refractive index of a surrounding medium. The light-guiding wall 35 has a refractive index lower than a refractive index of the color filter 25.

The light-guiding wall 35 is configured by, for example, silicon oxide, air gap (cavity), or the like. The light-guiding wall 35 changes a direction in which incident light travels by a refractive index difference between the light-guiding wall 35 and the surrounding medium. Providing the light-guiding wall 35 suppresses light leakage into surrounding pixels, thus reducing color mixture. The light-guiding wall 35 is provided at a boundary between the pixels P adjacent to each other, and can also be referred to as a separation wall (or separation section) that separates color filters 25 from each other.

The first light-guiding member 50a is provided above the first photoelectric conversion section 12a, and has a refractive index higher than a refractive index of an adjacent medium. In addition, the second light-guiding member 50b is provided above the second photoelectric conversion section 12b, and has a refractive index higher than a refractive index of an adjacent medium. The first light-guiding member 50a and the second light-guiding member 50b each have a refractive index higher than a refractive index of a surrounding medium.

In the present embodiment, the first light-guiding member 50a is provided between the color filter 25 and the first photoelectric conversion section 12a. The second light-guiding member 50b is provided between the color filter 25 and the second photoelectric conversion section 12b. In the example illustrated in FIG. 3, the first insulating layer 41 is provided around the first light-guiding member 50a and the second light-guiding member 50b. The first light-guiding member 50a and the second light-guiding member 50b can also be referred to as being arranged to replace a portion of the first insulating layer 41.

The first light-guiding member 50a and the second light-guiding member 50b are each configured by a material having a refractive index higher than a refractive index of the first insulating layer 41. As described above, the first insulating layer 41 is configured by, for example, silicon dioxide (SiO₂). The first light-guiding member 50a and the second light-guiding member 50b each have a refractive index higher than a refractive index of silicon dioxide (SiO₂). Each of the first light-guiding member 50a and the second light-guiding member 50b is configured by a high refractive index material, and can also be referred to as a high refractive index section. The first insulating layer 41 can also be referred to as a low refractive index section.

The first light-guiding member 50a and the second light-guiding member 50b are configured using, for example, a metal oxide such as titanium oxide (TiO) or tantalum oxide (TaO). In addition, the first light-guiding member 50a and the second light-guiding member 50b may be configured by, for example, silicon nitride (SiN), silicon oxynitride (SiON), or a-Si (amorphous silicon). It is to be noted that the first light-guiding member 50a and the second light-guiding member 50b may be configured by another high refractive index material.

The first light-guiding member 50a and the second light-guiding member 50b may be formed to include at least one of oxides of titanium (Ti), tantalum (Ta), aluminum (Al), hafnium (Hf), zirconium (Zr), lanthanoid (La), niobium (Nb), and magnesium (Mg) elements.

The first light-guiding member 50a is a light-guiding section, and changes a direction in which incident light travels by a refractive index difference between the first light-guiding member 50a and a surrounding medium. In FIG. 3, light incident on a side of the first photoelectric conversion section 12a from above via the lens section 21 travels toward the first photoelectric conversion section 12a in response to a refractive index difference between the first light-guiding member 50a and the first insulating layer 41. Providing the first light-guiding member 50a makes it possible to condense light on the first photoelectric conversion section 12a.

In addition, the second light-guiding member 50b is also a light-guiding section, and changes a direction in which incident light travels by a refractive index difference between the second light-guiding member 50b and a surrounding medium. In FIG. 3, light incident on a side of the second photoelectric conversion section 12b from above via the lens section 21 travels toward the second photoelectric conversion section 12b in response to a refractive index difference between the second light-guiding member 50b and the first insulating layer 41. Providing the second light-guiding member 50b makes it possible to condense light on the second photoelectric conversion section 12b.

The imaging device 1 can also be referred to as having a waveguide structure that causes the first light-guiding member 50a and the second light-guiding member 50b to guide light to the first photoelectric conversion section 12a and the second photoelectric conversion section 12b. It is possible to cause the first light-guiding member 50a and the second light-guiding member 50b to appropriately separate (disperse) light from the optical system and guide the light to the first photoelectric conversion section 12a and the second photoelectric conversion section 12b.

It is therefore possible for the first photoelectric conversion section 12a and the second photoelectric conversion section 12b to accurately receive respective light beams having passed through regions of different optical systems, and thus to perform pupil division. It is possible to suppress deterioration in accuracy of detecting a phase difference using the first pixel signal and the second pixel signal. Also in a case where a light-condensing spot by the lens section 21 becomes large in a fine pixel, it is possible for the first light-guiding member 50a and the second light-guiding member 50b to appropriately guide incident light, and thus to accurately detect a phase difference.

In this manner, it is possible, in the imaging device 1, to suppress deterioration in light separation performance in the case of out of focus, i.e., deterioration in the performance of separating the first pixel signal and the second pixel signal from each other. It is possible to suppress deterioration in the accuracy of detecting a phase difference, and thus to prevent deterioration in AF performance. In particular, also in the case of the fine pixel, it is possible to secure the AF performance. In the present embodiment, it is possible to improve the AF performance, and thus to improve the image quality of an image.

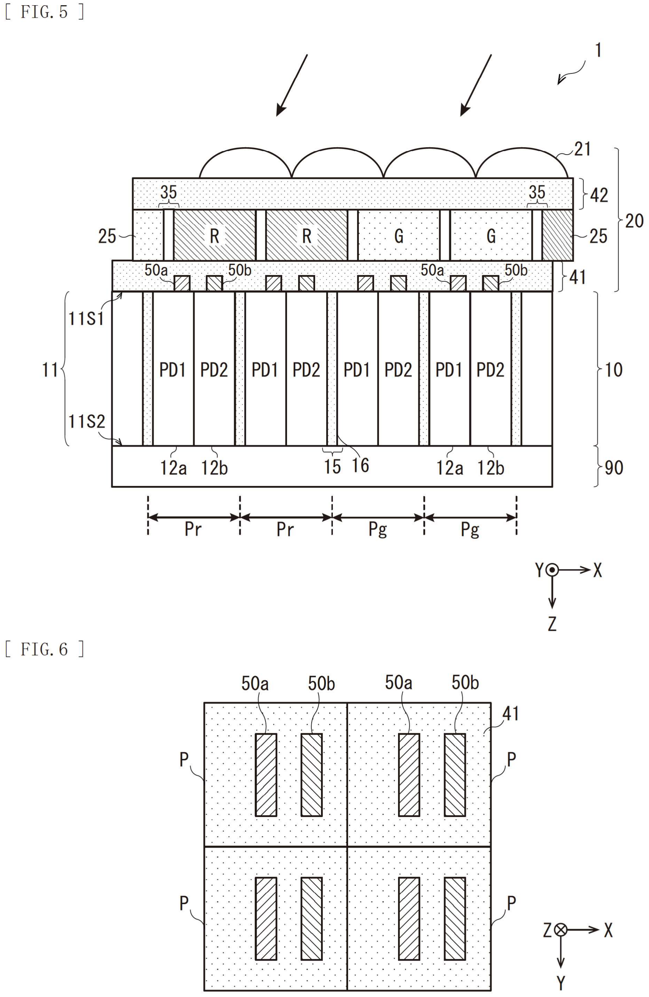

FIGs. 5 and 6 illustrate examples of a cross-sectional configuration and a planar configuration in a region where a distance from the center of the pixel section 100 (light-receiving section 10) of the imaging device 1, i.e., an image height is high. Light from the optical lens is incident substantially perpendicularly on the middle part of the pixel section 100 of the imaging device 1. Meanwhile, as in the example indicated by arrows in FIG. 5, light is obliquely incident on a peripheral region positioned outward from the middle part, i.e., on a region distant from the middle of the pixel section 100. Therefore, in the imaging device 1, positions of the lens section 21 and the color filter 25 in each of the pixels P are configured to differ depending on the distance from the center of the pixel section 100, i.e., the image height.

As in the example illustrated in FIG. 5, the lens section 21 and the color filter 25 of the pixel P (pixels Pr and Pg in FIG. 5) are arranged to be shifted to a side of the middle of the pixel section 100 from the first photoelectric conversion section 12a and the second photoelectric conversion section 12b of that pixel P. The first light-guiding member 50a and the second light-guiding member 50b of the pixel P can also be shifted to the side of the middle of the pixel section 100 (light-receiving section 10) from the first photoelectric conversion section 12a and the second photoelectric conversion section 12b of that pixel P.

In the example illustrated in FIG. 5, the center of the second light-guiding member 50b in the pixel P is positioned closer to the center of the pixel section 100 than the center of the first light-guiding member 50a of that pixel P. The first light-guiding member 50a illustrated in FIG. 5 is positioned distant from the center of the pixel section 100. The first light-guiding member 50a of the pixel P is arranged to be shifted to the side of the center of the pixel section 100 (light-receiving section 10). The first light-guiding member 50a is provided to be shifted in a rightward direction on the sheet.

It is to be noted that, in the middle region of the pixel section 100 (light-receiving section 10), the pixel P is configured as illustrated in FIGs. 3 and 4 described above, for example. In the pixel P at the middle of the pixel section 100, the center position of each of the lens section 21 and the color filter 25 and the position of a boundary between the first photoelectric conversion section 12a and the second photoelectric conversion section 12b are substantially coincident with to each other, as in the example illustrated in FIG. 3.

Thus, in the imaging device 1, respective positions of the lens section 21 and the color filter 25 are adjusted depending on the image height, thus enabling pupil corrections to be appropriately performed. It is possible to suppress a decrease in an amount of light incident on the first photoelectric conversion section 12a and the second photoelectric conversion section 12b, and thus to prevent deterioration in sensitivity to incident light. In addition, in the imaging device 1 according to the present embodiment, the respective positions of the first light-guiding member 50a and the second light-guiding member 50b are adjusted depending on the image height, thus making it possible to appropriately detect a phase difference. It is possible to suppress deterioration in the AF performance.

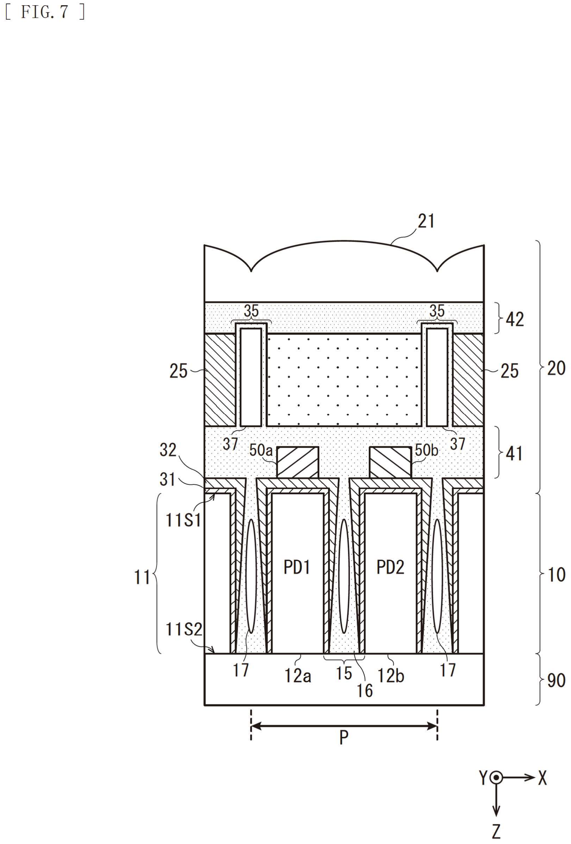

FIG. 7 is a diagram illustrating an example of a cross-sectional configuration of the imaging device according to the first embodiment. FIG. 7 illustrates a more detailed configuration example of the imaging device 1. As in the example illustrated in FIG. 7, the imaging device 1 may include a fixed charge film 31 and an antireflection film 32. The fixed charge film 31 and the antireflection film 32 are provided on the first photoelectric conversion section 12a and the second photoelectric conversion section 12b. The fixed charge film 31 and the antireflection film 32 are each configured by, for example, a metal compound (metal oxide, metal nitride, etc.), and can also be referred to as a metal compound layer.

The fixed charge film 31 is a film having fixed electric charge, and is formed using a high dielectric. The fixed charge film 31 is configured by, for example, a metal oxide such as hafnium oxide, and is provided on the first photoelectric conversion section 12a and the second photoelectric conversion section 12b. The fixed charge film 31 is provided between the first photoelectric conversion section 12a and the first insulating layer 41 and between the second photoelectric conversion section 12b and the first insulating layer 41.

In the example illustrated in FIG. 7, the fixed charge film 31 is provided to cover each of the first photoelectric conversion section 12a and the second photoelectric conversion section 12b. The fixed charge film 31 is, for example, a film having negative fixed electric charge, and suppresses generation of a dark current at an interface of the semiconductor substrate 11. The fixed charge film 31 may be formed to include, for example, at least one of oxides of hafnium (Hf), zirconium (Zr), aluminum (Al), titanium (Ti), tantalum (Ta), magnesium (Mg), yttrium (Y), and lanthanoid (La) elements.

The fixed charge film 31 may be configured by a metal nitride film or a metal oxynitride film such as an aluminum nitride film, a hafnium oxynitride film, or an aluminum oxynitride film. A film having positive fixed electric charge may be provided as the fixed charge film 31.

The antireflection film 32 is configured by, for example, a metal oxide such as tantalum oxide or hafnium oxide, and is provided on the fixed charge film 31. The antireflection film 32 is provided between the fixed charge film 31 and the first insulating layer 41 to reduce (suppress) reflection.

The antireflection film 32 may be configured by another metal oxide film, or may be configured by a metal nitride film or a metal oxynitride film. It is to be noted that the antireflection film 32 may be configured by an insulating material such as a silicon oxide film or a silicon nitride film, or may be configured using another material.

In the example illustrated in FIG. 7, the first light-guiding member 50a is formed on the antireflection film 32, and is in contact with the antireflection film 32. In addition, the second light-guiding member 50b is also formed on the antireflection film 32, and is in contact with the antireflection film 32.

In the separation section 15, the fixed charge film 31 and the antireflection film 32 can be formed to cover the side surface of the trench 16. As illustrated in FIG. 7, the separation section 15 has an air gap 17 (cavity) provided between the photoelectric conversion sections adjacent to each other. The air gap 17 of the separation section 15 is formed inside the trench 16 to surround each of the first photoelectric conversion section 12a and the second photoelectric conversion section 12b. Providing the separation section 15 having the air gap 17 effectively suppresses leakage of light to the photoelectric conversion section therearound.

In addition, in the example illustrated in FIG. 7, the light-guiding wall 35 has an air gap 37 (cavity) provided between the color filters 25 adjacent to each other. The air gap 37 of the light-guiding wall 35 is formed to surround the color filter 25. Providing the color filter 25 having the air gap 37 effectively suppresses leakage of light to the pixels P therearound.

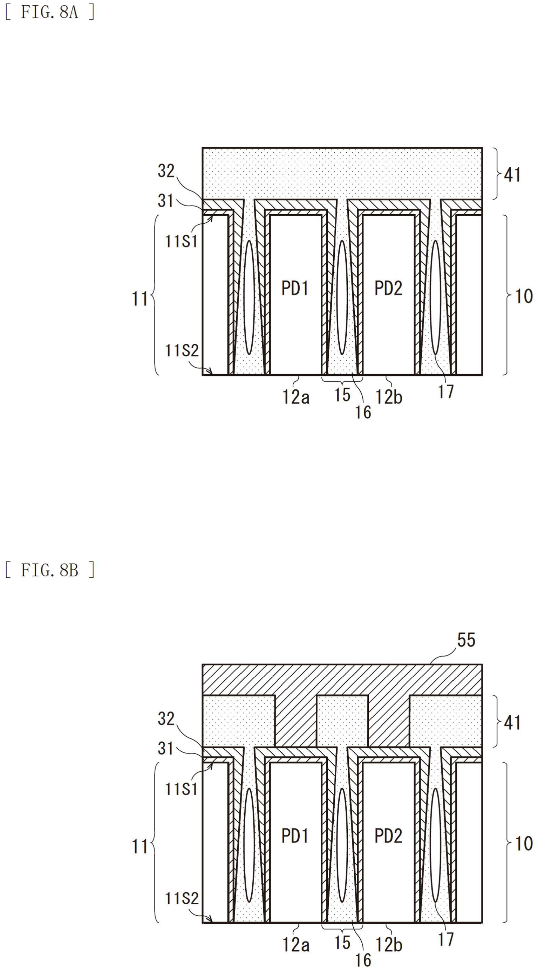

FIGs. 8A to 8F are each a diagram illustrating an example of a method of manufacturing the imaging device according to the first embodiment of the present embodiment. First, as illustrated in FIG. 8A, a silicon oxide film is formed as the first insulating layer 41 on the semiconductor substrate 11 in which the first photoelectric conversion section 12a, the second photoelectric conversion section 12b, and the like are formed. Then, the silicon oxide film is selectively removed by lithography and dry etching to form a high refractive index section 55 including a high refractive material, as illustrated in FIG. 8B.

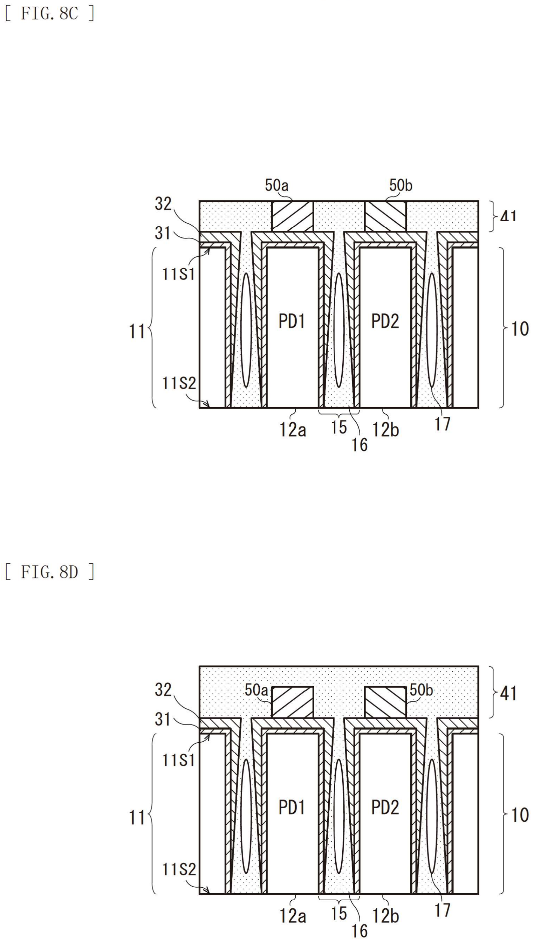

A silicon nitride film may be formed as the high refractive index section 55 by CVD or ALD, for example. In addition, for example, a titanium oxide film may be formed as the high refractive index section 55 by ALD. Next, as illustrated in FIG. 8C, the high refractive index section 55 is partially removed by etch-back or CMP processing to thereby form the first light-guiding member 50a and the second light-guiding member 50b. Then, as illustrated in FIG. 8D, a silicon oxide film is formed on the first light-guiding member 50a and the second light-guiding member 50b.

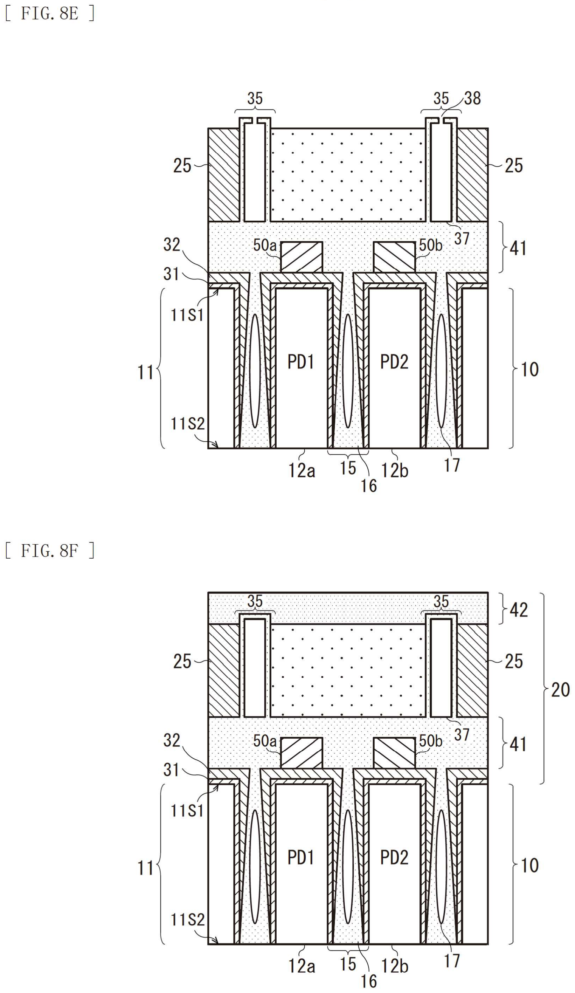

Next, as illustrated in FIG. 8E, the light-guiding wall 35 and the color filter 25 are formed on the first insulating layer 41. In a case where the light-guiding wall 35 is formed, for example, an a-Si film (amorphous silicon film) and a silicon oxide film covering the a-Si film are formed in a region where the light-guiding wall 35 is formed. Then, as illustrated in FIG. 8E, a hole 38 (opening) is formed in a portion of the silicon oxide film, and the a-Si film is etched through the hole 38 to thereby form the air gap 37 of the light-guiding wall 35.

Next, as illustrated in FIG. 8F, the hole is closed by a silicone oxide film, for example, to form the second insulating layer 42, the lens section 21, and the like. Through the manufacturing method as described above, the imaging device 1 illustrated in FIG. 7 or other drawings is able to be manufactured. It is to be noted that the above-described manufacturing method is merely exemplary and another manufacturing method may be employed.

It is to be noted that, although the description has been given above of the configuration example of the imaging device 1 provided with the light-guiding member, the configuration example is merely exemplary, and the configuration of the imaging device 1 is not limited to the above-described example. For example, a configuration may be adopted in which the imaging device 1 includes only one of the first light-guiding member 50a or the second light-guiding member 50b. In addition, for example, the first light-guiding member 50a and the second light-guiding member 50b may be provided between the lens section 21 and the color filter 25.

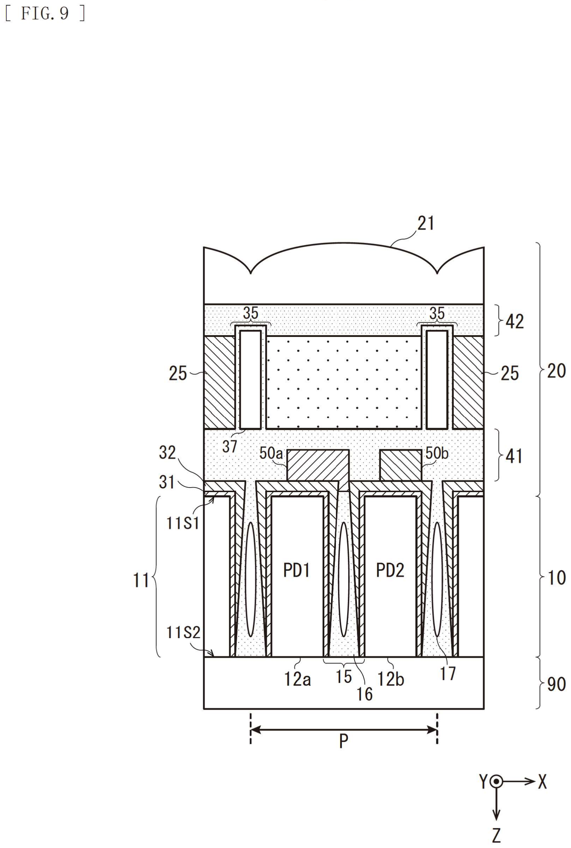

FIG. 9 is a diagram illustrating another example of the cross-sectional configuration of the imaging device according to the first embodiment. As in the example illustrated in FIG. 9, a portion of the first light-guiding member 50a may be provided inside the separation section 15. In the example illustrated in FIG. 9, a portion of the first light-guiding member 50a is embedded and formed inside the separation section 15.

In this case, it is possible to increase the film thickness of the first light-guiding member 50a while keeping the height from the semiconductor substrate 11 to the lens section 21. This enhances the performance of drawing incoming light, and thus an improvement in separation performance is expectable. In addition, suppression in scattering of condensed light is expectable. It is to be noted that a portion of the second light-guiding member 50b may be provided inside the separation section 15.

### [Workings and Effects]

The photodetector according to the present embodiment includes: a lens (lens section 21) on which light is incident; a first photoelectric conversion section (first photoelectric conversion section 12a) that photoelectrically converts light transmitted through the lens; a second photoelectric conversion section (second photoelectric conversion section 12b) provided next to the first photoelectric conversion section and photoelectrically converting light transmitted through the lens; and a first light-guiding member (first light-guiding member 50a) provided above the first photoelectric conversion section and having a refractive index higher than a refractive index of an adjacent medium.

A photodetector (imaging device 1) according to the present embodiment is provided with the first light-guiding member 50a above the first photoelectric conversion section 12a. It is therefore possible to cause the first light-guiding member 50a to appropriately guide incident light, and thus to suppress deterioration in accuracy of photodetection.

In the present embodiment, it is possible to suppress deterioration in the performance of separating the first pixel signal and the second pixel signal from each other. It is therefore possible to suppress deterioration in accuracy of detecting a phase difference, and thus to prevent deterioration in the AF performance.

### <2. Second Embodiment>

Next, a description is given of a second embodiment of the present disclosure. Hereinafter, components similar to those of the foregoing embodiment are denoted by the same reference numerals, and descriptions thereof are omitted as appropriate.

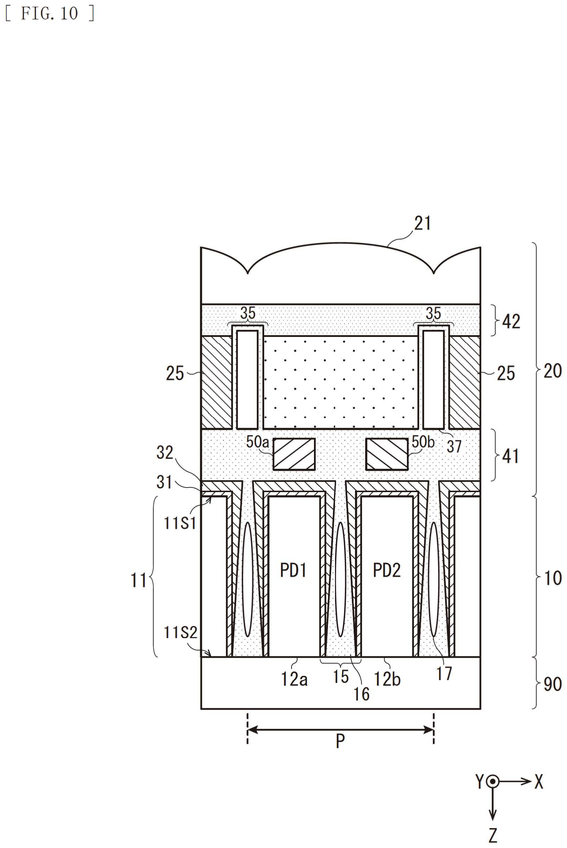

FIG. 10 is a diagram illustrating an example of a cross-sectional configuration of an imaging device according to the second embodiment of the present disclosure. As illustrated in FIG. 10, the first light-guiding member 50a is provided inside the first insulating layer 41, and is not in contact with the antireflection film 32. A portion of the first insulating layer 41 is disposed between the first light-guiding member 50a and the antireflection film 32. A silicone oxide film is provided, for example, as the first insulating layer 41 between the first light-guiding member 50a and the antireflection film 32. The first insulating layer 41 is provided to include the first light-guiding member 50a.

As illustrated in FIG. 10, the second light-guiding member 50b is provided inside the first insulating layer 41, and is not in contact with the antireflection film 32. A portion of the first insulating layer 41 is disposed between the second light-guiding member 50b and the antireflection film 32. A silicone oxide film is provided, for example, as the first insulating layer 41 between the second light-guiding member 50b and the antireflection film 32. The first insulating layer 41 is provided to include the second light-guiding member 50b. Also in the case of the present embodiment, it is possible for the first light-guiding member 50a and the second light-guiding member 50b to guide light to the first photoelectric conversion section 12a and the second photoelectric conversion section 12b. Also in the case of the present embodiment, it is possible to obtain effects similar to those of the first embodiment.

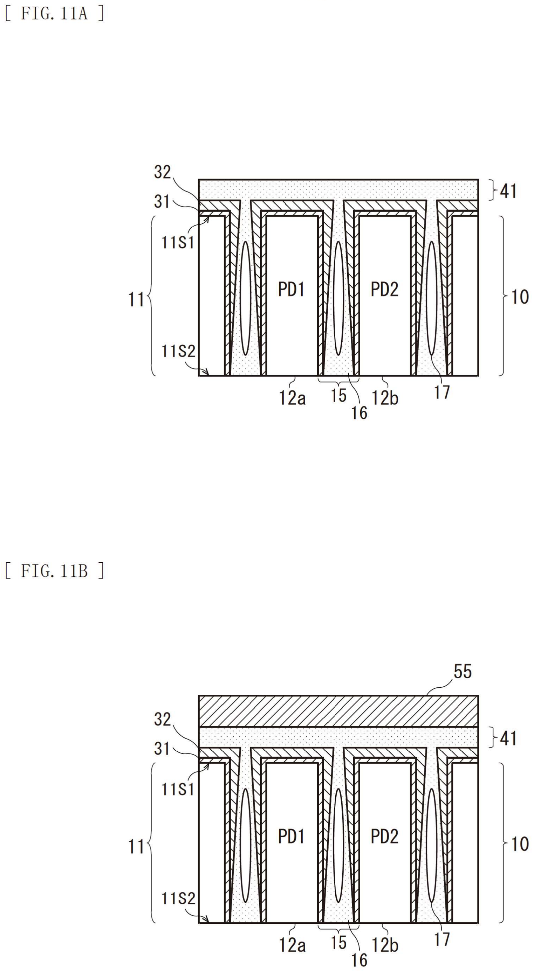

FIGs. 11A to 11D are each a diagram illustrating an example of a method of manufacturing the imaging device according to the second embodiment. First, as illustrated in FIG. 11A, a silicon oxide film is formed as the first insulating layer 41 on the semiconductor substrate 11 in which the first photoelectric conversion section 12a, the second photoelectric conversion section 12b, and the like are formed. Then, as illustrated in FIG. 11B, the high refractive index section 55 including a high refractive material is formed. For example, a silicon nitride film may be formed as the high refractive index section 55 by CVD or ALD. In addition, for example, a titanium oxide film may be formed as the high refractive index section 55 by ALD.

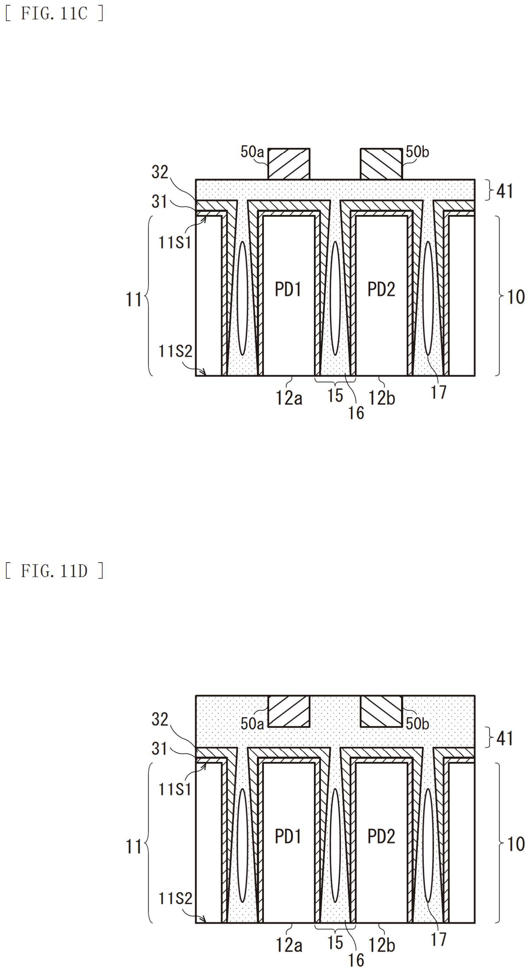

Next, as illustrated in FIG. 11C, the high refractive index section 55 is partially removed by lithography and dry etching to thereby form the first light-guiding member 50a and the second light-guiding member 50b. Then, as illustrated in FIG. 11D, a silicon oxide film is formed around the first light-guiding member 50a and the second light-guiding member 50b. Thereafter, in the same manner as the case of the first embodiment, the light-guiding wall 35, the color filter 25, the lens section 21, and the like are formed. Through the manufacturing method as described above, the imaging device 1 illustrated in FIG. 10 is able to be manufactured. It is to be noted that the above-described manufacturing method is merely exemplary and another manufacturing method may be employed.

### <3. Third Embodiment>

Next, a description is given of a third embodiment of the present disclosure. Hereinafter, components similar to those of the foregoing embodiments are denoted by the same reference numerals, and descriptions thereof are omitted as appropriate.

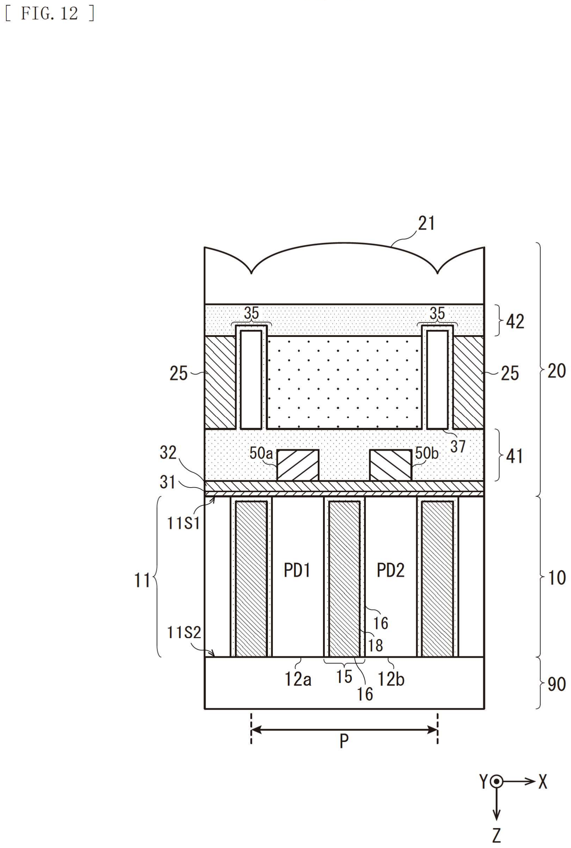

FIG. 12 is a diagram illustrating an example of a cross-sectional configuration of an imaging device according to the third embodiment of the present disclosure. As in the example illustrated in FIG. 12, Poly-Si (polysilicon) may be embedded and formed in the trench 16 of the separation section 15. The separation section 15 includes a Poly-Si film 18 (polysilicon film) provided between the photoelectric conversion sections adjacent to each other. The first light-guiding member 50a and the second light-guiding member 50b are each formed on the antireflection film 32, and are in contact with the antireflection film 32.

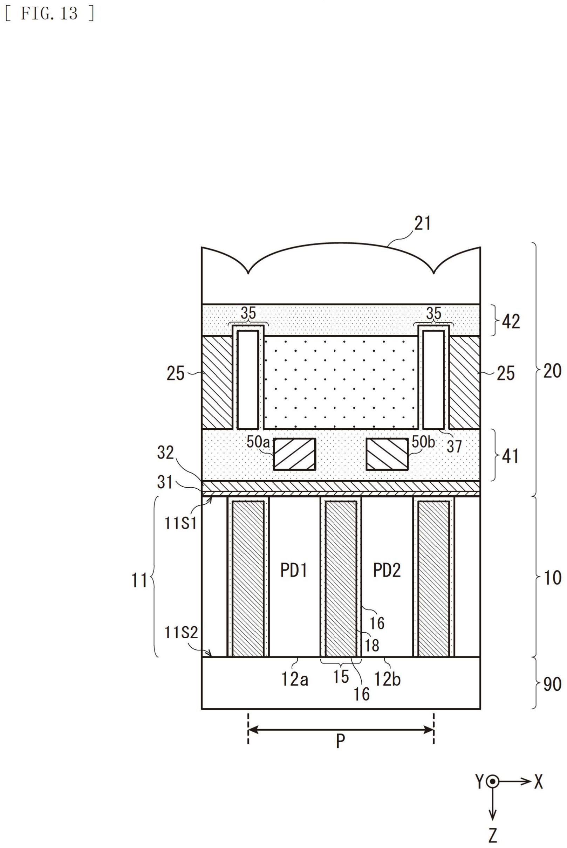

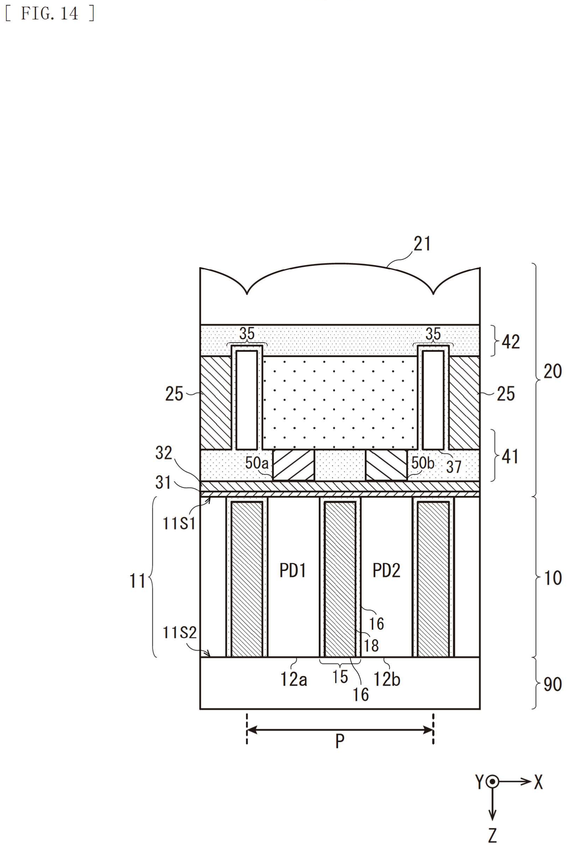

It is to be noted that, as in the example illustrated in FIG. 13, the first light-guiding member 50a and the second light-guiding member 50b may be provided inside the first insulating layer 41 not to be in contact with the antireflection film 32. In addition, as illustrated in FIG. 14, the first light-guiding member 50a and the second light-guiding member 50b may be provided to penetrate the first insulating layer 41. In the example illustrated in FIG. 14, the first light-guiding member 50a and the second light-guiding member 50b are in contact with the color filter 25 and the antireflection film 32.

Also in the case of the present embodiment, it is possible for the first light-guiding member 50a and the second light-guiding member 50b to guide light to the first photoelectric conversion section 12a and the second photoelectric conversion section 12b. Also in the case of the present embodiment, it is possible to obtain effects similar to those of the first embodiment.

Next, a description is given of modification examples of the present disclosure. Hereinafter, components similar to those of the foregoing embodiments are denoted by the same reference numerals, and descriptions thereof are omitted as appropriate.

### <4. Modification Examples>

### (4-1. Modification Example 1)

The description has been given, in the foregoing embodiments, of the configuration examples of the first light-guiding member 50a and the second light-guiding member 50b, but the configurations of the first light-guiding member 50a and the second light-guiding member 50b are not limited thereto. The first light-guiding member 50a and the second light-guiding member 50b may have different sizes.

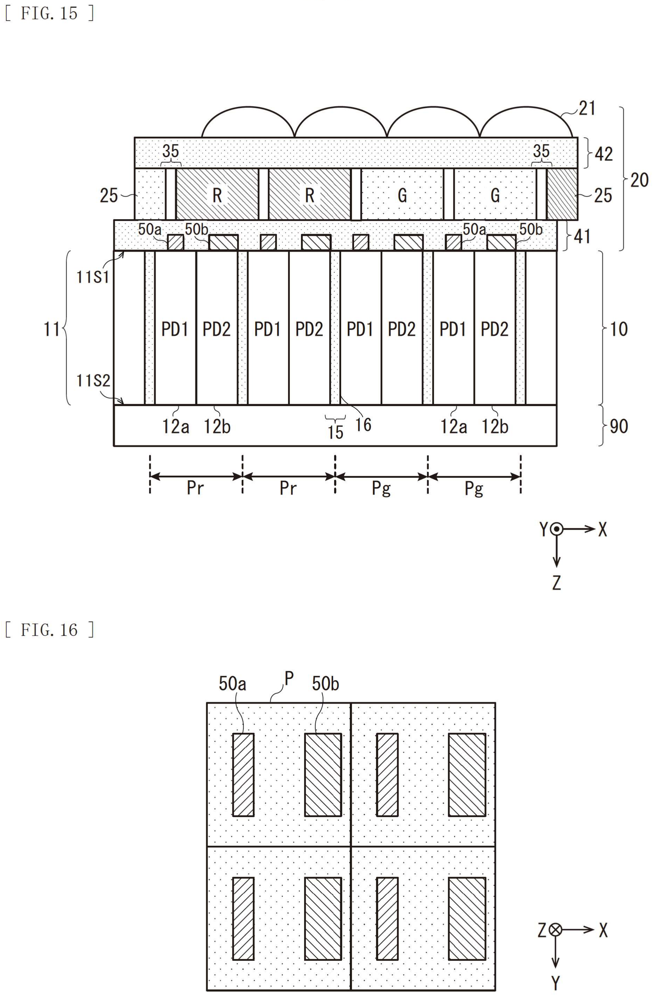

FIG. 15 is a diagram illustrating an example of a cross-sectional configuration of an imaging device according to Modification Example 1 of the present disclosure. In addition, FIG. 16 is a diagram illustrating an example of a planar configuration of the imaging device according to Modification Example 1 of the present disclosure. A size of the first light-guiding member 50a, of the first light-guiding member 50a and the second light-guiding member 50b, positioned distant from the center of the first pixel section 100 (light-receiving section 10) is smaller than a size of the second light-guiding member 50b.

In the example illustrated in FIGs. 15 and 16, a width of the first light-guiding member 50a is smaller than a width of the second light-guiding member 50b. In this case, it is possible to prevent light having passed through the color filter 25 of an adjacent pixel from being drawn by the first light-guiding member 50a, and thus to prevent color mixture.

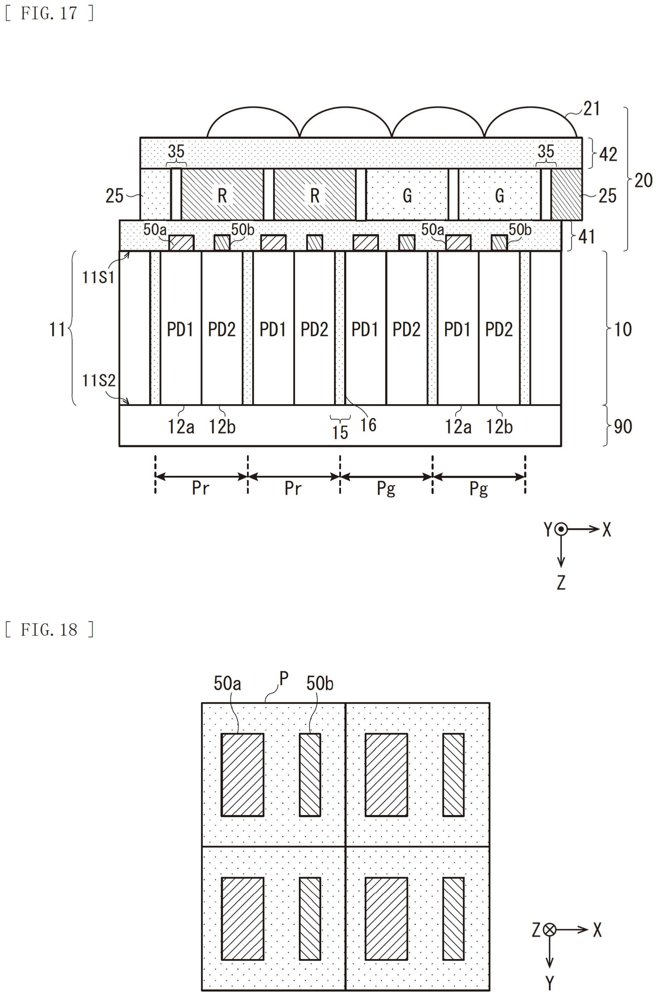

It is to be noted that, as in the example illustrated in FIGs. 17 and 18, the width of the first light-guiding member 50a may be larger than the width of the second light-guiding member 50b. In a region where the image height is high, it is possible to suppress a decrease in an amount of light incident on the first photoelectric conversion section 12a, and thus to prevent deterioration in sensitivity to incident light.

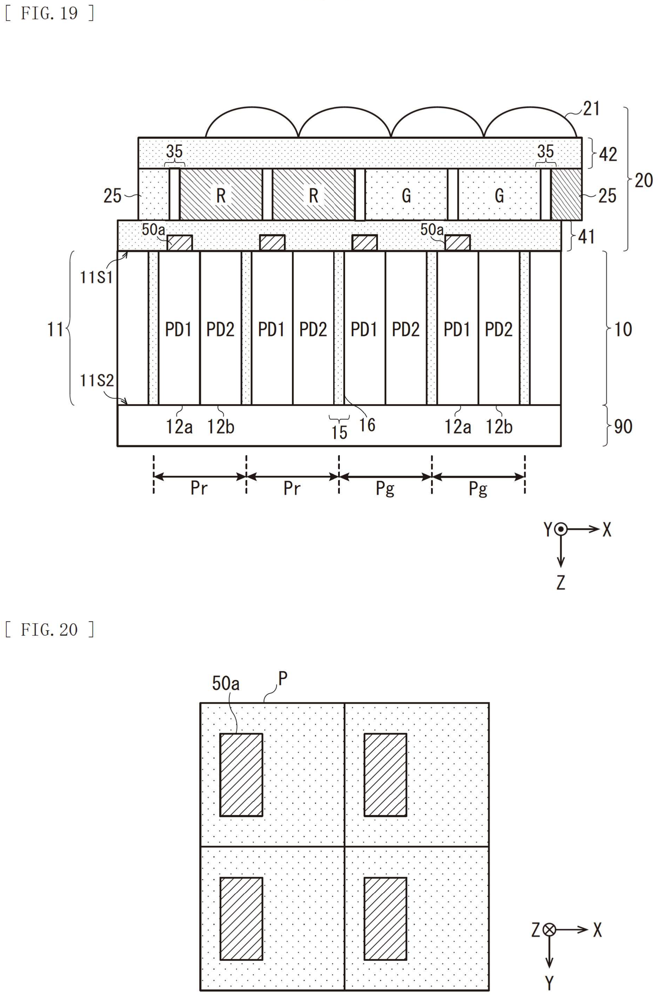

Only one of the first light-guiding member 50a and the second light-guiding member 50b may be arranged in each of the pixels P of the imaging device 1. For example, as in the example illustrated in FIGs. 19 and 20, only the first light-guiding member 50a may be arranged, whereas the second light-guiding member 50b may not be arranged. Only the second light-guiding member 50b may be arranged, whereas the first light-guiding member 50a may not be arranged.

### (4-2. Modification Example 2)

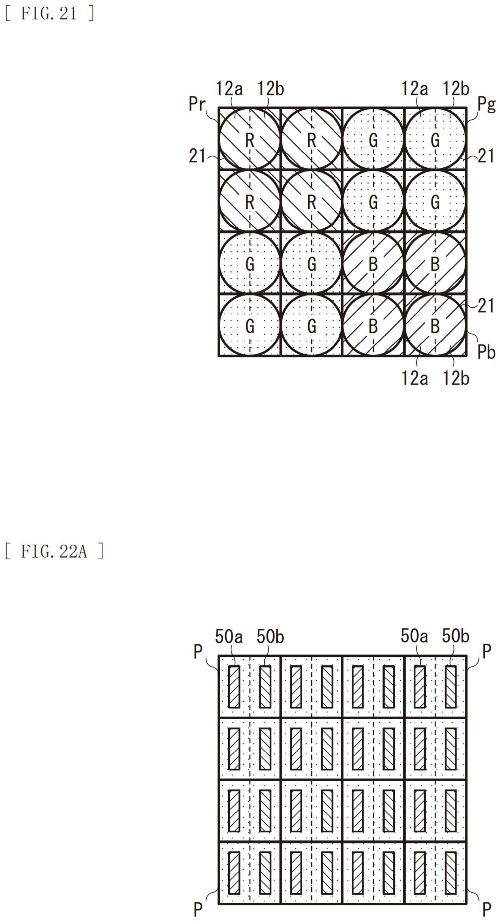

FIG. 21 is a diagram illustrating an example of an arrangement of pixels of an imaging device according to Modification Example 2. In the example illustrated in FIG. 21, the lens section 21 is provided to correspond to one pixel P. The lens section 21 is provided for each of the pixels P, and is arranged for the first photoelectric conversion section 12a and the second photoelectric conversion section 12b. As an example, in the pixel section 100 of the imaging device 1, four pixels Pr, four pixels Pg, and four pixels Pb are arranged in accordance with Bayer arrangement, as illustrated in FIG. 21.

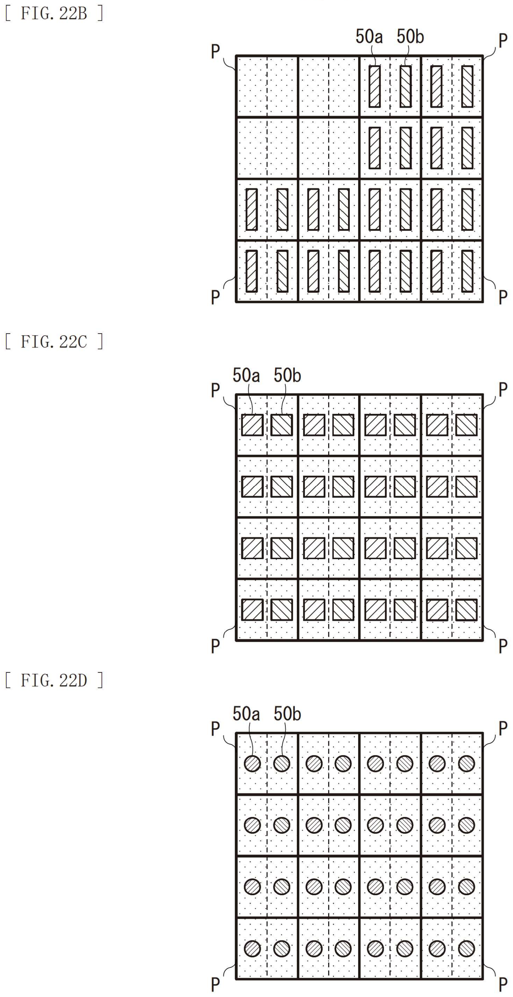

As in the example illustrated in FIG. 22A, the first light-guiding member 50a and the second light-guiding member 50b may be arranged in all of the pixels P. In addition, as in the example illustrated in FIG. 22B, the first light-guiding member 50a and the second light-guiding member 50b may not be arranged in some of the pixels P. For example, the first light-guiding member 50a and the second light-guiding member 50b may not be provided in the pixels P of a particular color. As an example, in consideration of sensitivity of human eyes, the first light-guiding member 50a and the second light-guiding member 50b may be arranged in the pixel Pg and the pixel Pb, whereas the first light-guiding member 50a and the second light-guiding member 50b may not be arranged in the pixel Pr.

The shapes of the first light-guiding member 50a and the second light-guiding member 50b are not particularly limited. The shapes of the first light-guiding member 50a and the second light-guiding member 50b may each be a quadrangular shape as illustrated in FIGs. 22A to 22C, or may be a polygonal, elliptical, or another shape. The shapes of the first light-guiding member 50a and the second light-guiding member 50b may each be a rectangular parallelepiped or a cube.

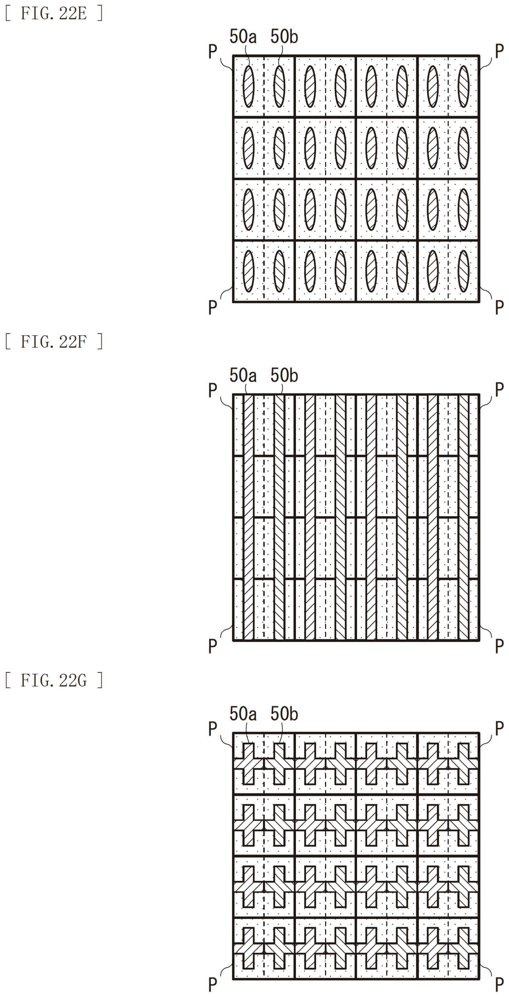

As an example, the first light-guiding member 50a and the second light-guiding member 50b may each have a circular shape in a plan view, as illustrated in FIG. 22D. In addition, the first light-guiding member 50a and the second light-guiding member 50b may each have an elliptical shape, as illustrated in FIG. 22E. In addition, for example, the first light-guiding member 50a and the second light-guiding member 50b may each have a slit shape, as illustrated in FIG. 22F.

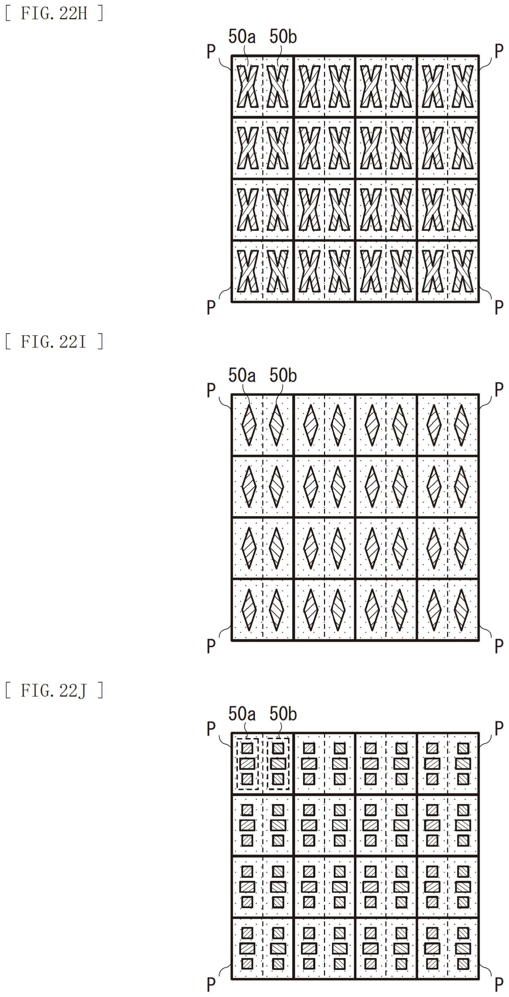

As another example, the first light-guiding member 50a and the second light-guiding member 50b may each have a cross shape, as illustrated in FIGs. 22G and 22H. In addition, the first light-guiding member 50a and the second light-guiding member 50b may each have a rhombic shape, as illustrated in FIG. 22I. It is to be noted that the first light-guiding member 50a and the second light-guiding member 50b may each be provided separately in a plurality of portions, as illustrated in FIG. 22J.

### (4-3. Modification Example 3)

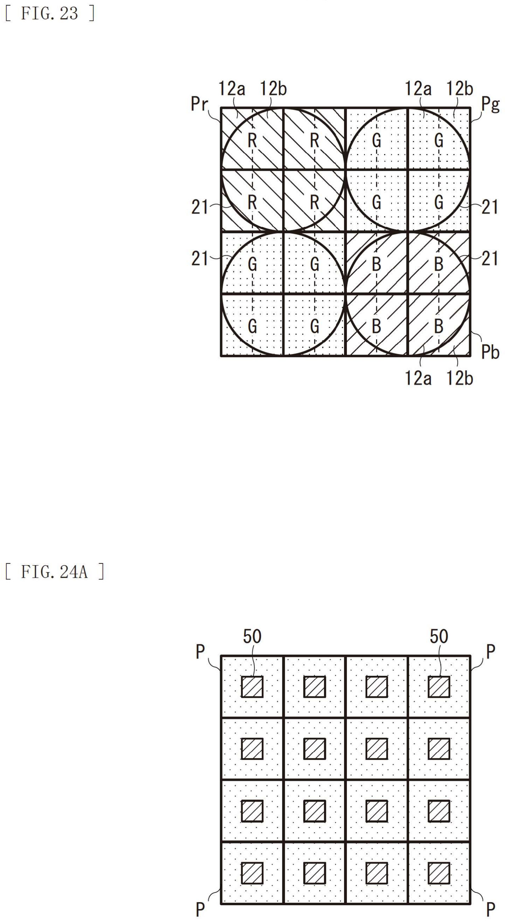

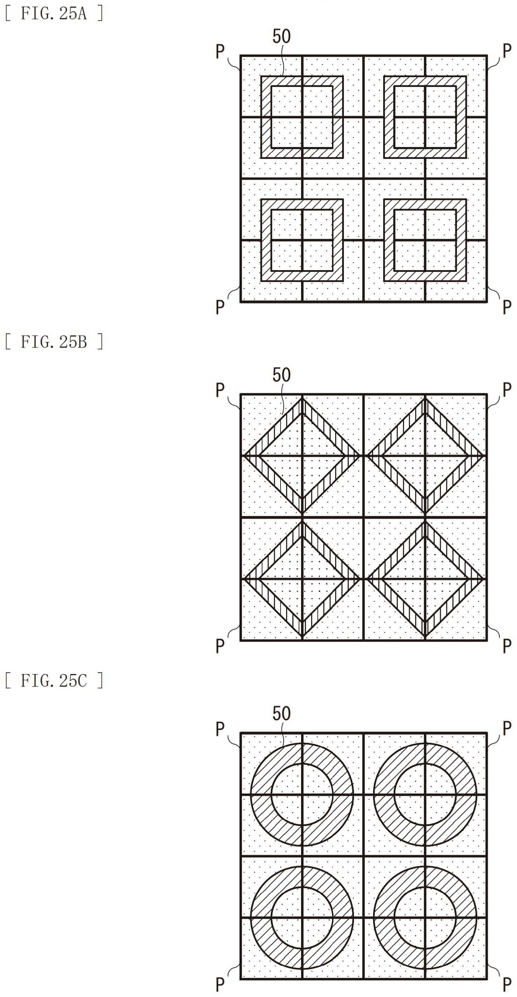

FIG. 23 is a diagram illustrating an example of an arrangement of pixels of an imaging device according to Modification Example 3. In the example illustrated in FIG. 23, the lens section 21 is provided to correspond to four pixels P. The lens section 21 is provided for every four pixels P. In addition, for example, each of the pixels P (pixel Pr, pixel Pg, and pixel Pb in FIG. 23) includes one light-guiding member 50 (see FIGs. 24A to 24F, 25A to 25C, or other drawings described later).

In the present modification example, respective photoelectric conversion sections of the four pixels P receive light beams having passed through regions of different optical system to allow pupil division to be performed. Using respective pixel signals of the four pixels P makes it possible to obtain phase difference data (phase difference information), and thus to perform the phase difference AF (Auto Focus). Also in the case of the present modification example, it is possible to cause the light-guiding member 50 of each of the pixels P to appropriately separate (disperse) light from the optical system and guide the light to the photoelectric conversion section of each of the pixels P. It is therefore possible to suppress deterioration in accuracy of detecting a phase difference, and thus to prevent deterioration in the AF performance. It is possible to obtain effects similar to those of the foregoing embodiments.

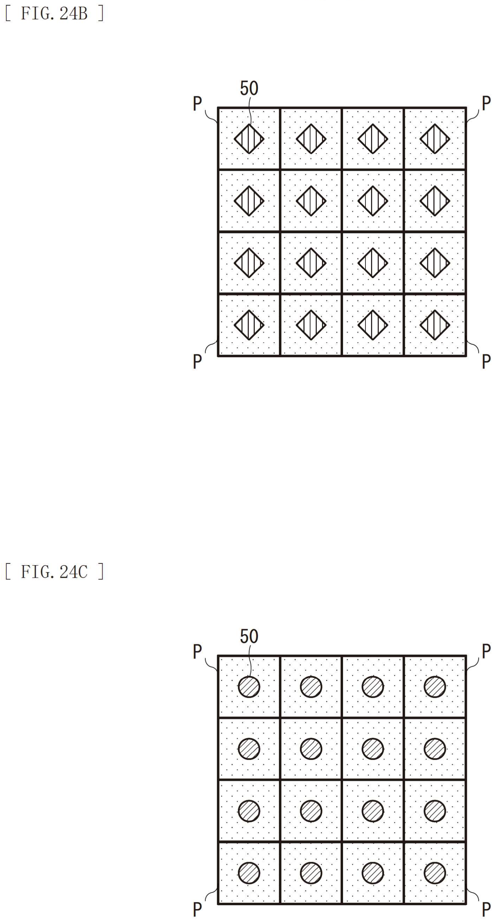

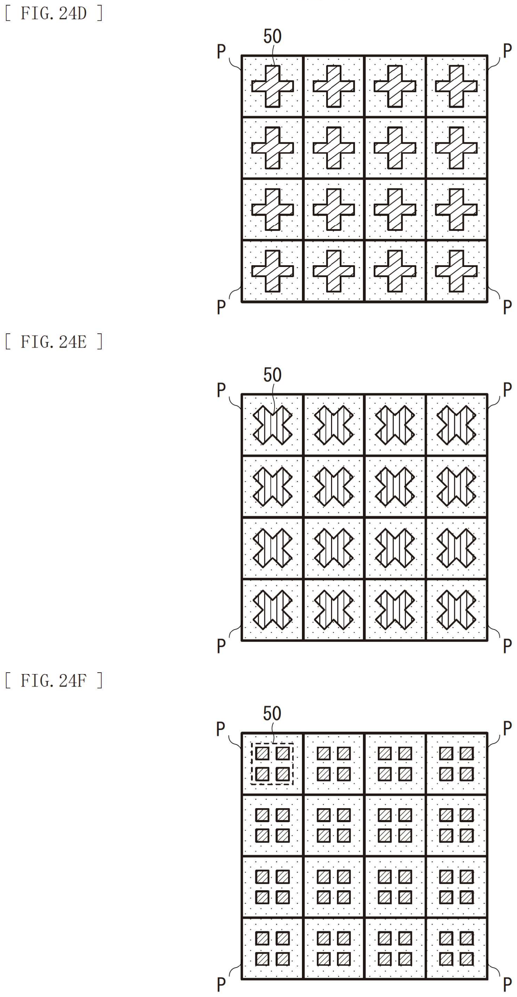

It is to be noted that the shape of light-guiding member 50 is not particularly limited. The shape of the light-guiding member 50 may be, for example, quadrangular, as illustrated in FIGs. 24A and 24B, or may be a polygonal, elliptical, or another shape. The light-guiding member 50 may have a circular shape in a plan view, as illustrated in FIG. 24C. The light-guiding member 50 may have a cross shape, as illustrated in FIGs. 24D and 24E. In addition, the light-guiding member 50 may be provided separately in a plurality of portions, as illustrated in FIG. 24F.

In addition, the light-guiding member 50 may be provided for four pixels P, as illustrated in FIGs. 25A to 25C. For example, as in the examples illustrated in FIGs. 25A to 25C, the light-guiding member 50 having a quadrangular shape, a circular shape, or the like may be arranged to straddle four pixels P.

### (4-4. Modification Example 4)

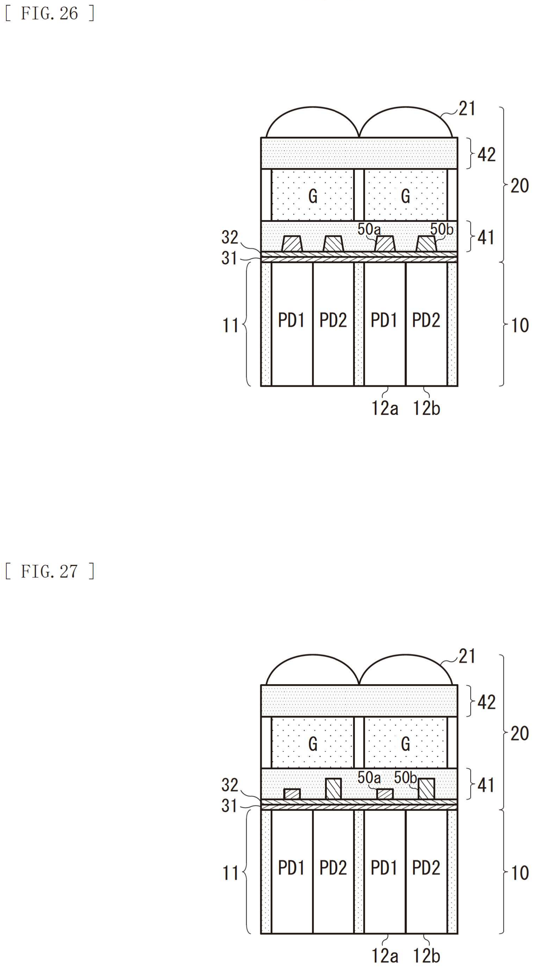

FIG. 26 is a diagram illustrating an example of a cross-sectional configuration of an imaging device according to Modification Example 4. The first light-guiding member 50a and the second light-guiding member 50b may each have a tapered shape, as illustrated in FIG. 26. In the example illustrated in FIG. 26, widths of the first light-guiding member 50a in the X-axis direction and the Y-axis direction become larger as being closer to the first photoelectric conversion section 12a. In addition, widths of the second light-guiding member 50b in the X-axis direction and the Y-axis direction become larger as being closer to the second photoelectric conversion section 12b.

The first light-guiding member 50a and the second light-guiding member 50b may have different heights, as illustrated in FIG. 27. In the example illustrated in FIG. 27, the first light-guiding member 50a and the second light-guiding member 50b have different thicknesses (film thicknesses). For example, a height of the first light-guiding member 50a (height of the first light-guiding member 50a in the Z-axis direction) may be smaller than a height of the second light-guiding member 50b.

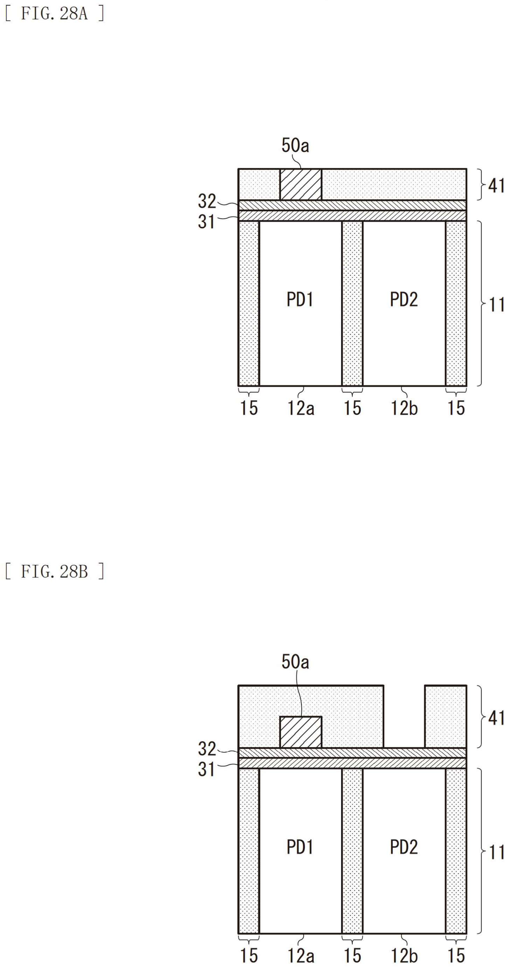

FIGs. 28A to 28D are each a diagram illustrating an example of a method of manufacturing the imaging device according to Modification Example 4. First, the semiconductor substrate 11 in which the first photoelectric conversion section 12a, the second photoelectric conversion section 12b, and the like are formed is subjected to film formation processing, planarization processing (etch-back processing or CMP processing), or the like. In this case, as illustrated in FIG. 28A, the first insulating layer 41 and the first light-guiding member 50a are formed on the semiconductor substrate 11.

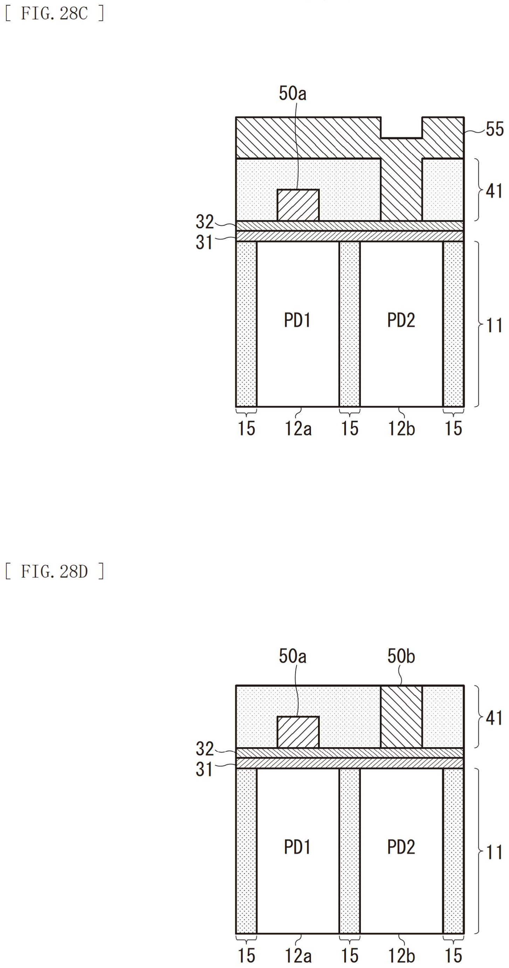

Next, a silicon oxide film of the first insulating layer 41 is selectively removed by lithography and dry etching as illustrated in FIG. 28B, and thereafter the high refractive index section 55 is formed as illustrated in FIG. 28C. Next, planarization processing is performed to thereby form the first light-guiding member 50a and the second light-guiding member 50b as illustrated in FIG. 28D. Subsequently, in the same manner as the case of the foregoing embodiments, the light-guiding wall 35, the color filter 25, the lens section 21, and the like are formed. Through the manufacturing method as described above, the imaging device 1 illustrated in FIG. 27 is able to be manufactured.

### (4-5. Modification Example 5)

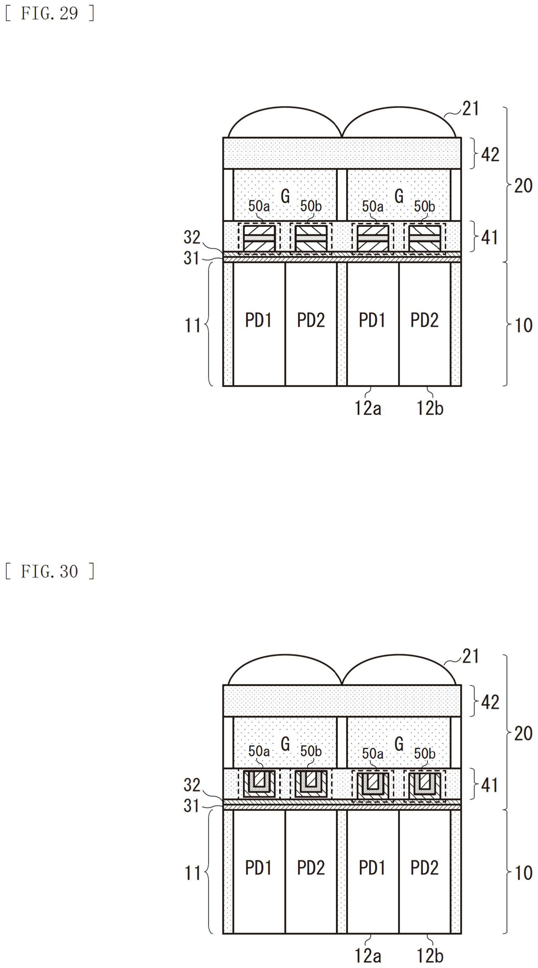

FIGs. 29 and 30 are each a diagram illustrating an example of a cross-sectional configuration of an imaging device according to Modification Example 5. As in the example illustrated in FIG. 29 or 30, the first light-guiding member 50a and the second light-guiding member 50b may each be configured by a stacked film in which a plurality of films are stacked.

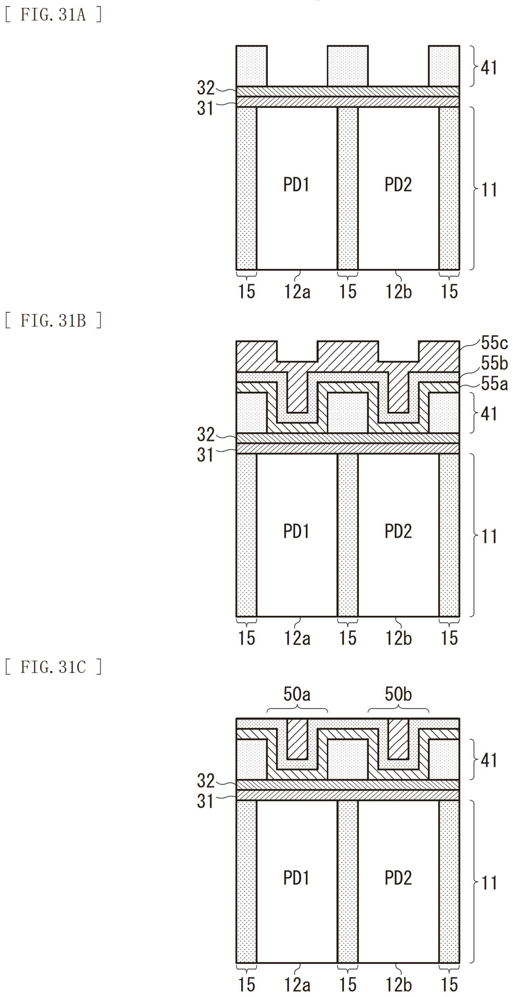

FIGs. 31A to 31C are each a diagram illustrating an example of a method of manufacturing the imaging device according to Modification Example 5. First, a silicon oxide film is formed as the first insulating layer 41 on the semiconductor substrate 11 in which the first photoelectric conversion section 12a, the second photoelectric conversion section 12b, and the like are formed. Then, as illustrated in FIG. 31A, the silicon oxide film of the first insulating layer 41 is selectively removed by lithography and dry etching.

Next, as illustrated in FIG. 31B, a multilayer film including a high refractive index section 55a to a high refractive index section 55c is formed. Then, performing planarization processing allows the first light-guiding member 50a and the second light-guiding member 50b to be formed, as illustrated in FIG. 31C. Thereafter, the light-guiding wall 35, the color filter 25, the lens section 21, and the like are formed. Through the manufacturing method as described above, the imaging device 1 illustrated in FIG. 30 or other drawings is able to be manufactured.

### (4-6. Modification Example 6)

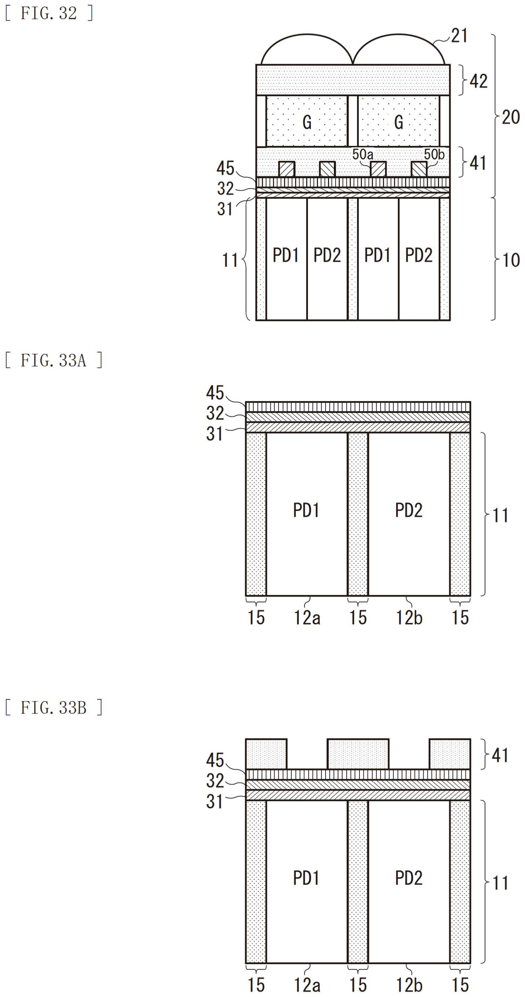

FIG. 32 is a diagram illustrating an example of a cross-sectional configuration of an imaging device according to Modification Example 6. The first light-guiding member 50a and the second light-guiding member 50b may be formed on an etching stopper film. In the example illustrated in FIG. 32, the first light-guiding member 50a and the second light-guiding member 50b are each provided on a stopper film 45.

FIGs. 33A and 33B are each an explanatory diagram of an example of a method of manufacturing the imaging device according to Modification Example 6. First, the fixed charge film 31, the antireflection film 32, and the stopper film 45 are sequentially formed on the semiconductor substrate 11 in which the first photoelectric conversion section 12a, the second photoelectric conversion section 12b, and the like are formed.

Next, a silicone oxide film is formed as the first insulating layer 41 on the stopper film 45. Then, as illustrated in FIG. 33B, the silicon oxide film of the first insulating layer 41 is selectively removed by lithography and dry etching. Thereafter, in the same manner as the case of the foregoing embodiments or modification examples, the first light-guiding member 50a and the second light-guiding member 50b, the light-guiding wall 35, the color filter 25, the lens section 21, and the like are formed. Through the manufacturing method as described above, the imaging device 1 illustrated in FIG. 32 is able to be manufactured.

### (4-7. Modification Example 7)

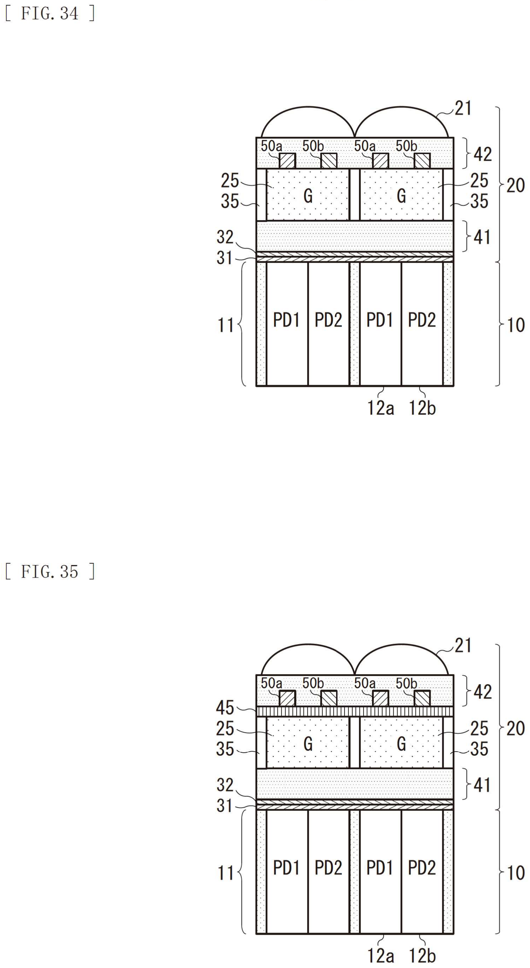

FIG. 34 is a diagram illustrating an example of a cross-sectional configuration of an imaging device according to Modification Example 7. The first light-guiding member 50a and the second light-guiding member 50b may be provided between the lens section 21 and the color filter 25. In the example illustrated in FIG. 34, the first light-guiding member 50a and the second light-guiding member 50b are provided in the second insulating layer 42 between the lens section 21 and the color filter 25.

FIG. 35 is a diagram illustrating another example of the cross-sectional configuration of the imaging device according to Modification Example 7. As in the example illustrated in FIG. 35, the first light-guiding member 50a and the second light-guiding member 50b may be arranged on the stopper film 45 between a layer provided with the lens section 21 and a layer provided with the color filter 25. In the example illustrated in FIG. 35, the stopper film 45 is provided to cover the color filter 25 and the light-guiding wall 35.

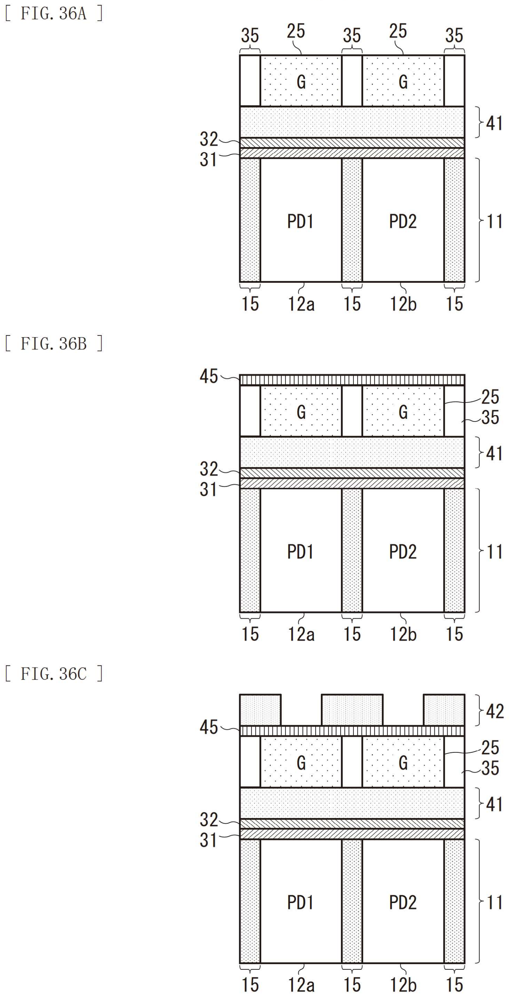

FIGs. 36A to 36E are each a diagram illustrating an example of a method of manufacturing the imaging device according to Modification Example 7. First, as illustrated in FIG. 36A, the first insulating layer 41, the color filter 25, and the like are formed on the semiconductor substrate 11 in which the first photoelectric conversion section 12a, the second photoelectric conversion section 12b, and the like are formed.

Next, as illustrated in FIG. 36B, the stopper film 45 is formed on the color filter 25. Then, as illustrated in FIG. 36C, a silicon oxide film is formed as the second insulating layer 42 on the stopper film 45, and thereafter the silicon oxide film of the second insulating layer 42 is selectively removed by lithography and dry etching.

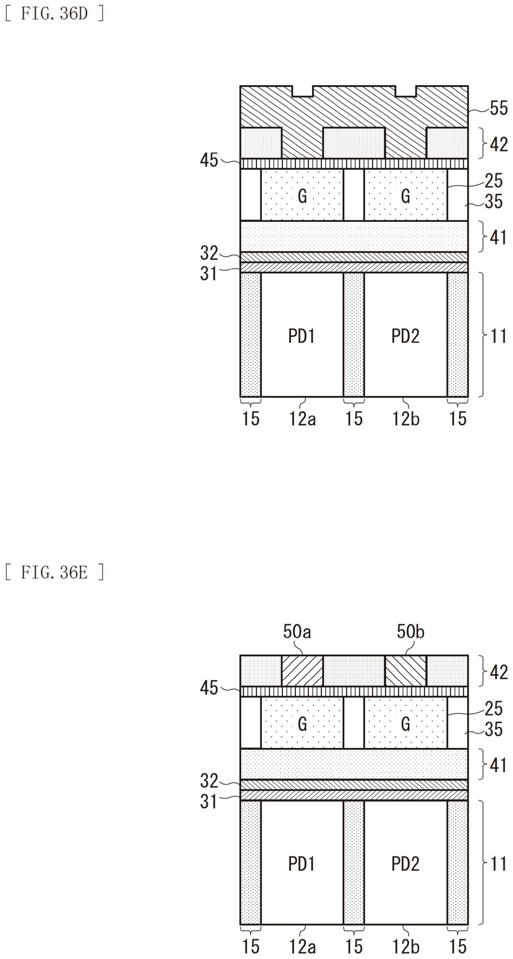

Next, as illustrated in FIG. 36D, the high refractive index section 55 is formed. Then, planarization processing is performed to thereby form the first light-guiding member 50a and the second light-guiding member 50b, as illustrated in FIG. 36E. Thereafter, the lens section 21 or the like is formed. Through the manufacturing method as described above, the imaging device 1 illustrated in FIG. 35 is able to be manufactured.

### (4-8. Modification Example 8)

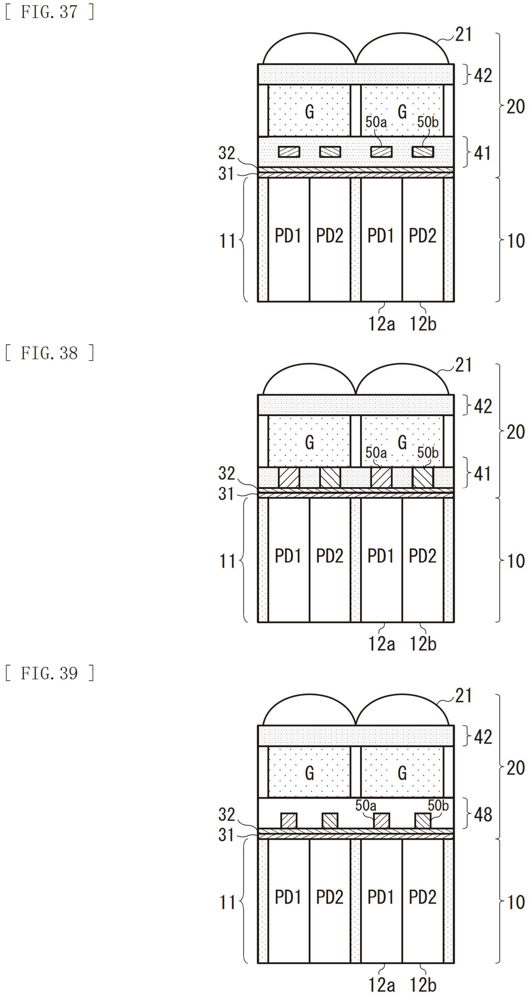

FIGs. 37 and 38 are each a diagram illustrating an example of a cross-sectional configuration of an imaging device according to Modification Example 8. The first light-guiding member 50a and the second light-guiding member 50b may be provided inside the first insulating layer 41 as illustrated in FIG. 37, or may be provided to penetrate the first insulating layer 41 as illustrated in FIG. 38.

A low refractive index member may be provided around the first light-guiding member 50a and the second light-guiding member 50b. FIG. 39 is a diagram illustrating another example of the cross-sectional configuration of the imaging device according to Modification Example 8. In the example illustrated in FIG. 39, the imaging device 1 includes a low refractive index section 48. The low refractive index section 48 is an insulating layer configured using a low refractive index material, and is provided around the first light-guiding member 50a and the second light-guiding member 50b.

### (4-9. Modification Example 9)

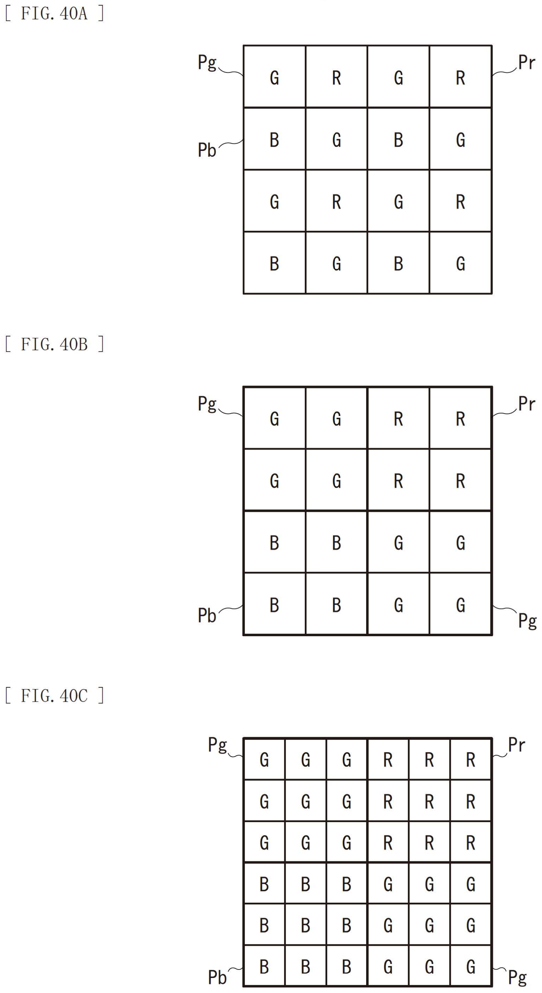

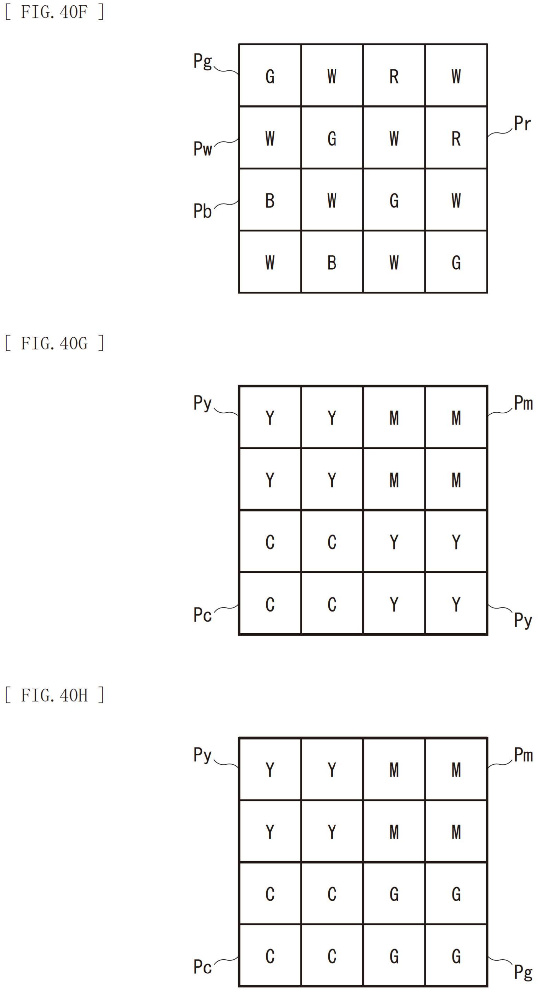

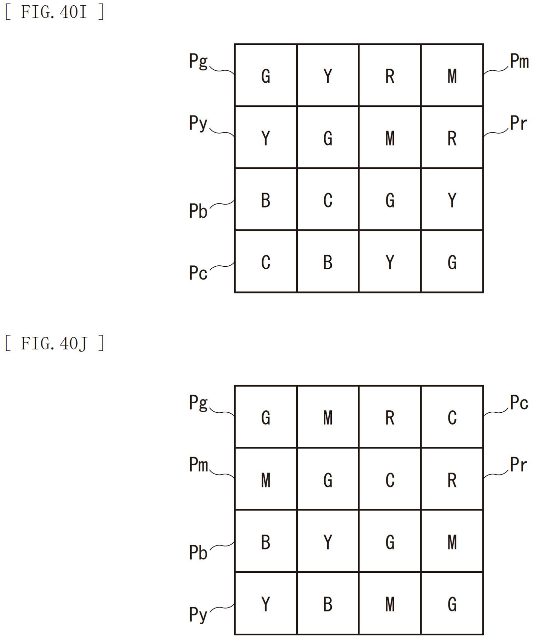

Although the description has been given, in the foregoing embodiments and modification examples, of the examples of the arrangement of pixels, the arrangement of pixels is not limited to the above-described examples. For example, as illustrated in FIG. 40A, one pixel Pr, one pixel Pg, and one pixel Pb may be arranged in accordance with Bayer arrangement. In addition, as illustrated in FIG. 40B, four pixels Pr in 2 × 2, four pixels Pg in 2 × 2, and four pixels Pb in 2 × 2 may be arranged in accordance with Bayer arrangement.

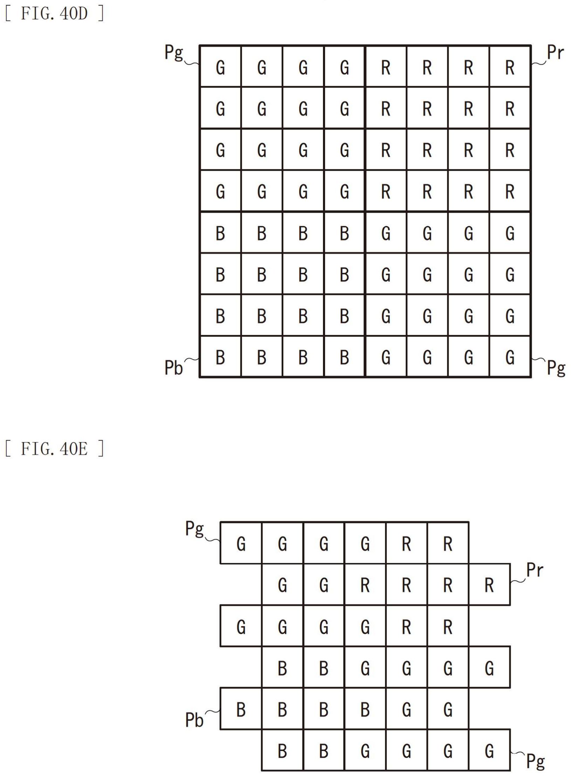

As illustrated in FIG. 40C, nine pixels Pr in 3 × 3, nine pixels Pg in 3 × 3, and nine pixels Pb in 3 × 3 may be repeatedly arranged. In addition, as illustrated in FIG. 40D, 16 pixels Pr in 4 × 4, 16 pixels Pg in 4 × 4, and 16 pixels Pb in 4 × 4 may be repeatedly arranged. In addition, for example, the pixel Pr, the pixel Pg, and the pixel Pb may be arranged as illustrated in FIG. 40E.

As in the example illustrated in FIG. 40F, a pixel Pw including a W (white) color filter may be provided. In addition, as in the examples illustrated in FIGs. 40G to 40J, a pixel Pc including a Cy (cyan) color filter, a pixel Pm including a Mg (magenta) color filter, and a pixel Py including a Ye (yellow) color filter may be arranged, in addition to the pixel Pr, the pixel Pg, and the pixel Pb.

### (4-10. Modification Example 10)

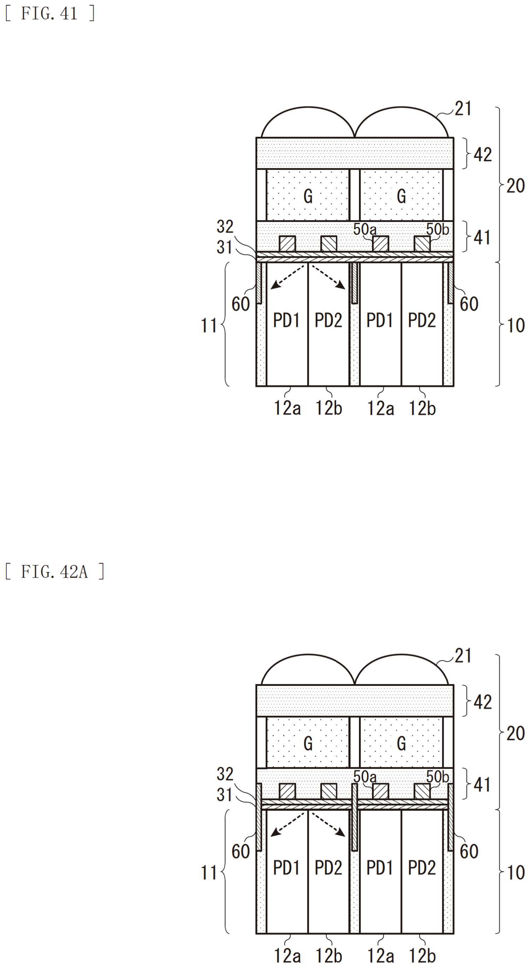

FIG. 41 is a diagram illustrating an example of a cross-sectional configuration of an imaging device according to Modification Example 10. The imaging device 1 according to the present modification example is provided with a light-blocking section 60. The light-blocking section 60 (light-blocking film) is configured by a member that blocks light. In the semiconductor substrate 11, for example, the light-blocking section 60 (light-blocking member) is provided between the photoelectric conversion sections adjacent to each other (between the first photoelectric conversion section 12a and the second photoelectric conversion section 12b, in the example illustrated in FIG. 41).

The light-blocking section 60 can be configured by a material of which an extinction coefficient k is not zero. The light-blocking section 60 is configured by a metal material, for example. In addition, the light-blocking section 60 may be configured using a metal compound. The light-blocking section 60 may be configured by another material that absorbs light.

In the present modification example, as schematically indicated by broken lines in FIG. 41, providing the light-blocking section 60 makes it possible to suppress leakage of light into the photoelectric conversion sections therearound, and thus to reduce color mixture. It is possible, in the imaging device 1, to appropriately separate (disperse) incident light while reducing color mixture.

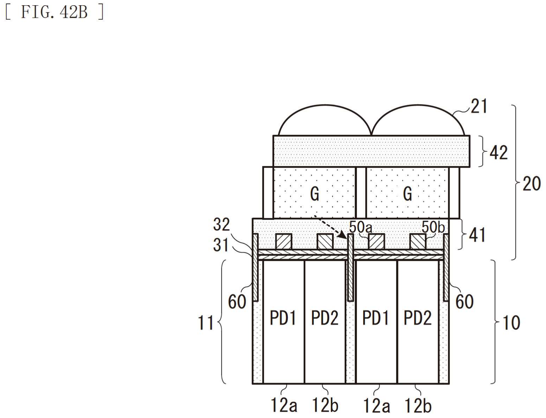

FIG. 42A is a diagram illustrating another example of the cross-sectional configuration of the imaging device according to Modification Example 10. In addition, FIG. 42B is a diagram illustrating an example of a cross-sectional configuration of an imaging device in a region where an image height is high. As in the examples illustrated in FIGs. 42A and 42B, the light-blocking section 60 may be provided inside the semiconductor substrate 11 and the first insulating layer 41.

The light-blocking section 60 extends from the first insulating layer 41 into the semiconductor substrate 11. As schematically indicated by a broken line in FIG. 42B, for example, providing the light-blocking section 60 inside the first insulating layer 41 makes it possible to suppress occurrence of leakage of light into the first insulating layer 41, and thus to reduce color mixture. In addition, also in the case of the present modification example, it is possible to obtain effects similar to those of the foregoing embodiments.

### <5. Fourth Embodiment>

Next, description is given of a fourth embodiment of the present disclosure. Hereinafter, components similar to those of the foregoing embodiments are denoted by the same reference numerals, and descriptions thereof are omitted as appropriate.

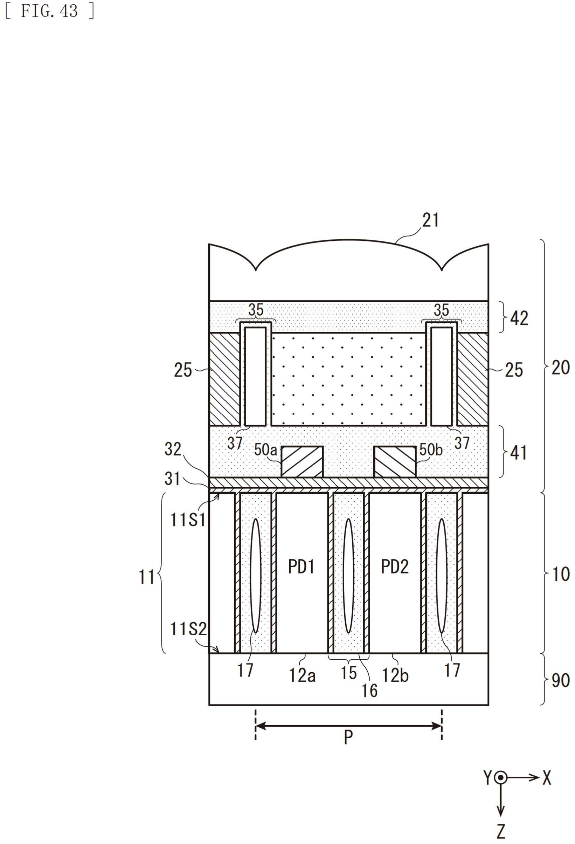

FIG. 43 is a diagram illustrating an example of a cross-sectional configuration of an imaging device according to the fourth embodiment of the present disclosure. Each of the pixels P of the imaging device 1 may have a structure illustrated in FIG. 43. The fixed charge film 31 and the antireflection film 32 may be provided along the first surface 11S1 of the semiconductor substrate 11, as in the example illustrated in FIG. 43.

Each of the first light-guiding member 50a and the second light-guiding member 50b may be positioned on the antireflection film 32, and may be provided in contact with the antireflection film 32. The fixed charge film 31 may be provided to cover the side surface (side part) of the trench 16, for example. In addition, the separation section 15 may have the air gap 17 (cavity).

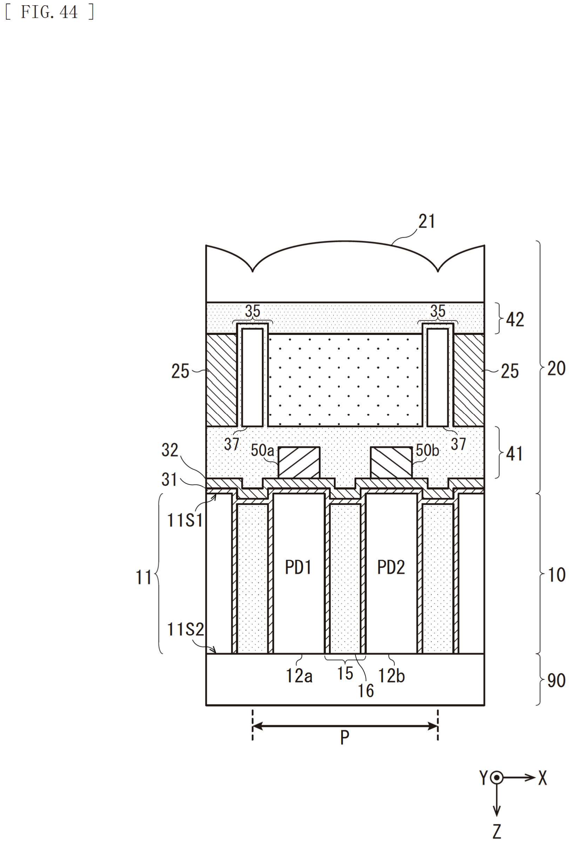

FIG. 44 is a diagram illustrating another example of the cross-sectional configuration of the imaging device according to the fourth embodiment. At least one of the fixed charge film 31 or the antireflection film 32 may have a shape including unevenness. For example, a portion of each of the fixed charge film 31 and the antireflection film 32 may be provided by digging the semiconductor substrate 11 which is a semiconductor layer. In the example illustrated in FIG. 44, the fixed charge film 31 and the antireflection film 32 each have a plurality of recesses and a plurality of protrusions, and can also be said to have an uneven structure.

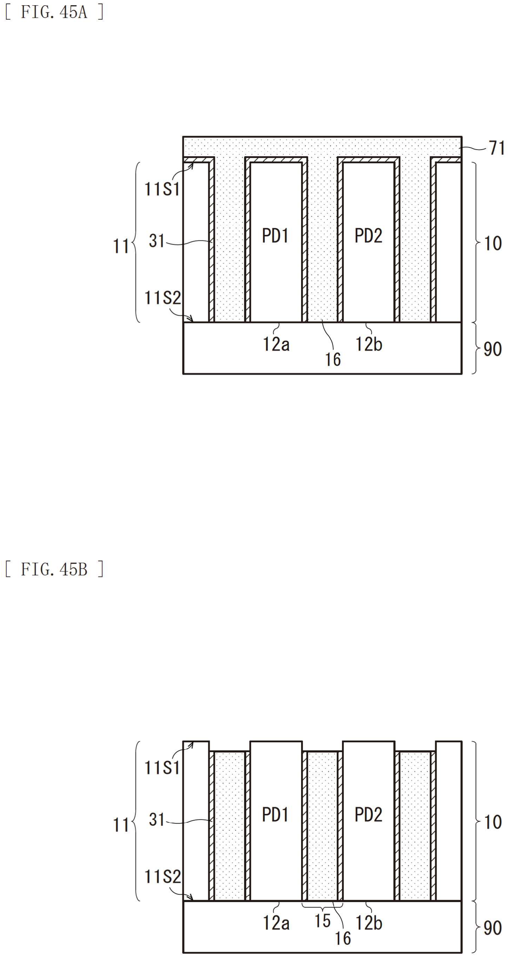

FIGs. 45A to 45G are each a diagram illustrating an example of a method of manufacturing the imaging device according to the fourth embodiment. As illustrated in FIG. 45A, the fixed charge film 31 is formed along the side surface (sidewall) of the trench 16 of the semiconductor substrate 11, and a silicon oxide film 71 is formed to fill the inside of the trench 16. Then, as illustrated in FIG. 45B, a portion of the silicon oxide film 71 and a portion of the fixed charge film 31 are removed by CMP (Chemical Mechanical Polishing) processing.

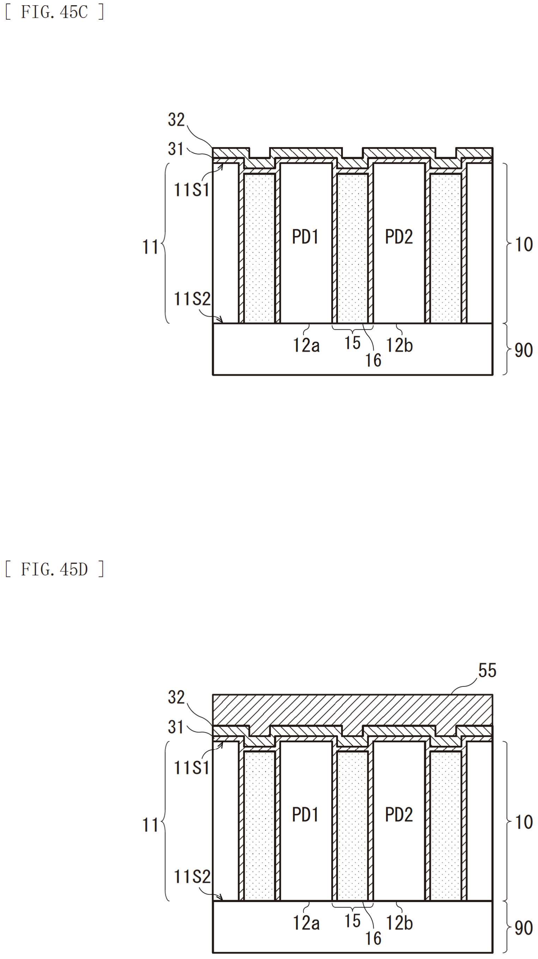

Next, as illustrated in FIG. 45C, the fixed charge film 31 and the antireflection film 32 are formed. Then, as illustrated in FIG. 45D, the high refractive index section 55 including a high refractive material is formed on the fixed charge film 31 and the antireflection film 32. For example, a silicon nitride film is formed, as the high refractive index section 55, by CVD or ALD.

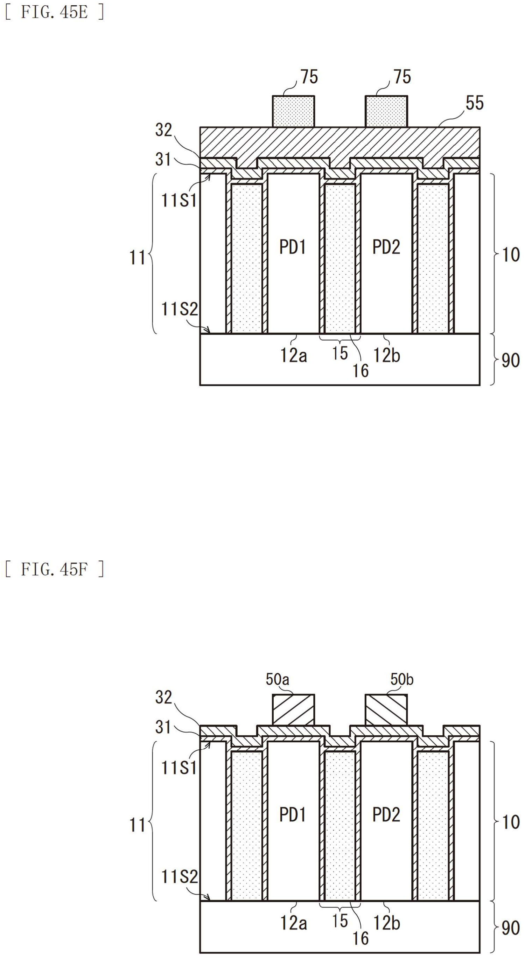

Next, as illustrated in FIG. 45E, a resist film 75 is formed on the high refractive index section 55 by lithography and etching. Then, partially removing the high refractive index section 55 by etching allows for formation of the first light-guiding member 50a and the second light-guiding member 50b, as in illustrated in FIG. 45F.

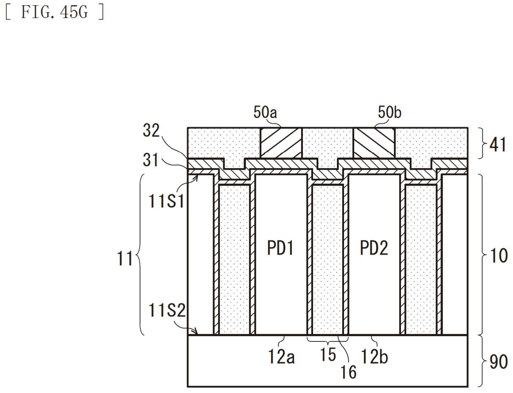

Next, as illustrated in FIG. 45G, the first insulating layer 41 is formed around the first light-guiding member 50a and the second light-guiding member 50b. Thereafter, the color filter 25, the second insulating layer 42, the lens section 21, and the like are formed. The manufacturing method as described above enables the imaging device 1 illustrated in FIG. 44 to be manufactured. It is to be noted that the above-described manufacturing method is merely exemplary and another manufacturing method may also be employed.

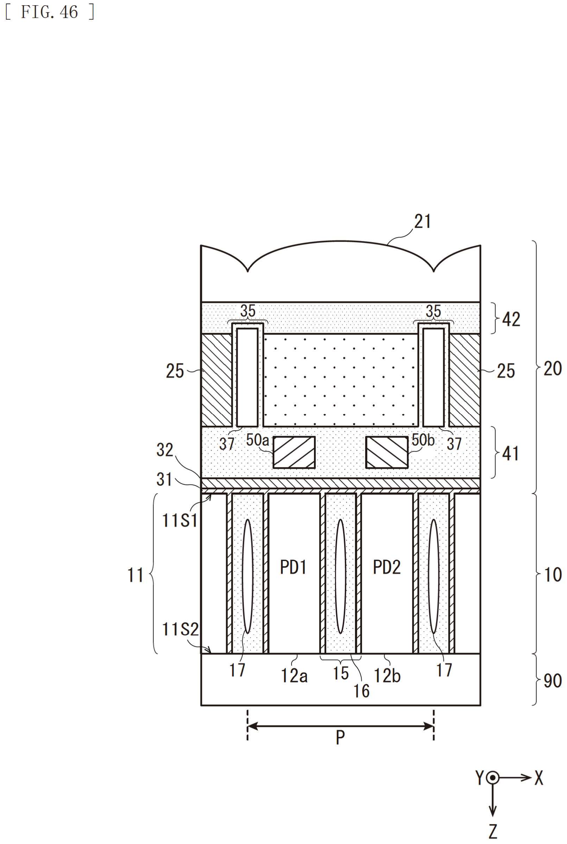

FIG. 46 is a diagram illustrating another example of the cross-sectional configuration of the imaging device according to the fourth embodiment. Each of the pixels P of the imaging device 1 may have the structure illustrated in FIG. 46. Each of the first light-guiding member 50a and the second light-guiding member 50b may be provided in the first insulating layer 41 and may not be in contact with the antireflection film 32, as in the example illustrated in FIG. 46.

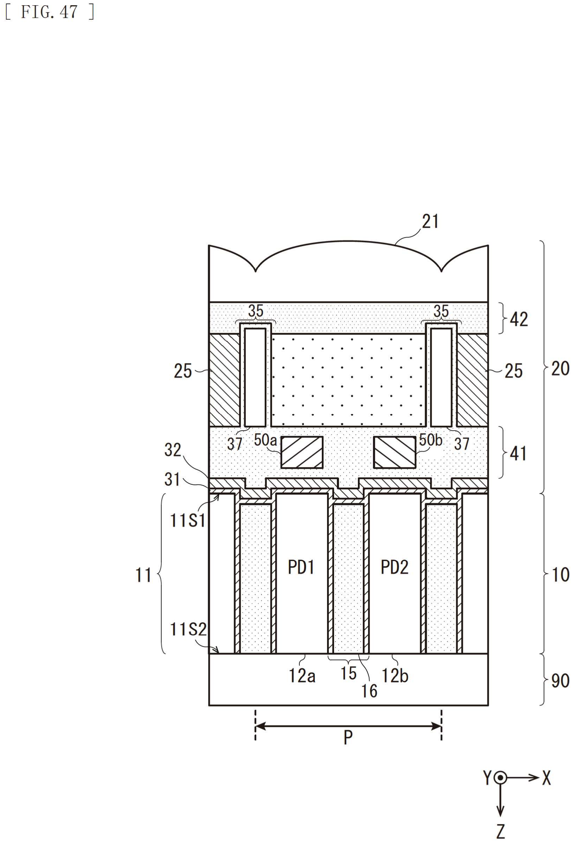

In the example illustrated in FIG. 46, a portion of the first insulating layer 41 is provided between the first light-guiding member 50a and the antireflection film 32. In addition, a portion of the first insulating layer 41 is provided between the second light-guiding member 50b and the antireflection film 32. It is to be noted that the fixed charge film 31 and the antireflection film 32 may each have an uneven shape, as in the example illustrated in FIG. 47.

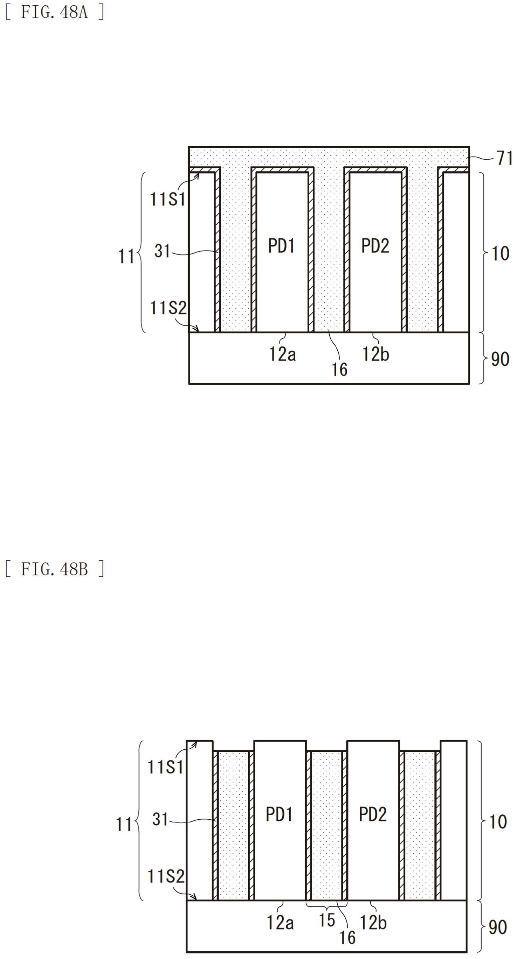

FIGs. 48A to 48H are each a diagram illustrating an example of the method of manufacturing the imaging device according to the fourth embodiment. As illustrated in FIG. 48A, the fixed charge film 31 is formed along the side surface (side part) of the trench 16 of the semiconductor substrate 11, and the silicon oxide film 71 is formed to fill the inside of the trench 16. Then, as illustrated in FIG. 48B, a portion of the silicon oxide film 71 and a portion of the fixed charge film 31 are removed by CMP processing.

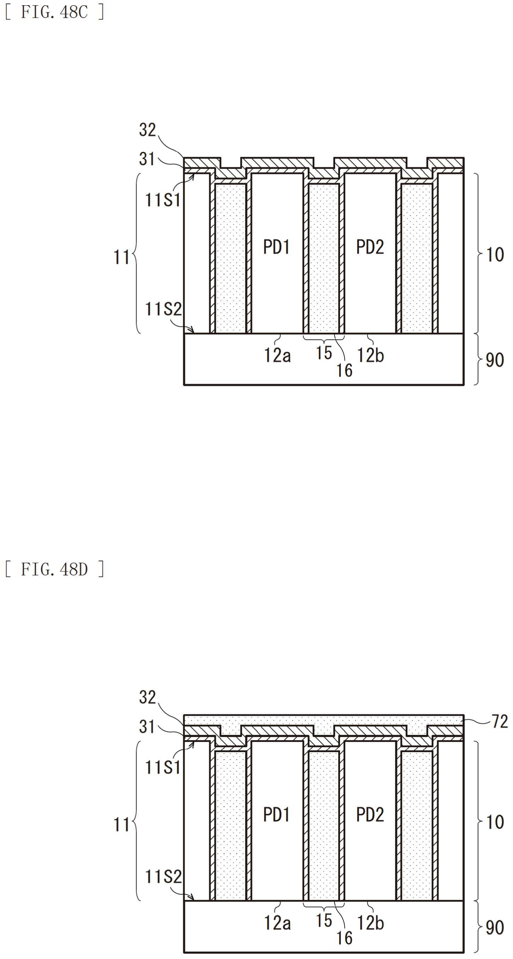

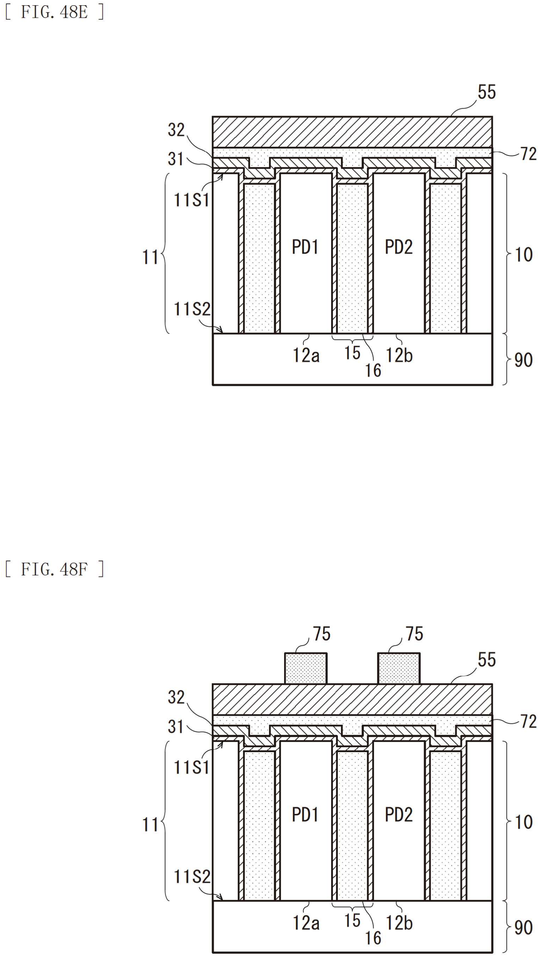

Next, as illustrated in FIG. 48C, the fixed charge film 31 and the antireflection film 32 are formed. Then, as illustrated in FIG. 48D, a silicon oxide film 72 as a portion of the first insulating layer 41 is formed on the fixed charge film 31 and the antireflection film 32. Further, as illustrated in FIG. 48E, the high refractive index section 55 (e.g., a silicon nitride film) including a high refractive material is formed on the silicon oxide film 72.

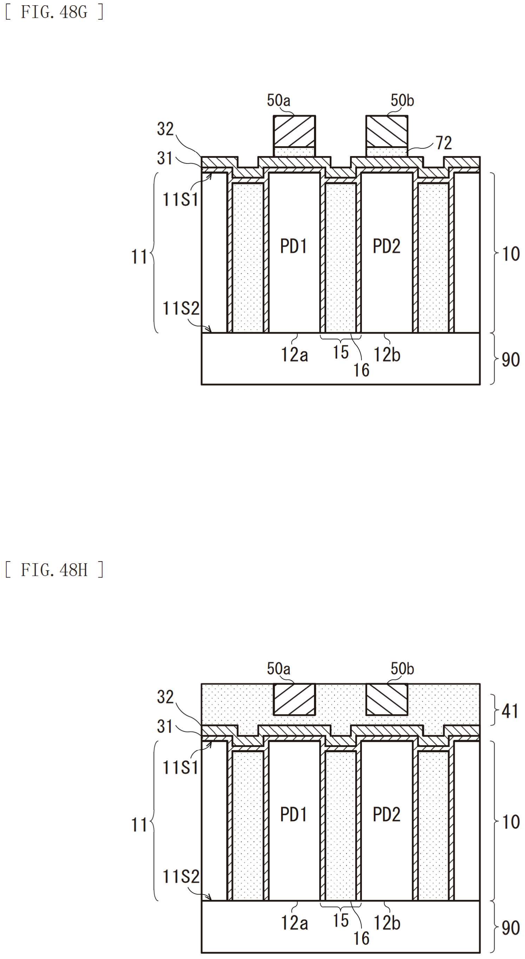

Next, as illustrated in FIG. 48F, the resist film 75 is formed on the high refractive index section 55 by lithography and etching. Then, partially removing the high refractive index section 55 by etching allows for formation of the first light-guiding member 50a and the second light-guiding member 50b, as illustrated in FIG. 48G.

Next, as illustrated in FIG. 48H, the first insulating layer 41 is formed by forming a silicon oxide film around the first light-guiding member 50a and the second light-guiding member 50b. Thereafter, the color filter 25, the second insulating layer 42, the lens section 21, and the like are formed. The manufacturing method as described above enables the imaging device 1 illustrated in FIG. 47 to be manufactured. It is to be noted that the above-described manufacturing method is merely exemplary and another manufacturing method may also be employed.

Also in the case of the imaging device 1 according to the present embodiment, it is possible for the first light-guiding member 50a and the second light-guiding member 50b to guide light to the first photoelectric conversion section 12a and the second photoelectric conversion section 12b. Also in the case of the present embodiment, it is possible to obtain effects similar to those of the first embodiment.

### <6. Fifth Embodiment>

Next, description is given of a fifth embodiment of the present disclosure. Hereinafter, components similar to those of the foregoing embodiments are denoted by the same reference numerals, and descriptions thereof are omitted as appropriate.

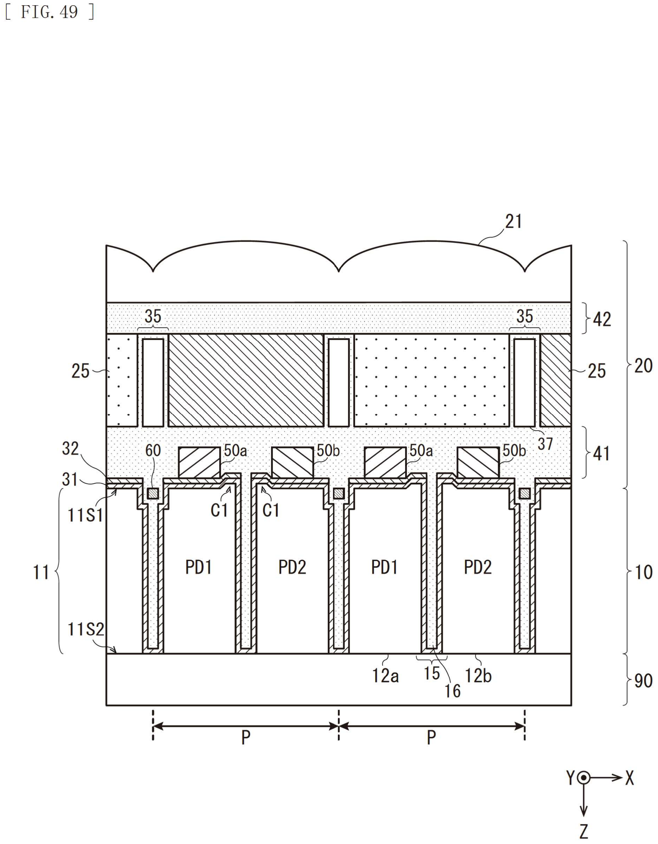

FIG. 49 is a diagram illustrating an example of a cross-sectional configuration of an imaging device according to the fifth embodiment of the present disclosure. The imaging device 1 may include the light-blocking section 60, as illustrated in FIG. 49. The light-blocking section 60 is a light-blocking member (light-blocking film) configured by a member that blocks light. At least a portion of the light-blocking section 60 is provided at a boundary between the plurality of pixels P adjacent to each other, for example, in the semiconductor substrate 11 as a semiconductor layer.

The light-blocking section 60 (light-blocking member) is provided on the side of the first surface 11S1 of the semiconductor substrate 11, for example. At least a portion of the light-blocking section 60 may be provided at a boundary between the plurality of pixels P adjacent to each other on the side of the first surface 11S1 of the semiconductor substrate 11. In the example illustrated in FIG. 49, the light-blocking section 60 is formed between a plurality of photoelectric conversion sections adjacent to each other (in FIG. 49, between the first photoelectric conversion section 12a and the second photoelectric conversion section 12b).

In the imaging device 1 according to the present embodiment, providing the light-blocking section 60 makes it possible to suppress leakage of light into surrounding pixels P and to suppress color mixture. It becomes possible, in the imaging device 1, to appropriately separate (disperse) incident light while reducing color mixture.

As in the example illustrated in FIG. 49, the light-blocking section 60 may be provided between a photoelectric conversion section (photoelectric conversion element) of the pixel P and a photoelectric conversion section of the surrounding pixel P on the side of the first surface 11S1 of the semiconductor substrate 11. It is to be noted that the light-blocking section 60 may be provided between the first photoelectric conversion section 12a and the second photoelectric conversion section 12b in the pixel P on the side of the first surface 11S1 of the semiconductor substrate 11.

The light-blocking section 60 is configured using, for example, a metal material that blocks light. The light-blocking section 60 may be configured by a material that absorbs light. As an example, the light-blocking section 60 may be formed using tungsten (W). The light-blocking section 60 may be formed using another material. The light-blocking section 60 may be configured by a stacked film in which a plurality of films are stacked.

At least one of the fixed charge film 31 or the antireflection film 32 may have a protrusion C1, as in the example illustrated in FIG. 49. The protrusion C1 is a projecting structure part, and can also be referred to as a projecting part. A portion of the first light-guiding member 50a (or a portion of the second light-guiding member 50b) may be provided to be adjacent to the protrusion C1 of the antireflection film 32, for example.

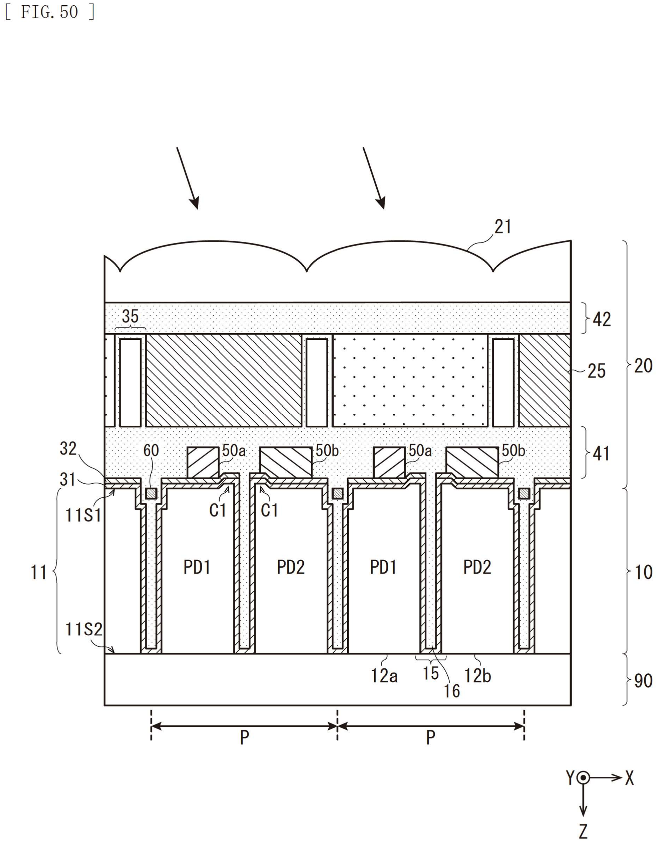

FIG. 50 illustrates an example of a cross-sectional configuration in a region where a distance from the center of the pixel section 100 (light-receiving section 10), i.e., the image height is high. In the imaging device 1, positions of the lens section 21, the color filter 25, and the like in each of the pixels P may be configured to differ depending on the image height.

The first light-guiding member 50a and the second light-guiding member 50b may have sizes different from each other. In the example illustrated in FIG. 50, among the first light-guiding member 50a and the second light-guiding member 50b, the second light-guiding member 50b at a position distant from the center of the pixel section 100 has a size that is larger than a size of the first light-guiding member 50a.

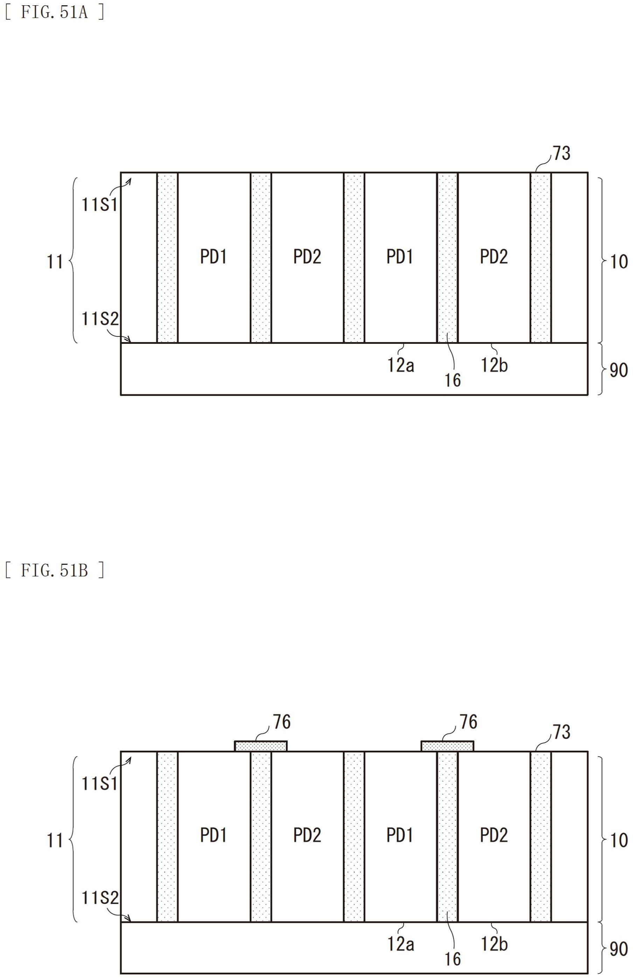

FIGs. 51A to 51N are each a diagram illustrating an example of a method of manufacturing the imaging device according to the fifth embodiment. As illustrated in FIG. 51A, a silicon oxide film 73 is formed in the trench 16 of the semiconductor substrate 11. In addition, as illustrated in FIG. 51B, a resist film 76 is formed on the semiconductor substrate 11 by lithography and etching.

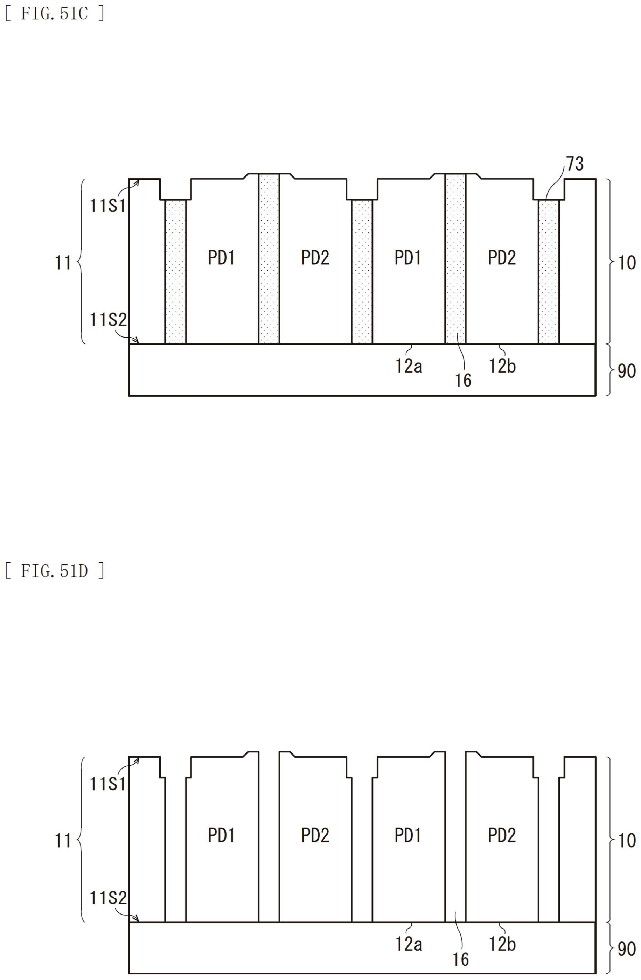

Next, as illustrated in FIG. 51C, a portion of the silicon oxide film 73 and a portion of the semiconductor substrate 11 (semiconductor layer) are partially removed by etch-back. Further, as illustrated in FIG. 51D, the silicon oxide film 73 is removed by dry etching or wet etching.

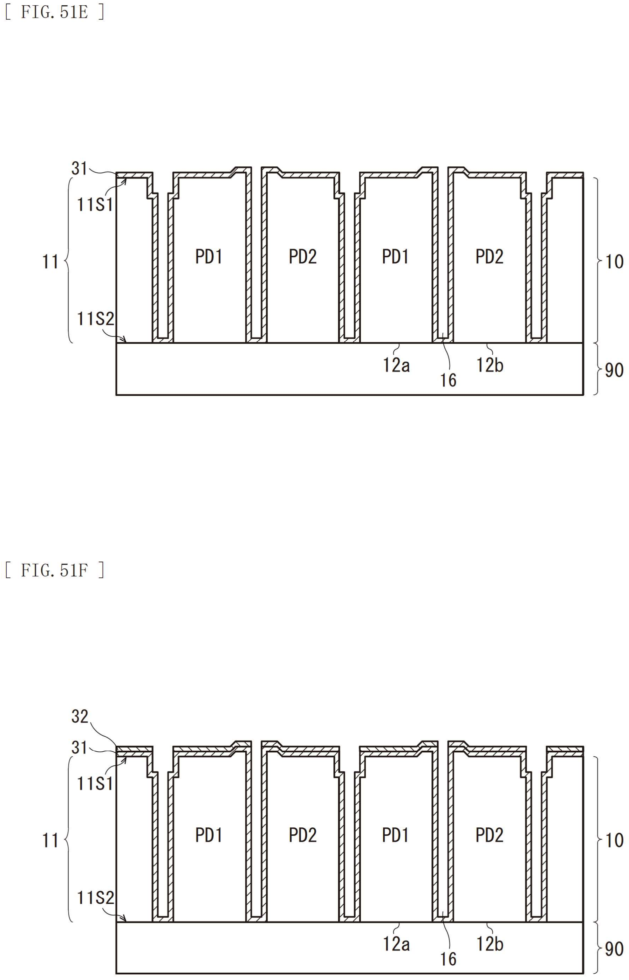

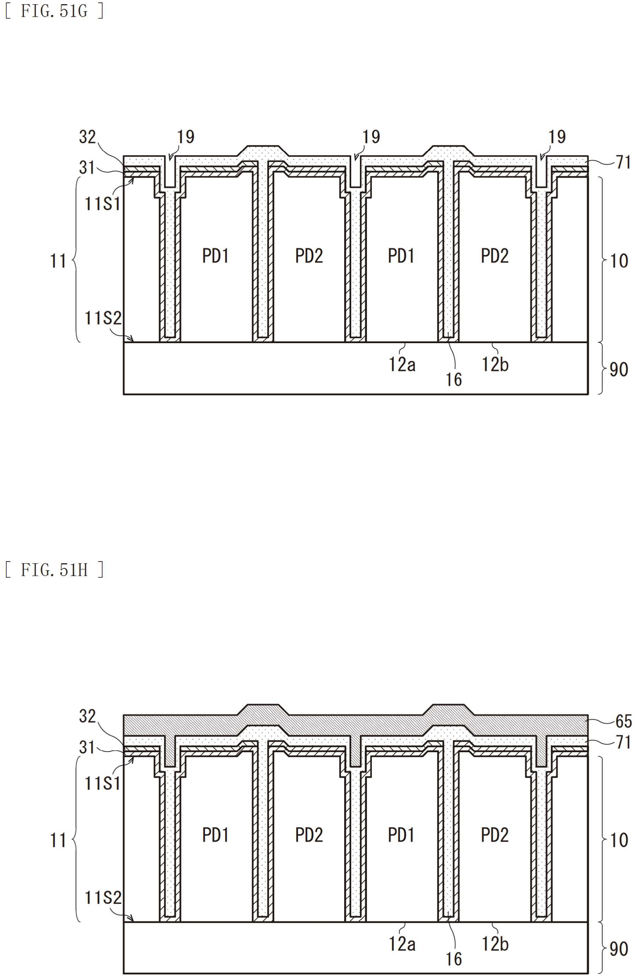

Next, as illustrated in FIG. 51E, the fixed charge film 31 is formed to follow the side surface of the trench 16 of the semiconductor substrate 11. In addition, as illustrated in FIG. 51F, the antireflection film 32 is formed on the fixed charge film 31. Then, as illustrated in FIG. 51G, the silicon oxide film 71 is formed to fill the inside of the trench 16. In this case, as illustrated in FIG. 51G, a plurality of groove parts 19 (recesses) are provided.

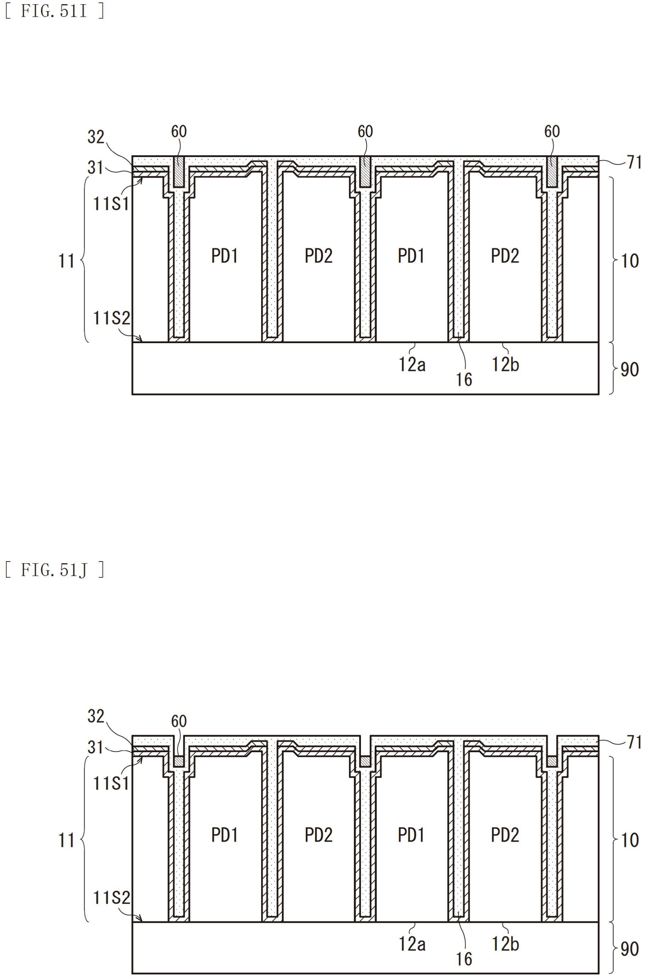

Next, as illustrated in FIG. 51H, a tungsten film 65 is formed on the silicon oxide film 71. In this case, a portion of the tungsten film 65 is provided to be embedded in the plurality of groove parts 19. Then, the tungsten film 65 is partially removed by CMP processing to thereby allow the light-blocking section 60 to be formed, as illustrated in FIG. 51I.

Next, as illustrated in FIG. 51J, a portion of the light-blocking section 60 is removed by EB (Electron Beam) to thereby reduce the height (length) of the light-blocking section 60. In the imaging device 1, reducing the height of the light-blocking section 60 makes it possible to appropriately condense light on the first photoelectric conversion section 12a and the second photoelectric conversion section 12b. Also in the case of a fine pixel, in particular, it is possible to improve light-condensing performance.

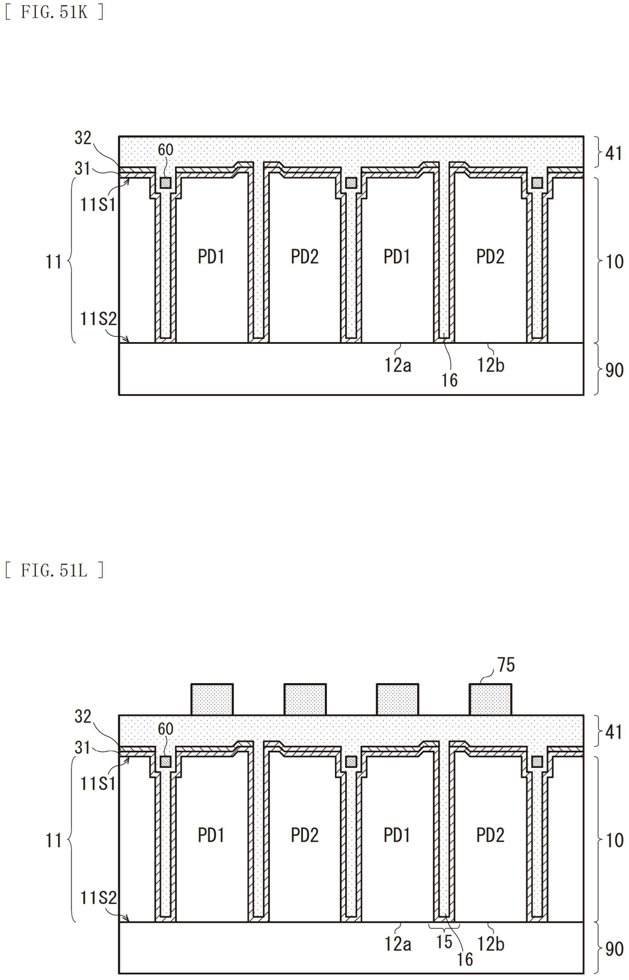

Next, as illustrated in FIG. 51K, a silicon oxide film is formed to cover the light-blocking section 60, the antireflection film 32, and the like, to thereby allow the first insulating layer 41 to be formed. Then, as illustrated in FIG. 51L, the resist film 75 is formed on the first insulating layer 41 by lithography and etching.

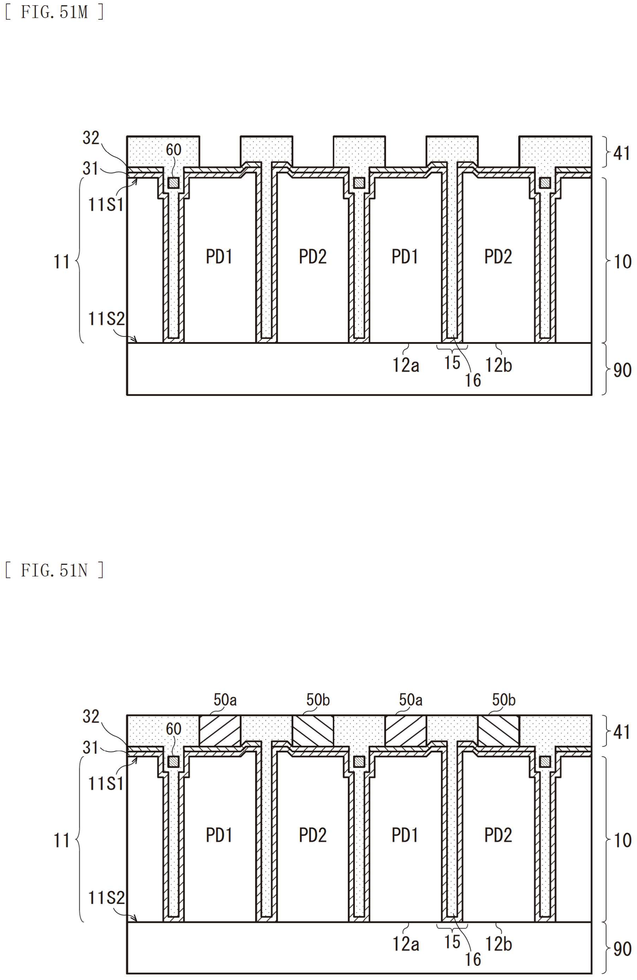

Next, as illustrated in FIG. 51M, the first insulating layer 41 is partially removed by etching. Then, as illustrated in FIG. 51N, the first light-guiding member 50a and the second light-guiding member 50b are formed. Thereafter, the color filter 25, the second insulating layer 42, the lens section 21, and the like are formed. The manufacturing method as described above enables the imaging device 1 illustrated in FIG. 49 or other drawings to be manufactured. It is to be noted that the above-described manufacturing method is merely exemplary and another manufacturing method may also be employed.

### [Workings and Effects]

The photodetector according to the present embodiment includes a plurality of pixels each including a first photoelectric conversion section (e.g., first photoelectric conversion section 12a) provided in a semiconductor layer (semiconductor substrate 11), and a first light-blocking member (light-blocking section 60) provided on a light incident side of the semiconductor layer. At least a portion of the first light-blocking member is provided at a boundary between the plurality of pixels adjacent to each other.

The photodetector (imaging device 1) according to the present embodiment is provided with the light-blocking section 60 on the side of the first surface 11S1 of the semiconductor substrate 11. It is therefore possible to cause the first light-guiding member 50a to appropriately guide incident light while suppressing color mixture. It becomes possible to achieve a photodetector that makes it possible to suppress a decrease in accuracy of photodetection.

Next, description is given of modification examples of the present disclosure. Hereinafter, components similar to those of the foregoing embodiments are denoted by the same reference numerals, and descriptions thereof are omitted as appropriate.

### (Modification Example 10)

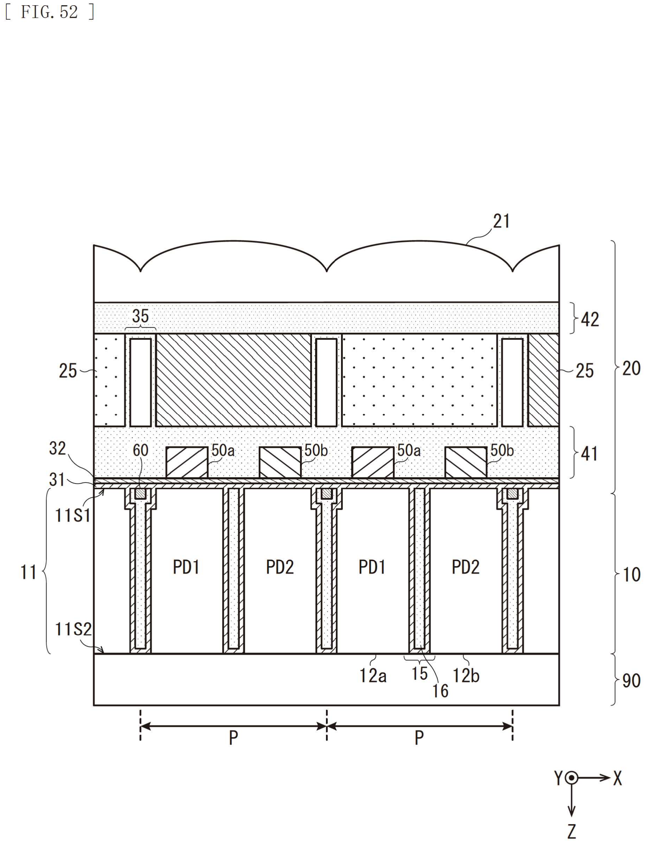

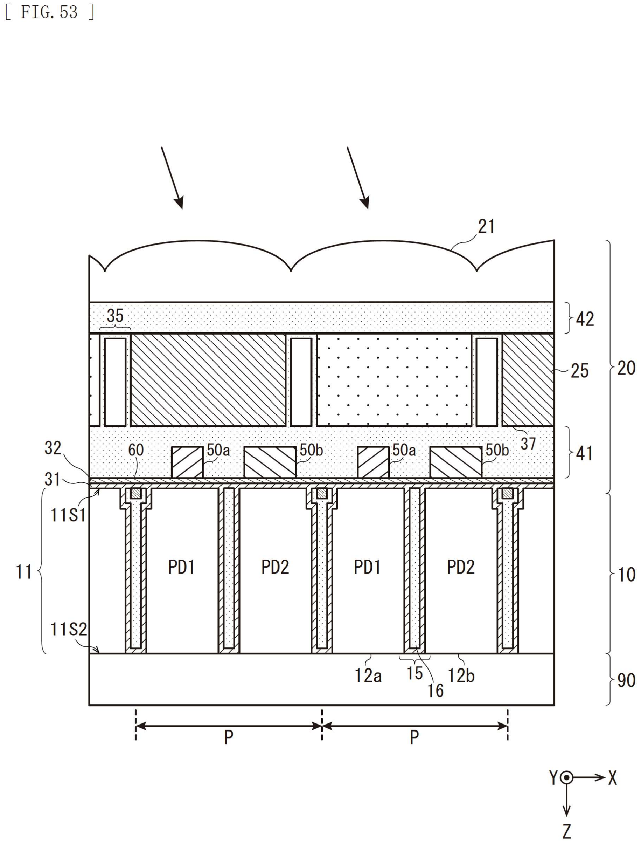

FIG. 52 is a diagram illustrating an example of a cross-sectional configuration of an imaging device according to Modification Example 10 of the present disclosure. In addition, FIG. 53 is a diagram illustrating an example of a cross-sectional configuration of the imaging device in a region where an image height is higher than that of the case of FIG. 52. As in the example illustrated in FIG. 52 or 53, the light-blocking section 60 may be provided below the antireflection film 32 and the fixed charge film 31 on the side of the first surface 11S1 of the semiconductor substrate 11. A portion of each of the fixed charge film 31 and the antireflection film 32 may be provided to cover the light-blocking section 60. Also in the case of the present modification example, it is possible to obtain effects similar to those of the foregoing embodiments.

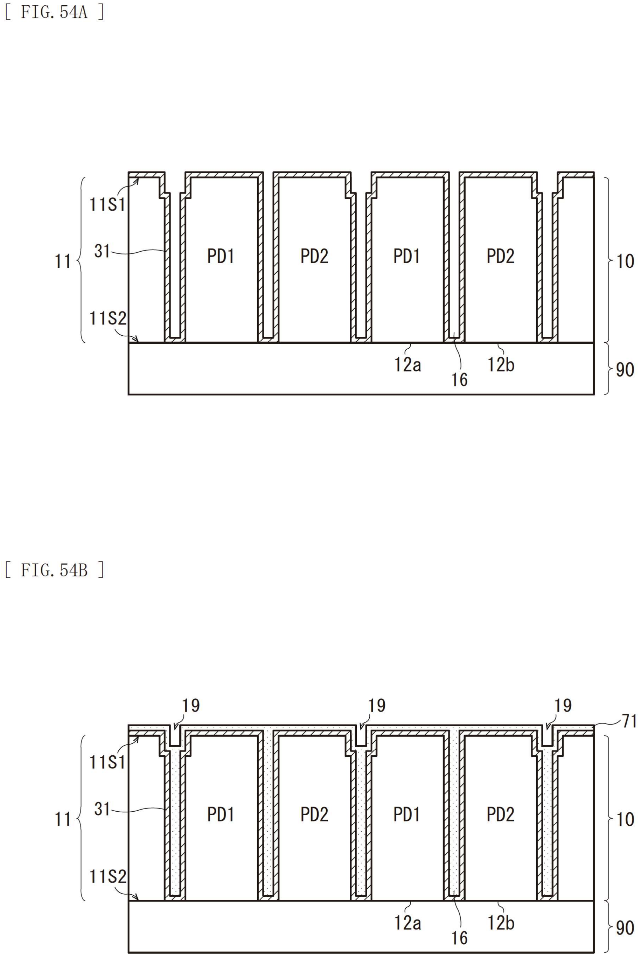

FIGs. 54A to 54I are each a diagram illustrating an example of a method of manufacturing the imaging device according to Modification Example 10. As illustrated in FIG. 54A, the fixed charge film 31 is formed to follow the side surface (sidewall) of the trench 16 of the semiconductor substrate 11. Then, as illustrated in FIG. 54B, the silicon oxide film 71 is formed to fill the inside of the trench 16, to allow the plurality of groove parts 19 to be formed.

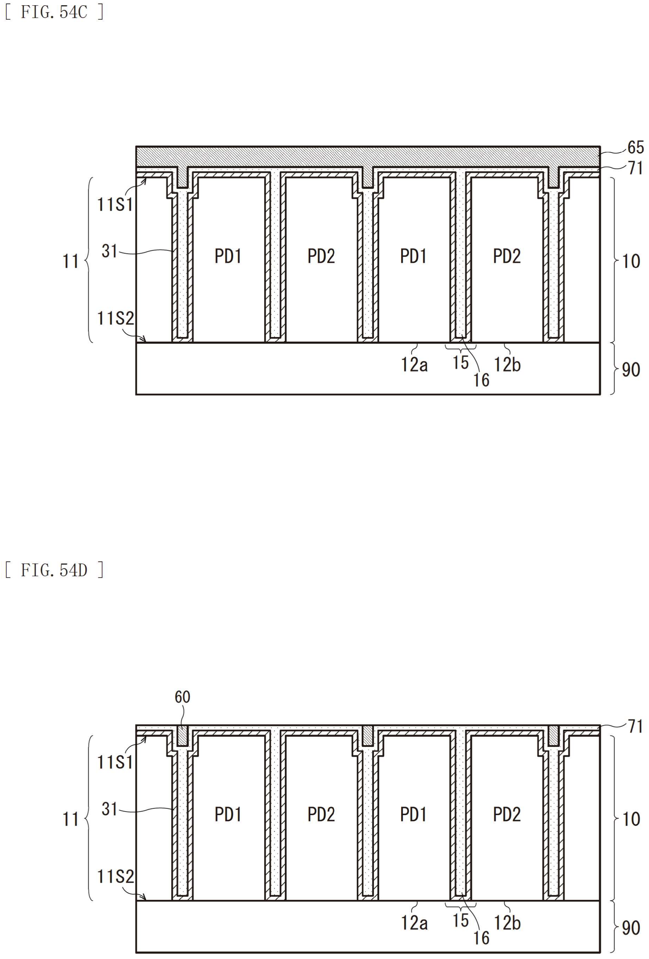

Next, as illustrated in FIG. 54C, the tungsten film 65 is formed on the silicon oxide film 71. A portion of the tungsten film 65 is formed to be embedded in the plurality of groove parts 19. Then, the tungsten film 65 is partially removed by CMP processing to thereby allow the light-blocking section 60 to be formed, as illustrated in FIG. 54D.

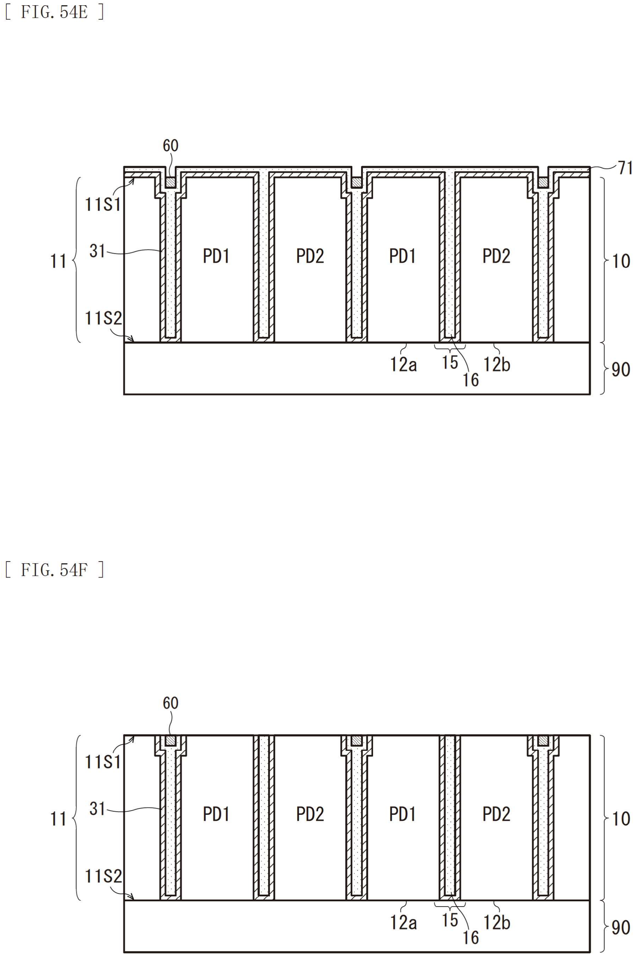

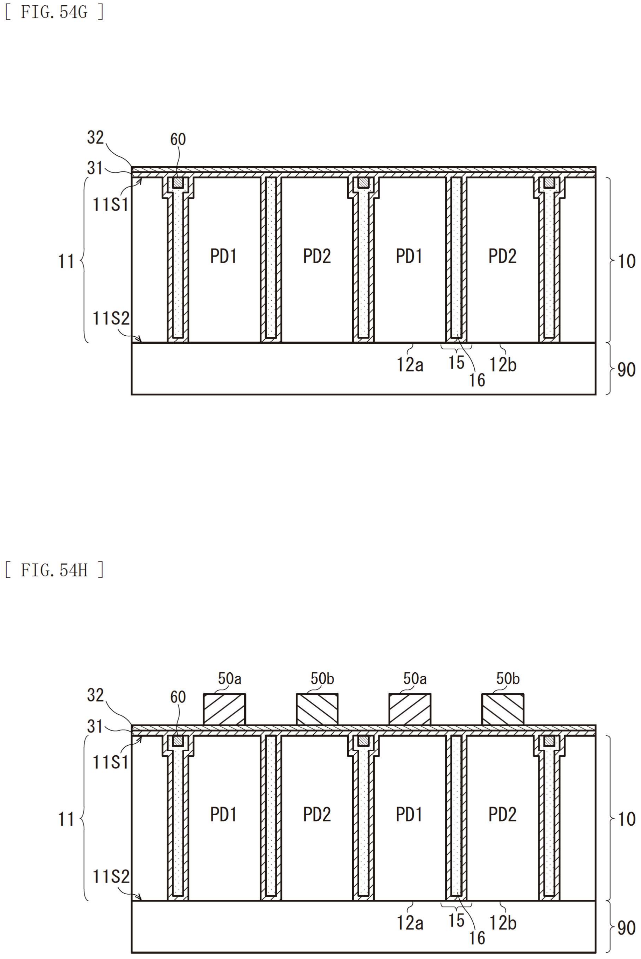

Next, as illustrated in FIG. 54E, a portion of the light-blocking section 60 is removed by EB (Electron Beam). Then, as illustrated in FIG. 54F, a portion of the silicon oxide film 71 and a portion of the fixed charge film 31 are removed by CMP processing. Further, as illustrated in FIG. 54G, the fixed charge film 31 and the antireflection film 32 are formed on the side of the first surface 11S1 of the semiconductor substrate 11.

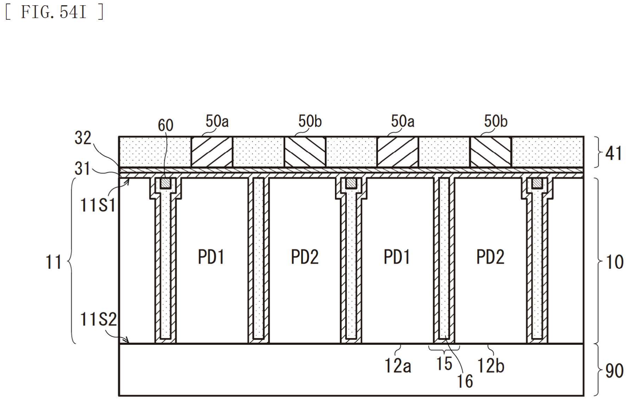

Next, as illustrated in FIG. 54H, the first light-guiding member 50a and the second light-guiding member 50b are formed. Then, as illustrated in FIG. 54I, the first insulating layer 41 is formed around the first light-guiding member 50a and the second light-guiding member 50b. Thereafter, the color filter 25, the second insulating layer 42, the lens section 21, and the like are formed. The manufacturing method as described above enables the imaging device 1 illustrated in FIG. 52 or other drawings to be manufactured.

### (Modification Example 11)

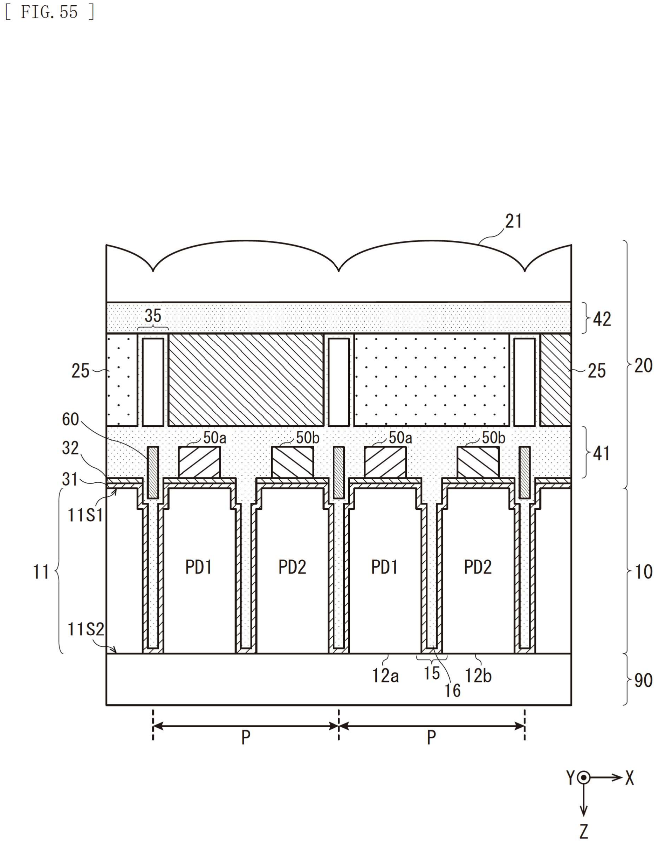

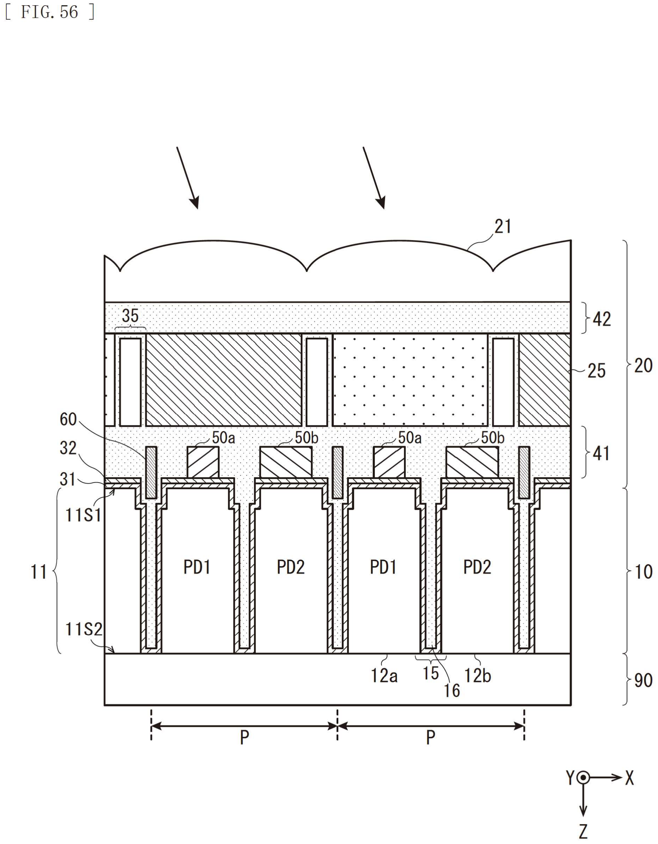

FIG. 55 is a diagram illustrating an example of a cross-sectional configuration of an imaging device according to Modification Example 11. In addition, FIG. 56 is a diagram illustrating an example of a cross-sectional configuration of the imaging device in a region where an image height is high. As in the example illustrated in FIG. 55 or 56, at least a portion of the light-blocking section 60 may be provided between the plurality of light-guiding members adjacent to each other. The light-blocking section 60 may be formed, for example, from between the first light-guiding member 50a and the second light-guiding member 50b in the first insulating layer 41 to between the first photoelectric conversion section 12a and the second photoelectric conversion section 12b.

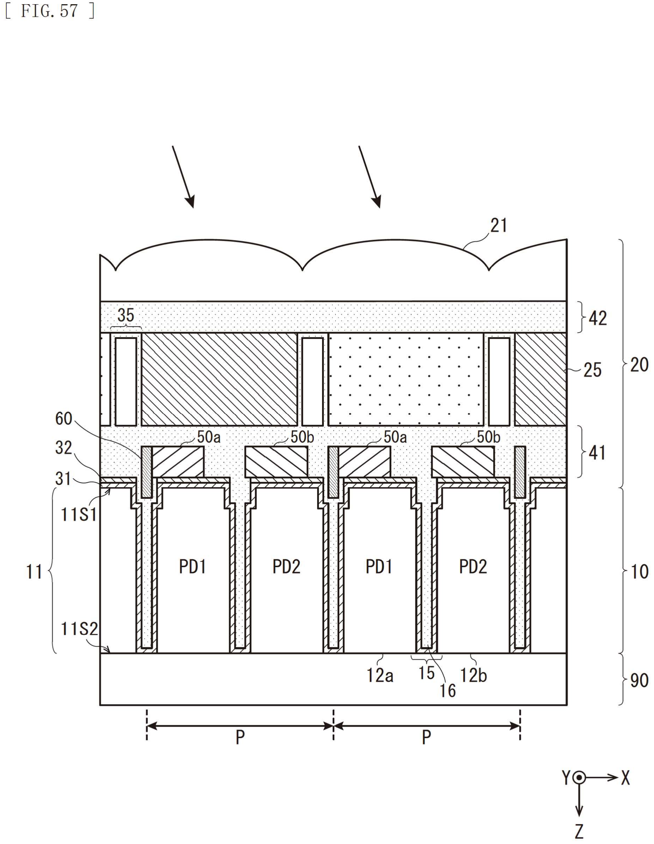

FIG. 57 is a diagram illustrating another example of the cross-sectional configuration of the imaging device in the region where the image height is high. The light-blocking section 60 may be provided to be in contact with the first light-guiding member 50a or the second light-guiding member 50b. For example, the light-blocking section 60 may be provided to be in contact with the first light-guiding member 50a at a position closer to the center of the pixel section 100, among the first light-guiding member 50a and the second light-guiding member 50b of the pixel P.

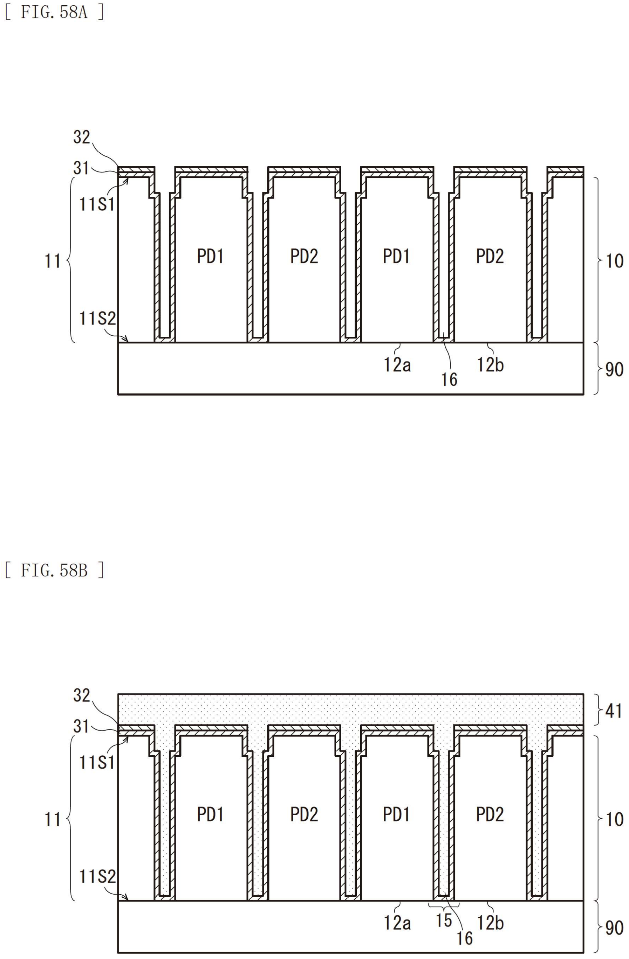

FIGs. 58A to 58H are each a diagram illustrating an example of a method of manufacturing the imaging device according to Modification Example 11. As illustrated in FIG. 58A, the fixed charge film 31 is formed to follow the side surface of the trench 16 of the semiconductor substrate 11. Then, as illustrated in FIG. 54B, a silicon oxide film is formed to fill the inside of the trench 16, to allow the first insulating layer 41 to be formed on the semiconductor substrate 11.

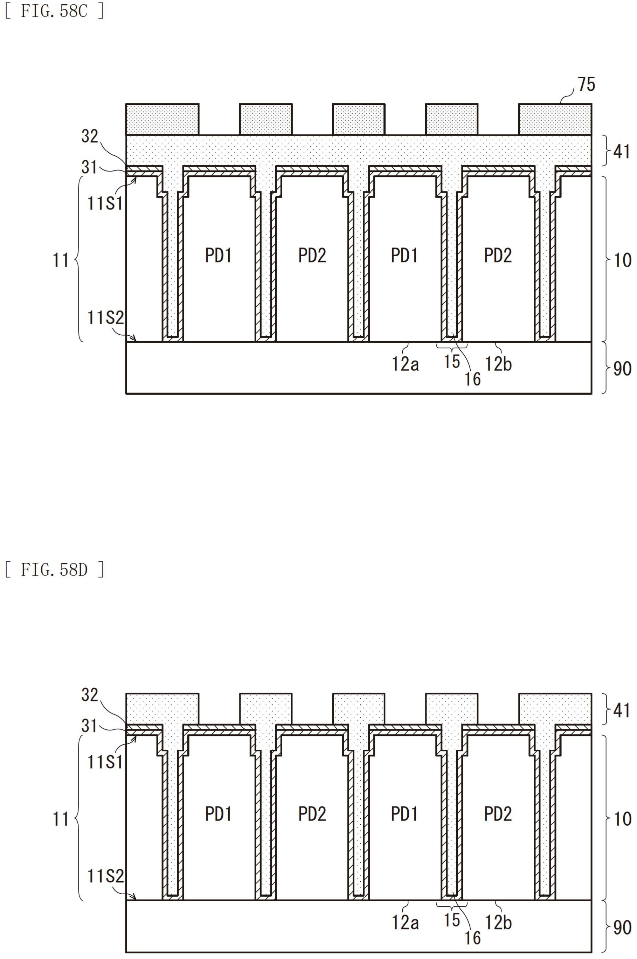

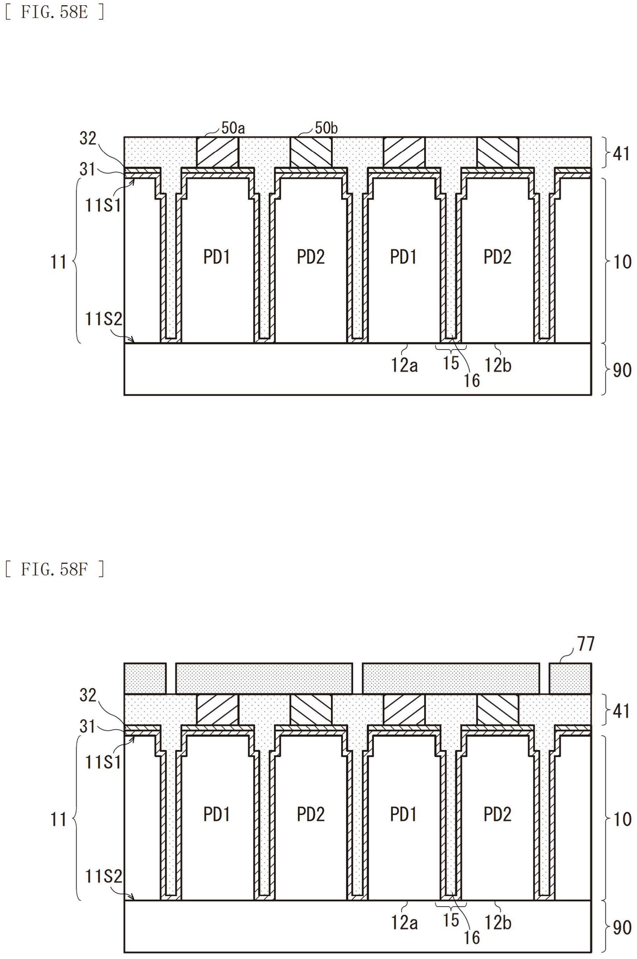

Next, as illustrated in FIG. 58C, the resist film 75 is formed on the first insulating layer 41. Then, as illustrated in FIG. 58D, the first insulating layer 41 is partially removed by etching. Further, as illustrated in FIG. 58E, the first light-guiding member 50a and the second light-guiding member 50b are formed in the first insulating layer 41.

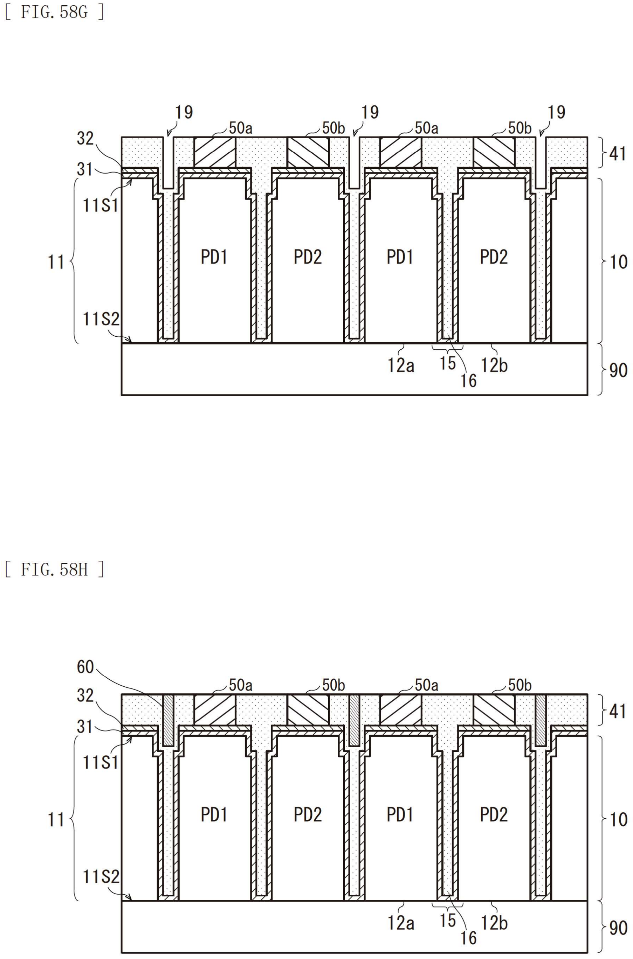

Next, as illustrated in FIG. 58F, a resist film 77 is formed on the first insulating layer 41. Then, as illustrated in FIG. 58G, the first insulating layer 41 is partially removed by etching to thereby form the plurality of groove parts 19.

Then, a tungsten film is formed to fill the plurality of groove parts 19, and thereafter the tungsten film on the first insulating layer 41 is partially removed to thereby form the light-blocking section 60, as illustrated in FIG. 58H. Thereafter, the color filter 25, the second insulating layer 42, the lens section 21, and the like are formed. The manufacturing method as described above enables the imaging device 1 illustrated in FIG. 55 or other drawings to be manufactured.

### (Modification Example 12)

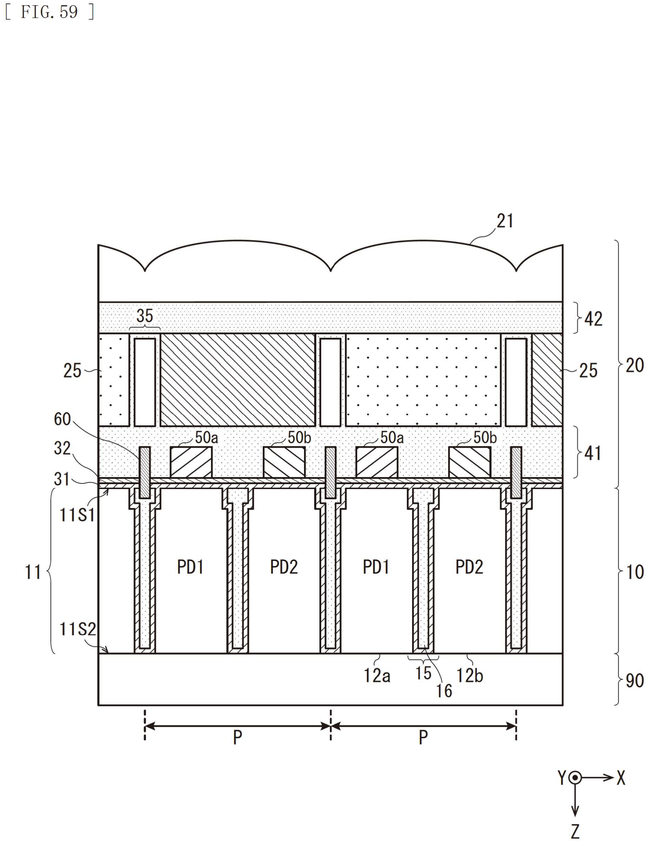

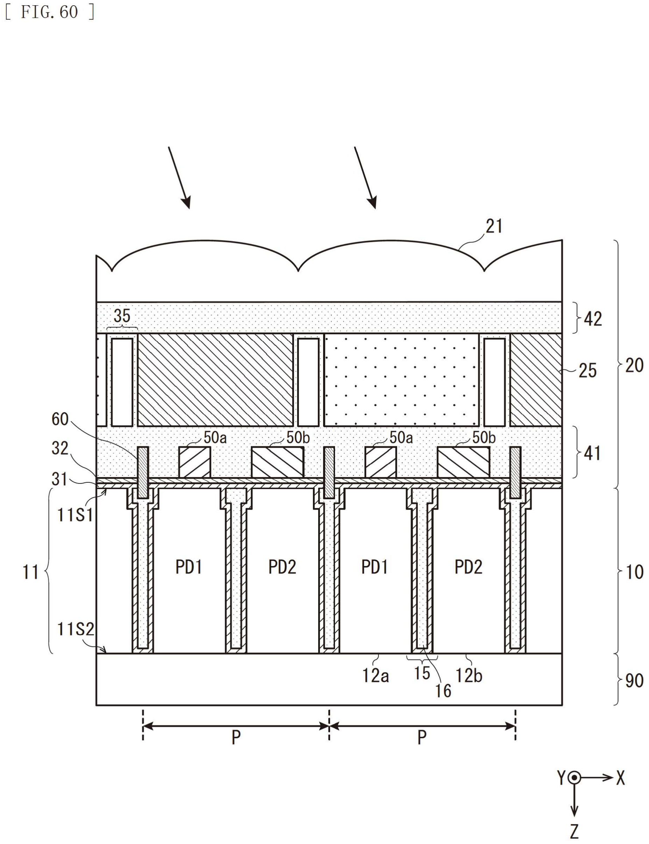

FIG. 59 is a diagram illustrating an example of a cross-sectional configuration of an imaging device according to Modification Example 12. FIG. 60 is a diagram illustrating an example of a cross-sectional configuration of the imaging device in a region where an image height is higher than that of the case of FIG. 59. The light-blocking section 60 may be provided to penetrate the fixed charge film 31 and the antireflection film 32, as in the example illustrated in FIG. 59 or 60. In the example illustrated in FIGs. 55 and 56, a portion of each of the fixed charge film 31 and the antireflection film 32 is provided in contact with the light-blocking section 60.

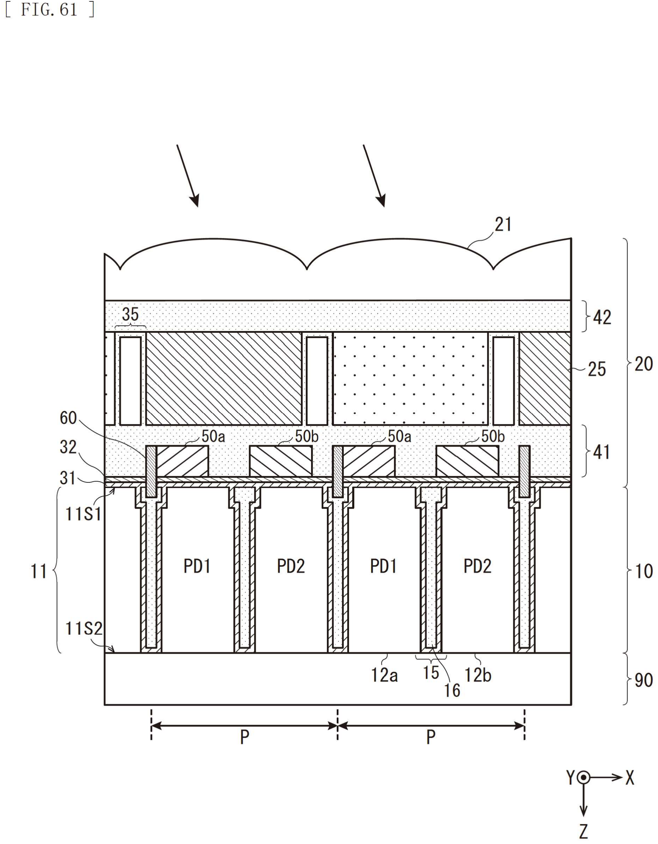

FIG. 61 is a diagram illustrating another example of the cross-sectional configuration of the imaging device in the region where the image height is high. The light-blocking section 60 may be provided to be in contact with the first light-guiding member 50a or the second light-guiding member 50b. In the example illustrated in FIG. 61, the light-blocking section 60 may be disposed in contact with the first light-guiding member 50a at a position closer to the center of the pixel section 100, among the first light-guiding member 50a and the second light-guiding member 50b of the pixel P.

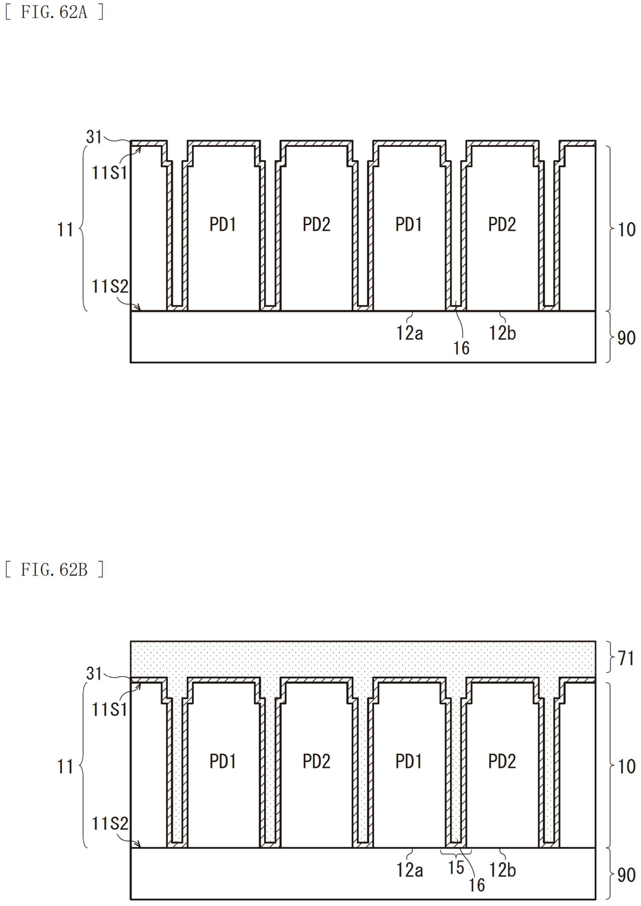

FIGs. 62A to 62J are each a diagram illustrating an example of a method of manufacturing the imaging device according to Modification Example 12. As illustrated in FIG. 62A, the fixed charge film 31 is formed to follow the side surface of the trench 16 of the semiconductor substrate 11. Then, as illustrated in FIG. 62B, the silicon oxide film 71 is formed to fill the inside of the trench 16.

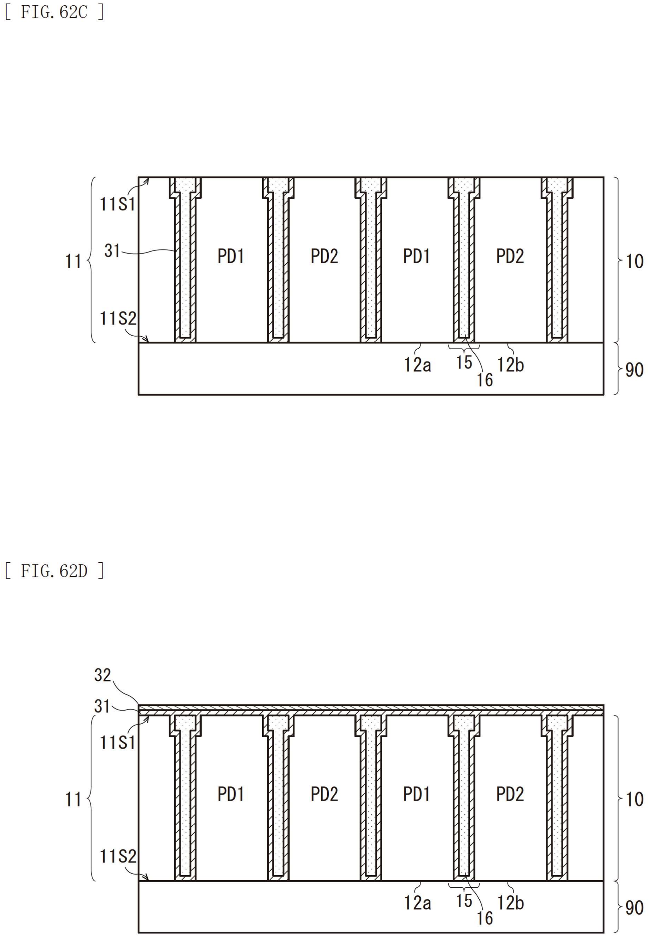

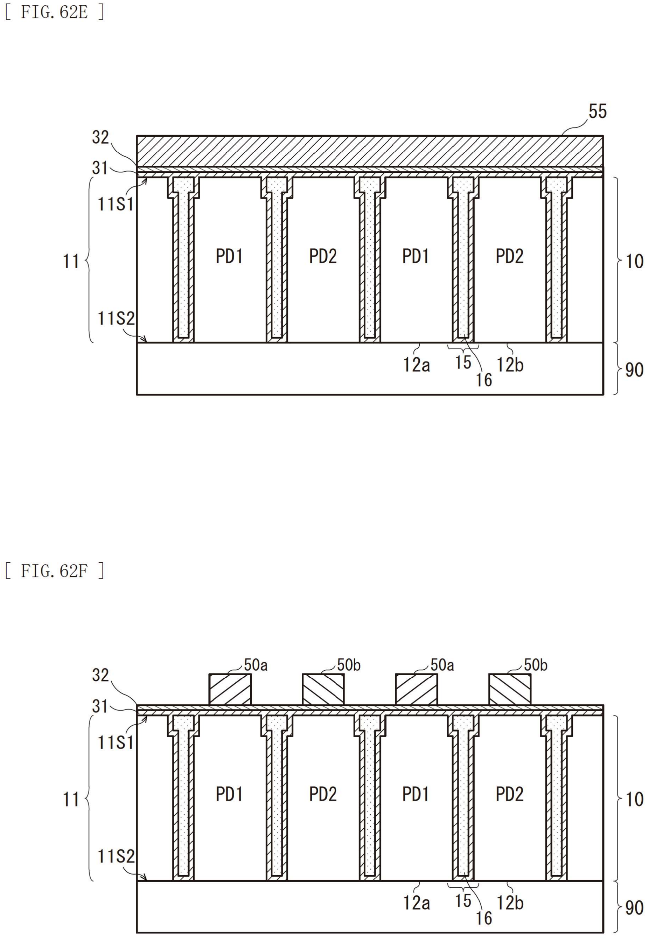

Next, as illustrated in FIG. 62C, a portion of the silicon oxide film 71 and a portion of the fixed charge film 31 are removed by CMP processing. Then, as illustrated in FIG. 62D, the fixed charge film 31 and the antireflection film 32 are formed. In addition, as illustrated in FIG. 62E, the high refractive index section 55 (e.g., a silicon nitride film) including a high refractive material is formed on the antireflection film 32.

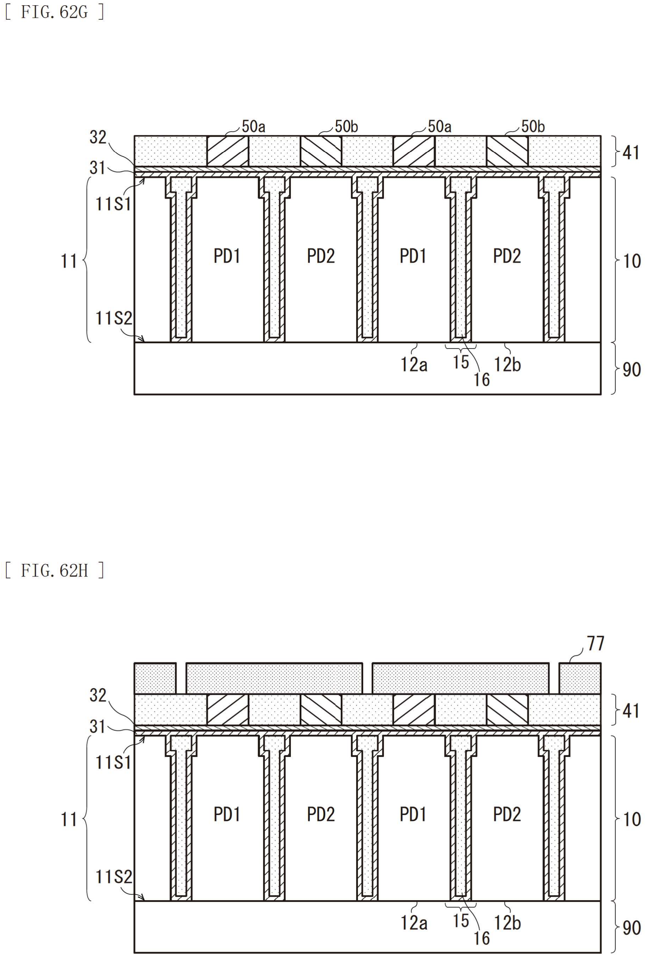

Next, the high refractive index section 55 is partially removed by etching to thereby form the first light-guiding member 50a and the second light-guiding member 50b, as illustrated in FIG. 62F. Then, as illustrated in FIG. 62G, a silicon oxide film is formed around the first light-guiding member 50a and the second light-guiding member 50b, to allow the first insulating layer 41 to be formed.

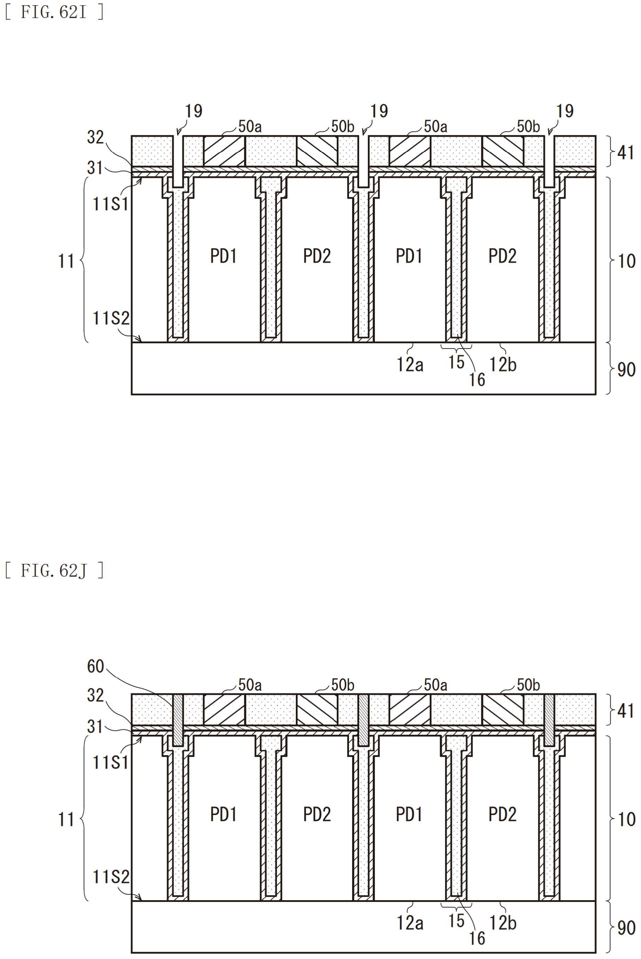

Next, as illustrated in FIG. 62H, the resist film 77 is formed on the first insulating layer 41. Then, as illustrated in FIG. 62I, the first insulating layer 41 is partially removed by etching to thereby form the plurality of groove parts 19.

Then, a tungsten film is formed to fill the plurality of groove parts 19, and thereafter the tungsten film on the first insulating layer 41 is partially removed to thereby form the light-blocking section 60, as illustrated in FIG. 62J. Thereafter, the color filter 25, the second insulating layer 42, the lens section 21, and the like are formed. The manufacturing method as described above enables the imaging device 1 illustrated in FIG. 59 or other drawings to be manufactured. It is to be noted that the above-described manufacturing method is merely exemplary and another manufacturing method may also be employed.

### <7. Sixth Embodiment>

Next, description is given of a sixth embodiment of the present disclosure. Hereinafter, components similar to those of the foregoing embodiments are denoted by the same reference numerals, and descriptions thereof are omitted as appropriate.

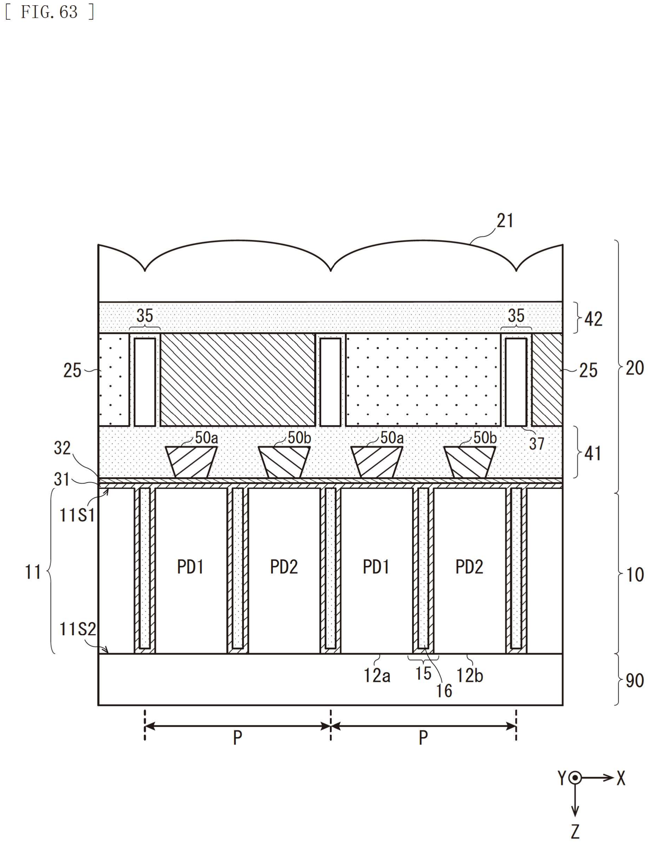

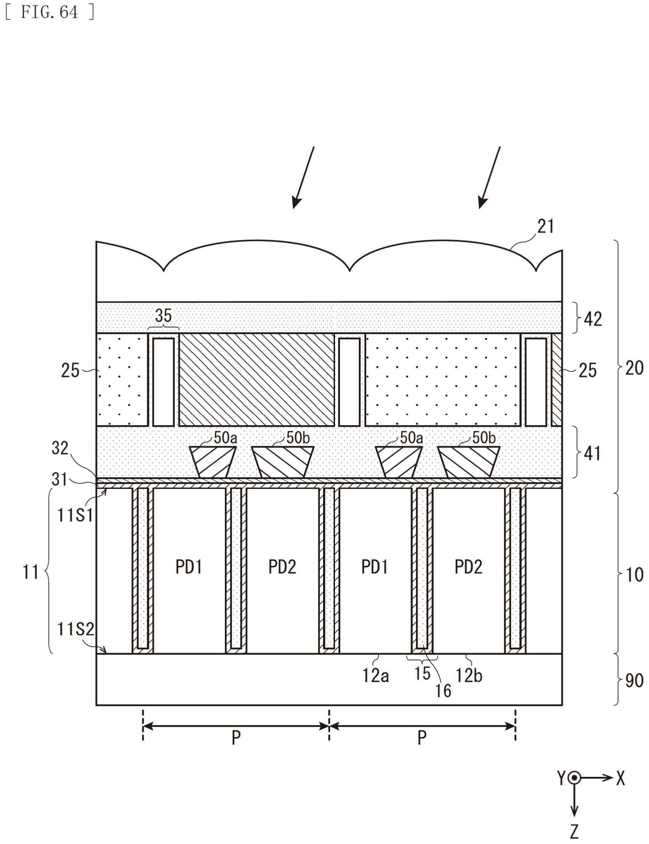

FIG. 63 is a diagram illustrating an example of a cross-sectional configuration of an imaging device according to the sixth embodiment of the present disclosure. In addition, FIG. 64 is a diagram illustrating an example of a cross-sectional configuration of the imaging device in a region where an image height is higher than that of the case of FIG. 63. The first light-guiding member 50a may be provided to allow a width of the first light-guiding member 50a on a side opposite to the side of the first photoelectric conversion section 12a (or a side of the semiconductor substrate 11) (i.e., the width of the first light-guiding member 50a on a light incident side) to be larger than a width of the first light-guiding member 50a on the side of the first photoelectric conversion section 12a.

In the imaging device 1, for example, the first light-guiding member 50a may be formed to allow a width of an upper end (top) of the first light-guiding member 50a to be larger (thicker) than a width of a lower end (bottom) of the first light-guiding member 50a. For example, the first light-guiding member 50a is tapered (has an inclined part), and has an inversely tapered shape.

The width (length) of the first light-guiding member 50a in the X-axis direction (or the Y-axis direction) becomes larger, for example, as being more distant from the first photoelectric conversion section 12a. It can also be said that the width of the first light-guiding member 50a in the X-axis direction (or the Y-axis direction) becomes smaller as being closer to the first photoelectric conversion section 12a (or the semiconductor substrate 11).

In addition, the second light-guiding member 50b may be provided to allow a width of the second light-guiding member 50b on a side opposite to the side of the second photoelectric conversion section 12b (or the side of the semiconductor substrate 11) (i.e., the width of the second light-guiding member 50b on the light incident side) to be larger than a width of the second light-guiding member 50b on the side of the second photoelectric conversion section 12b.

In the imaging device 1, for example, the second light-guiding member 50b may be formed to allow a width of an upper end (top) of the second light-guiding member 50b to be larger than a width of a lower end (bottom) of the second light-guiding member 50b. For example, the second light-guiding member 50b may have an inversely tapered shape.

The width of the second light-guiding member 50b in the X-axis direction (or the Y-axis direction) becomes larger, for example, as being more distant from the second photoelectric conversion section 12b. It can also be said that the width of the second light-guiding member 50b in the X-axis direction (or the Y-axis direction) becomes smaller as being closer to the second photoelectric conversion section 12b (or the semiconductor substrate 11).

The imaging device 1 according to the present embodiment includes the first light-guiding member 50a and the second light-guiding member 50b configured as described above. It is therefore possible for the first light-guiding member 50a and the second light-guiding member 50b to appropriately guide light to the first photoelectric conversion section 12a and the second photoelectric conversion section 12b. It is also possible for the first light-guiding member 50a (or the second light-guiding member 50b) having an inversely tapered shape, for example, to condense, on the first photoelectric conversion section 12a (or the second photoelectric conversion section 12b), light traveling from the lens section 21 toward the separation section 15 between the first photoelectric conversion section 12a and the second photoelectric conversion section 12b.

Thus, it is possible, in the imaging device 1 according to the present embodiment, to efficiently guide light to the first photoelectric conversion section 12a and the second photoelectric conversion section 12b, thus making it possible to improve quantum efficiency (QE). It is possible to appropriately separate (disperse) light from a subject as a measurement target and guide the light to a photoelectric conversion section of each of the pixels P. It is therefore possible to suppress a decrease in accuracy of phase difference detection and thus to prevent a decrease in AF performance.

### [Workings and Effects]

The photodetector according to the present embodiment includes a first light-guiding member (first light-guiding member 50a) provided above a first photoelectric conversion section (first photoelectric conversion section 12a) and having a refractive index higher than a refractive index of an adjacent medium. A width of the first light-guiding member on a side opposite to a side of the first photoelectric conversion section is larger than a width of the first light-guiding member on the side of the first photoelectric conversion section.

In the photodetector (imaging device 1) according to the present embodiment, the width of the first light-guiding member 50a on the side opposite to the side of the first photoelectric conversion section 12a is larger than the width of the first light-guiding member 50a on the side of the first photoelectric conversion section 12a. It is therefore possible for the first light-guiding member 50a to efficiently guide incident light. It becomes possible to achieve a photodetector that makes it possible to suppress a decrease in accuracy of photodetection.

Next, description is given of modification examples of the present disclosure. Hereinafter, components similar to those of the foregoing embodiments are denoted by the same reference numerals, and descriptions thereof are omitted as appropriate.

### (Modification Example 13)

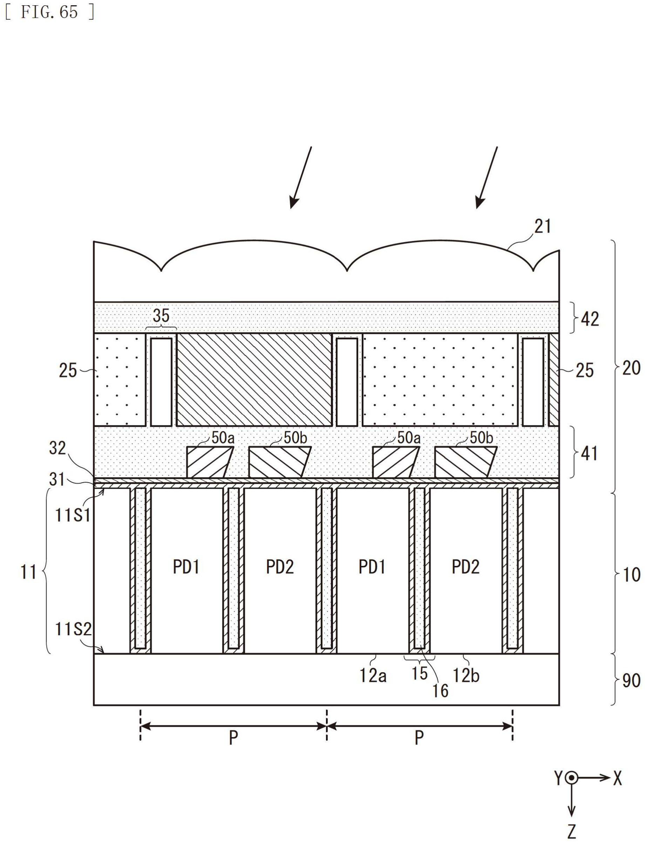

FIG. 65 is a diagram illustrating an example of a cross-sectional configuration of an imaging device according to Modification Example 13 of the present disclosure. As in the example illustrated in FIG. 65, the first light-guiding member 50a may be configured to allow one of a left end or a right end of the first light-guiding member 50a to be tapered (has an inclined part). In addition, the second light-guiding member 50b may be configured to allow one of a left end or a right end of the second light-guiding member 50b to be tapered. The first light-guiding member 50a and the second light-guiding member 50b may each have, for example, a left-right asymmetric shape.

### (Modification Example 14)

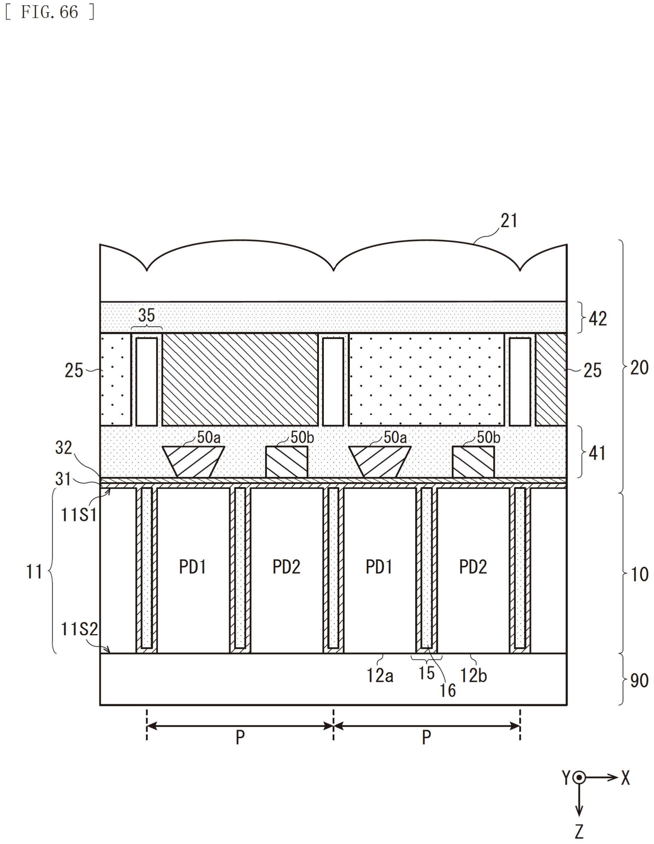

FIG. 66 is a diagram illustrating an example of a cross-sectional configuration of an imaging device according to Modification Example 14. The imaging device 1 may be configured to allow one of the first light-guiding member 50a or the second light-guiding member 50b to be tapered. For example, in the example illustrated in FIG. 66, the first light-guiding member 50a has an inversely tapered shape. The second light-guiding member 50b has a shape of cuboid or cube, for example.

### (Modification Example 15)

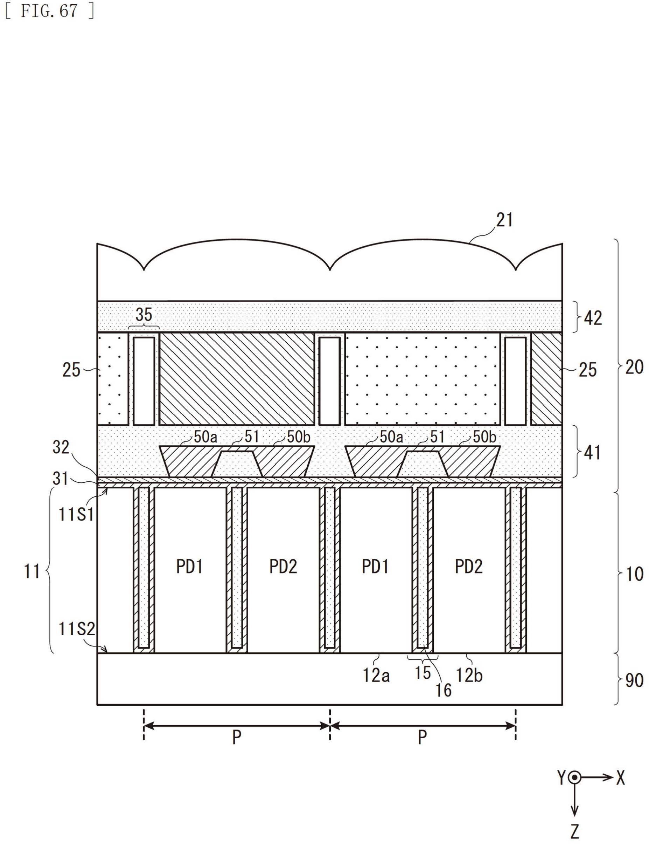

FIG. 67 is a diagram illustrating an example of a cross-sectional configuration of an imaging device according to Modification Example 15. A portion of the first light-guiding member 50a and a portion of the second light-guiding member 50b may be coupled to each other. As in the example illustrated in FIG. 67, for example, the imaging device 1 may include a coupling section 51 (which can also be referred to as a lid part) that couples the first light-guiding member 50a and the second light-guiding member 50b to each other. The coupling section 51 is configured by, for example, the same material as that of the first light-guiding member 50a and the second light-guiding member 50b.

### (Modification Example 16)

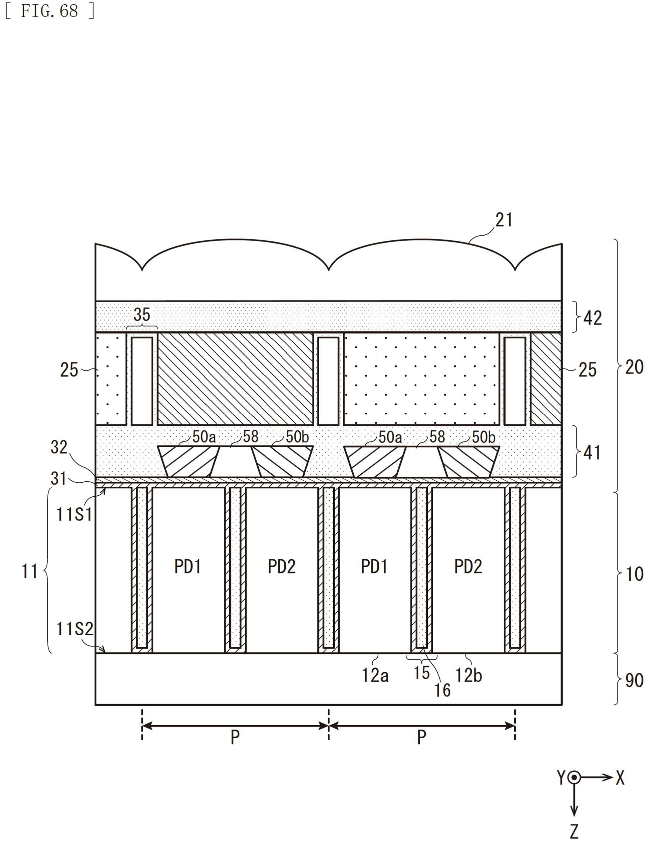

FIG. 68 is a diagram illustrating an example of a cross-sectional configuration of an imaging device according to Modification Example 16. In the imaging device 1, a low refractive index section 58 configured by a low refractive index material may be provided around the first light-guiding member 50a (or the second light-guiding member 50b). For example, in the example illustrated in FIG. 68, the imaging device 1 includes the low refractive index section 58 provided between the first light-guiding member 50a and the second light-guiding member 50b of the pixel P. As an example, the low refractive index section 58 (low refractive index member) may be an air gap (cavity).

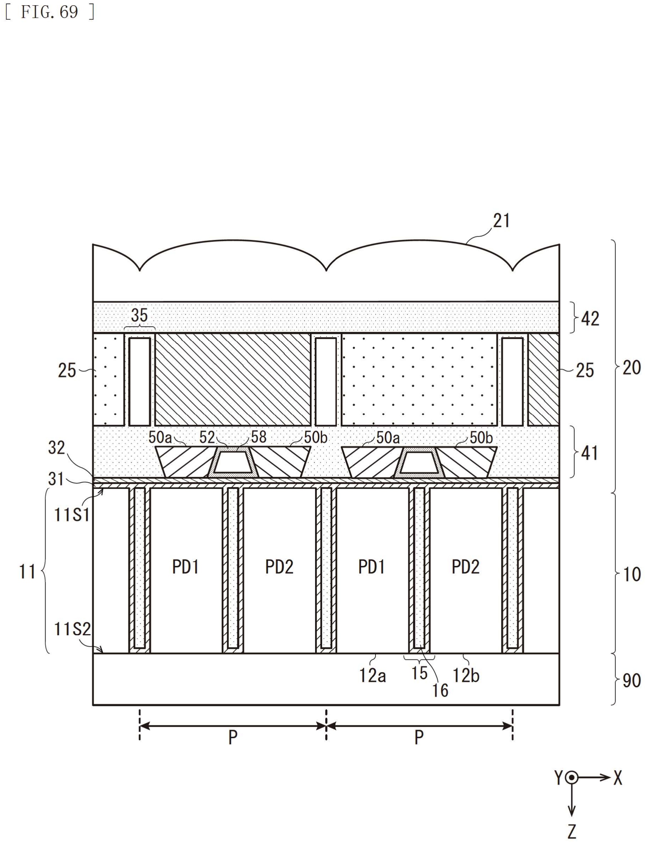

FIGs. 69 to 71 are each a diagram illustrating another example of the cross-sectional configuration of the imaging device according to Modification Example 16. As in the example illustrated in FIG. 69, the imaging device 1 may include an insulating member 52. The insulating member 52 is provided to cover a perimeter of the low refractive index section 58, for example, and can also be referred to as a partition wall part. The low refractive index section 58 may be formed to be embedded in the insulating member 52.

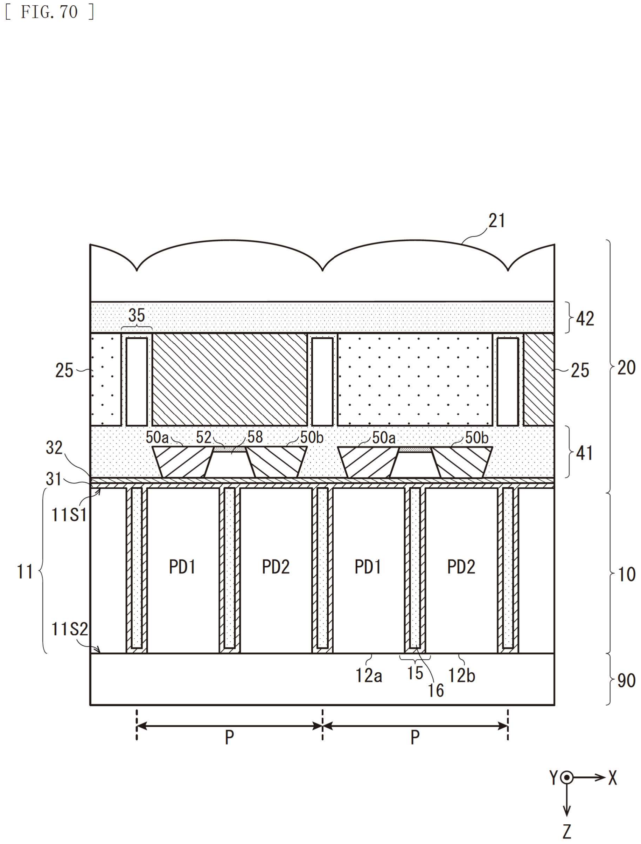

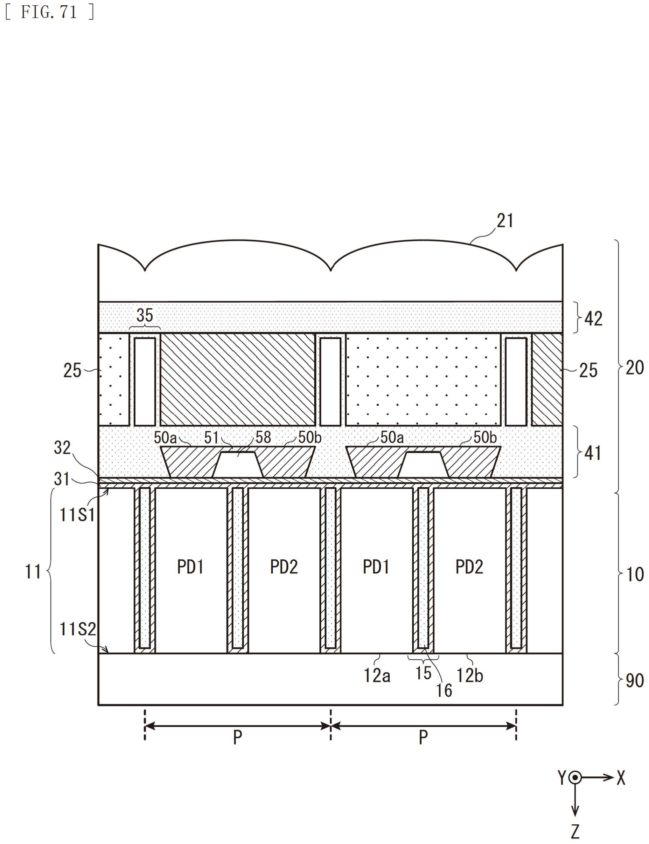

As in the example illustrated in FIG. 70, the insulating member 52 may be provided only on an upper side of the low refractive index section 58. In the example illustrated in FIG. 70, the insulating member 52 is disposed to cover an upper part of the low refractive index section 58. In addition, as in the example illustrated in FIG. 71, the imaging device 1 may include the coupling section 51 (lid part) and the low refractive index section 58.

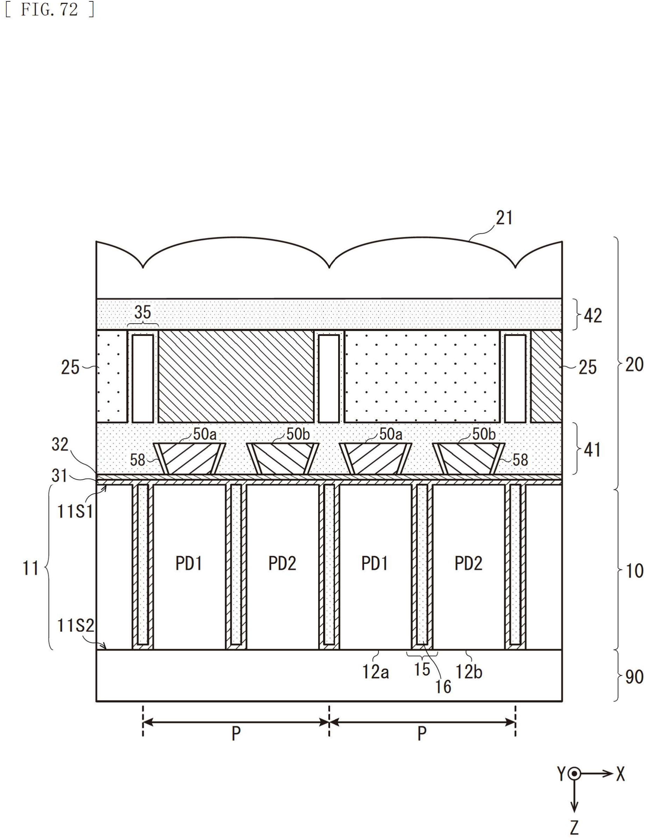

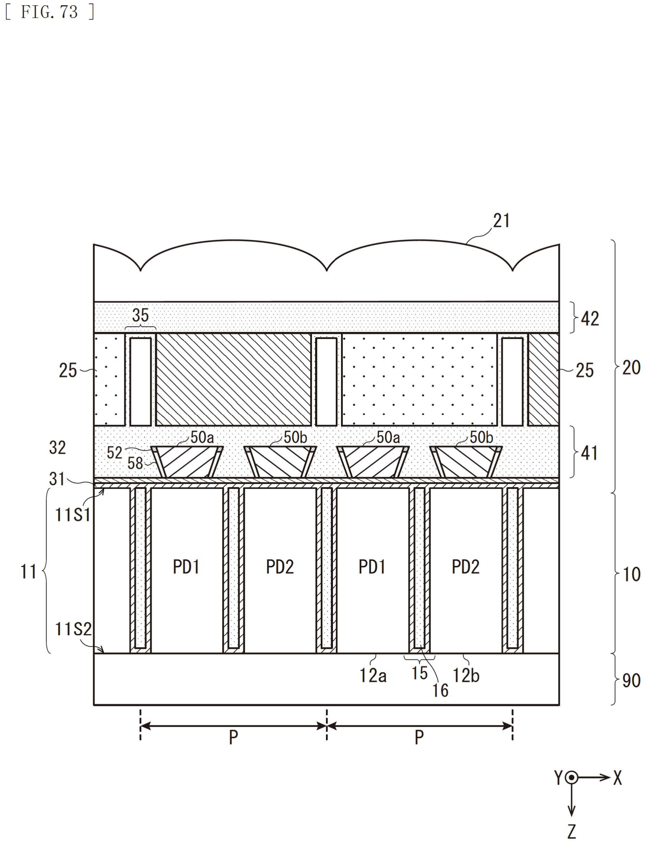

FIGs. 72 and 73 are each a diagram illustrating another example of the cross-sectional configuration of the imaging device according to Modification Example 16. As in the example illustrated in FIG. 72, the low refractive index section 58 (low refractive index member) may be provided on a side surface (side part) of the first light-guiding member 50a (or the second light-guiding member 50b). In addition, as in the example illustrated in FIG. 73, the imaging device 1 may include the insulating member 52 as a lid part on the upper side of the low refractive index section 58.

### (Modification Example 17)

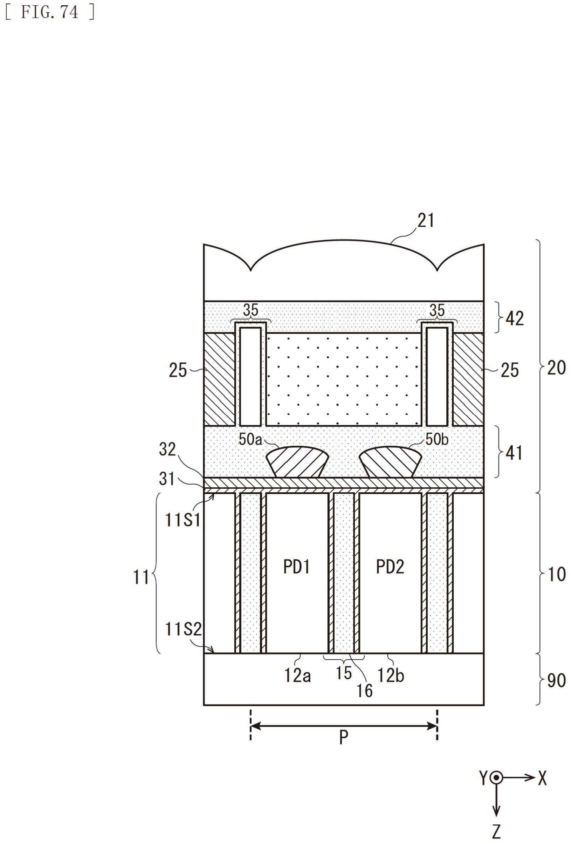

FIG. 74 is a diagram illustrating an example of a cross-sectional configuration of an imaging device according to Modification Example 17. In the foregoing embodiments and modification examples, the description has been given of the configuration examples of the light-guiding member. However, the configuration of the light-guiding member (the first light-guiding member 50a, the second light-guiding member 50b, etc.) is not limited to the above-described examples. The first light-guiding member 50a and the second light-guiding member 50b may have a convex shape, for example, as in the example illustrated in FIG. 74. The first light-guiding member 50a and the second light-guiding member 50b may each have a convex lens shape.

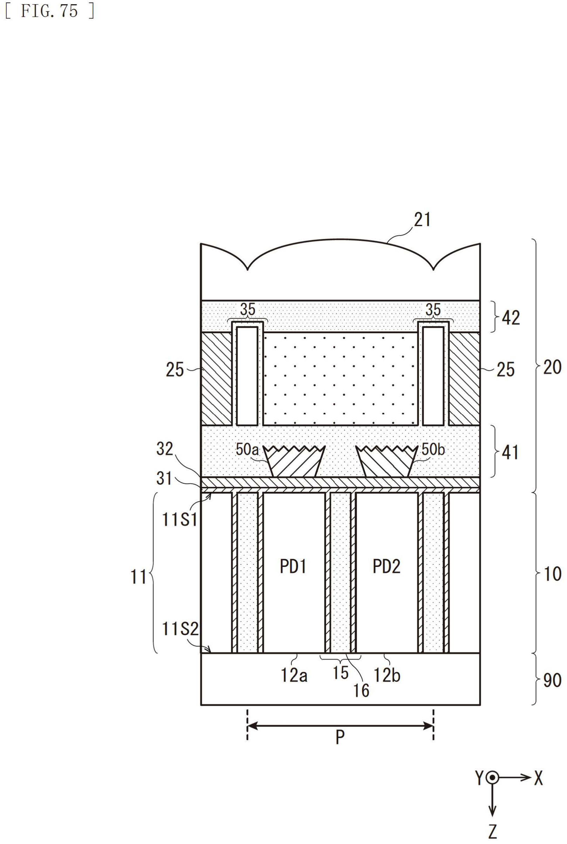

FIG. 75 is a diagram illustrating another example of the cross-sectional configuration of the imaging device according to Modification Example 17. As in the example illustrated in FIG. 75, the first light-guiding member 50a and the second light-guiding member 50b may have a shape including fine unevenness. The first light-guiding member 50a and the second light-guiding member 50b may each have a moth-eye structure as an antireflection structure.

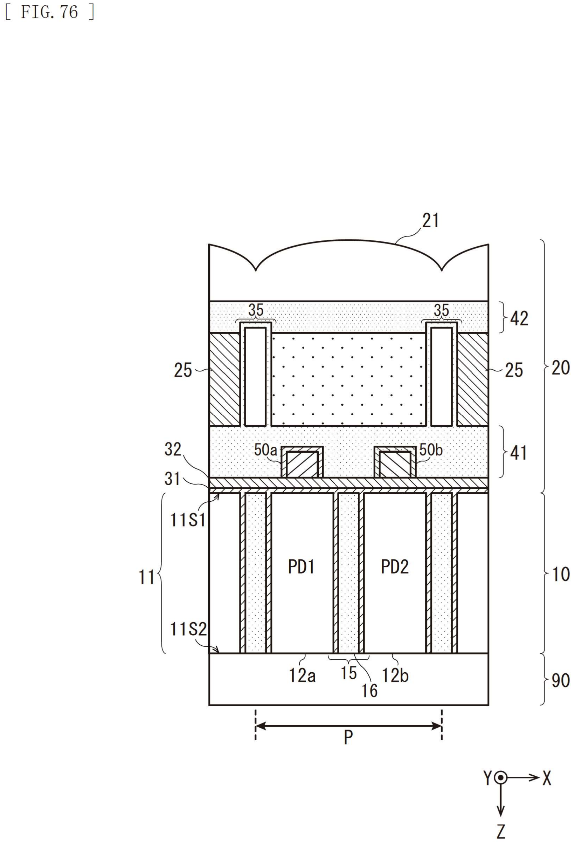

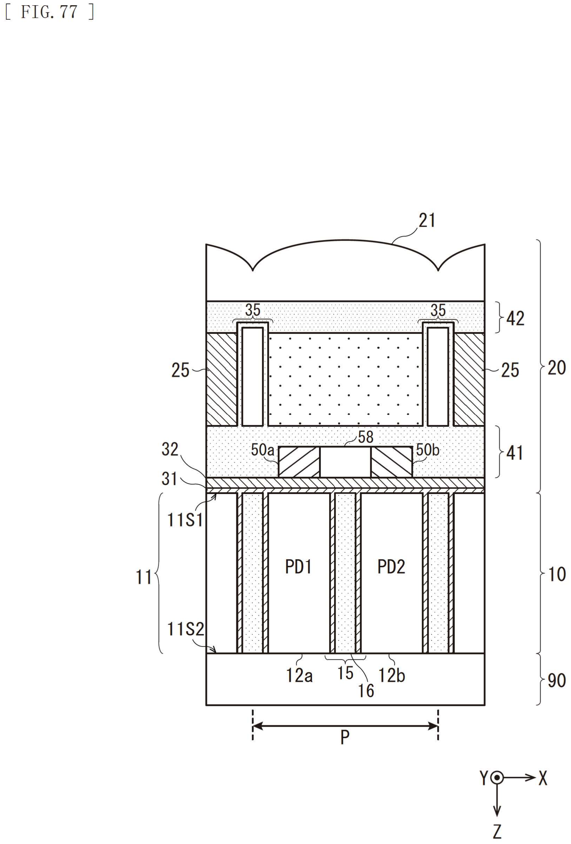

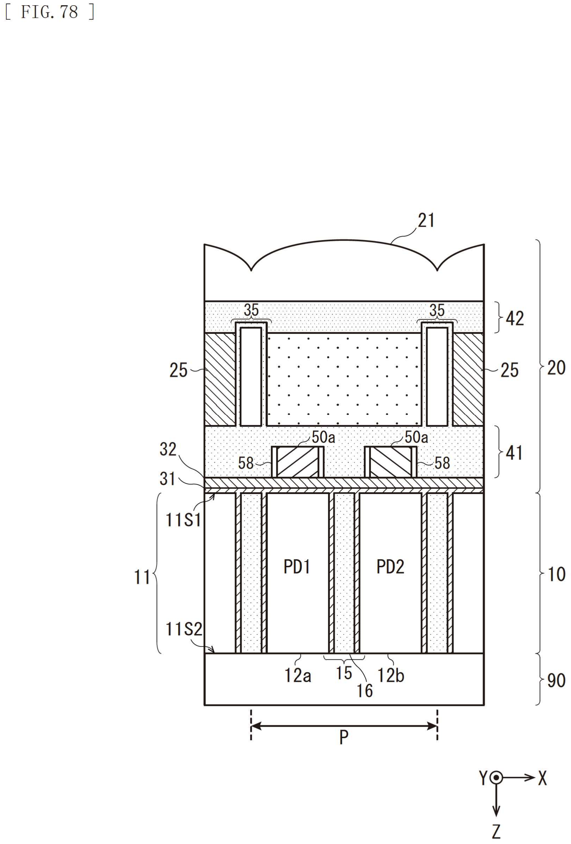

FIGs. 76 to 79 are each a diagram illustrating another example of the cross-sectional configuration of the imaging device according to Modification Example 17. As in the example illustrated in FIG. 76, the first light-guiding member 50a and the second light-guiding member 50b may each be configured by a stacked film in which a plurality of films are stacked. In addition, as in the example illustrated in FIG. 77 or 78, the imaging device 1 may include the low refractive index section 58.

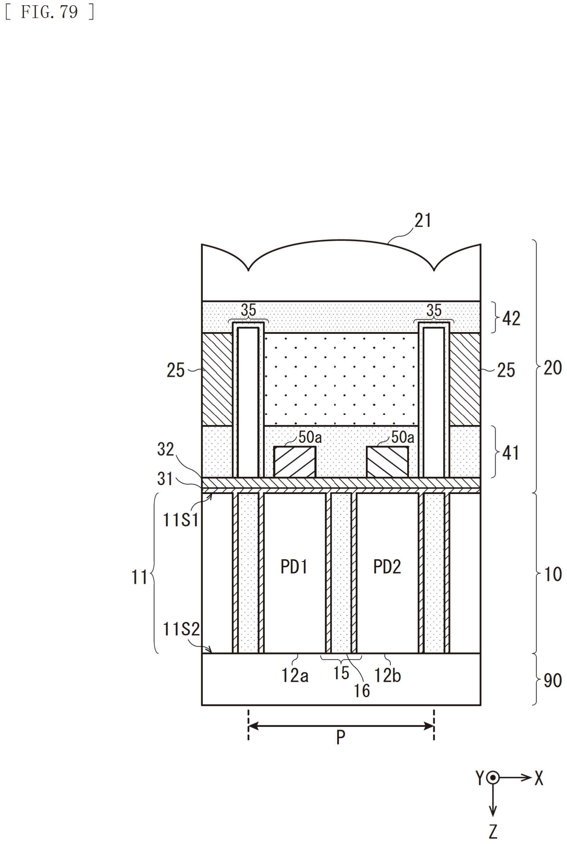

As in the example illustrated in FIG. 79, the light-guiding wall 35 of the imaging device 1 may extend in the Z-axis direction to be provided to the inside of the first insulating layer 41. The light-guiding wall 35 is provided, for example, to reach the antireflection film 32 from between a plurality of color filters 25 adjacent to each other. The light-guiding wall 35 may be provided to surround the first light-guiding member 50a and the second light-guiding member 50b in the first insulating layer 41.

### (8. Seventh Embodiment)

Next, description is given of a seventh embodiment of the present disclosure. Hereinafter, components similar to those of the foregoing embodiments are denoted by the same reference numerals, and descriptions thereof are omitted as appropriate.

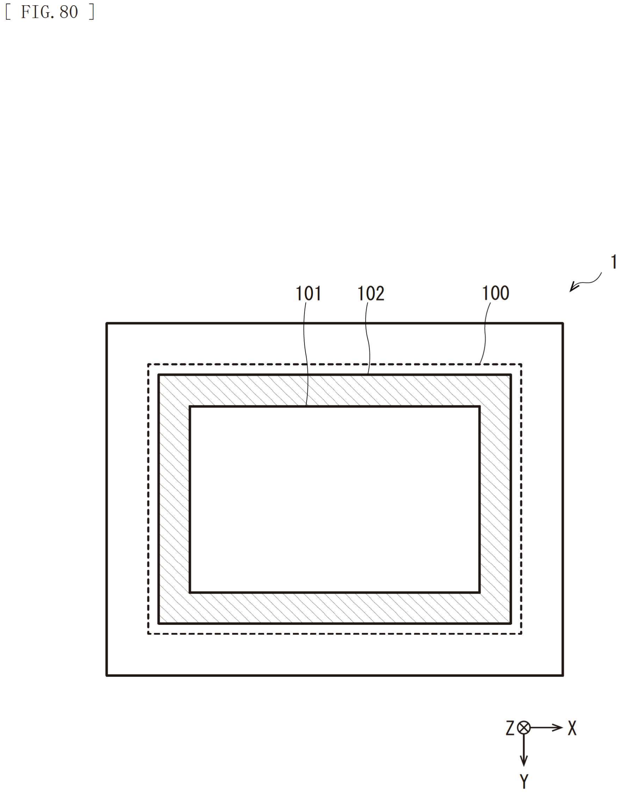

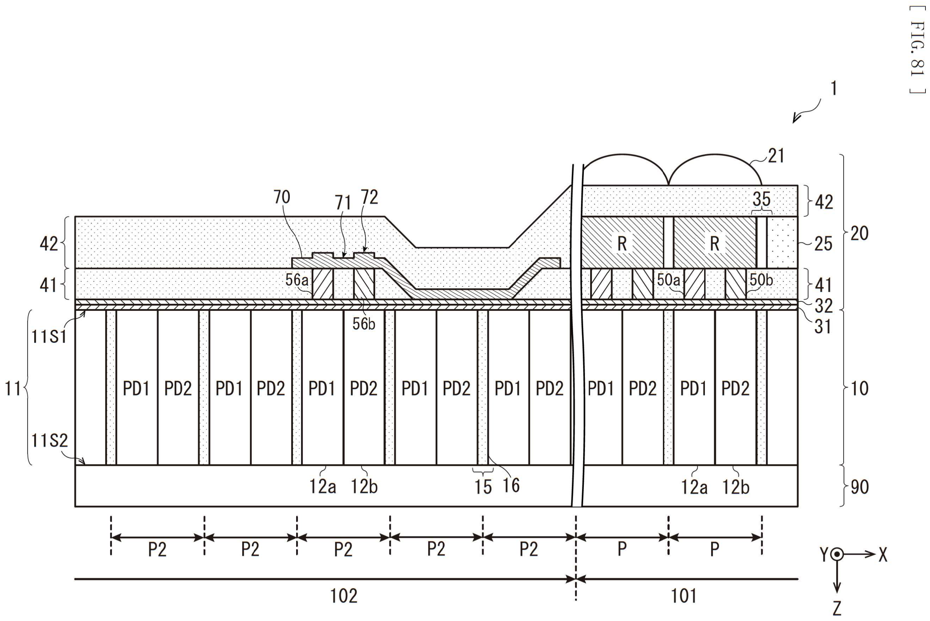

FIG. 80 is an explanatory diagram of a configuration example of an imaging device according to the seventh embodiment of the present disclosure. In addition, FIG. 81 is a diagram illustrating an example of a cross-sectional configuration of the imaging device. The imaging device 1 includes a region in which the plurality of pixels P are provided (referred to as an effective pixel region 101) and a region provided around the effective pixel region 101 (referred to as a dummy pattern region 102).

In the effective pixel region 101, the pixels P as effective pixels are two-dimensionally arranged. In the effective pixel region 101, for example, the plurality of pixels P are provided to be aligned in the horizontal direction and in the vertical direction. As an example, as described above, the plurality of pixels Pr, the plurality of pixels Pg, and the plurality of pixels Pb are arranged in accordance with Bayer arrangement. It is to be noted that the number and arrangement of the pixels P in the effective pixel region 101 may be set optionally.

The dummy pattern region 102 is provided to surround the effective pixel region 101, for example, as illustrated in FIG. 80. As an example, in the dummy pattern region 102, a plurality of cells P2 are two-dimensionally arranged to surround the effective pixel region 101. As illustrated in FIG. 81, for example, the cell P2 includes the first photoelectric conversion section 12a and the second photoelectric conversion section 12b in the same manner as the pixel P, and can also be referred to as a dummy pixel.

As in the example illustrated in FIG. 81, the dummy pattern region 102 is provided with a structure 56a, a structure 56b, and a light-blocking member 70. The structure 56a and the structure 56b are configured using the same material as those of the first light-guiding member 50a and the second light-guiding member 50b, for example. The structure 56a and the structure 56b are each a member configured by a high refractive index material, and can also be referred to as a high refractive index section. In addition, the structure 56a and the structure 56b can also be referred to as dummy pattern (or dummy member).

As an example, the structure 56a is provided above the first photoelectric conversion section 12a of the cell P2, and has a refractive index higher than a refractive index of an adjacent medium. In addition, as an example, the structure 56b is provided above the second photoelectric conversion section 12b of the cell P2, and has a refractive index higher than a refractive index of an adjacent medium.

In the example illustrated in FIG. 81, the structure 56a and the structure 56b are provided in the first insulating layer 41. The structure 56a and the structure 56b are configured by a material having a refractive index higher than the refractive index of the first insulating layer 41. The structures 56a and 56b each have a refractive index higher than the refractive index of silicon dioxide (SiO₂).

The light-blocking member 70 is provided on the structure 56a and the structure 56b in the dummy pattern region 102, for example. As in the example illustrated in FIG. 81, the light-blocking member 70 is provided to cover the structure 56a and the structure 56b, and has an uneven shape. The light-blocking member 70 may have a plurality of recesses and a plurality of protrusions, and may have an uneven structure.

For example, the light-blocking member 70 (light-blocking section) is formed on the structures 56a and 56b, and has a recess C11 and a protrusion C12. In the example illustrated in FIG. 81, the protrusion C12 of the light-blocking member 70 is formed on the structure 56b and on the structure 56a. It is to be noted that the numbers and arrangements of the recess C11 and the protrusion C12 are not limited to those of the illustrated example and may be changed as appropriate.

The light-blocking member 70 is a light-blocking section (light-blocking film) configured by a member that blocks light. The light-blocking member 70 is configured using, for example, a metal material that blocks light. The light-blocking member 70 may be configured by a material that absorbs light. As an example, the light-blocking member 70 is formed using tungsten (W). It is to be noted that the light-blocking member 70 may be formed using another material. The light-blocking member 70 may be configured by a stacked film in which a plurality of films are stacked.

In the imaging device 1 according to the present embodiment, the light-blocking member 70 having an uneven shape is provided on the structure 56a and the structure 56b in the dummy pattern region 102. It is therefore possible, in the imaging device 1, to reduce reflected light, thus making it possible to suppress mixing of a noise caused by reflected light into a pixel signal.

It is possible, in the imaging device 1, to suppress occurrence of flare, thus making it possible to prevent a decrease in image quality of an image. It is possible to suppress mixing of a noise into a pixel signal and thus to suppress a decrease in the accuracy of phase difference detection using a pixel signal. In addition, providing the dummy pattern region 102 with the structure 56a (and the structure 56b) makes it possible to improve planarity of the first insulating layer 41 or the like.

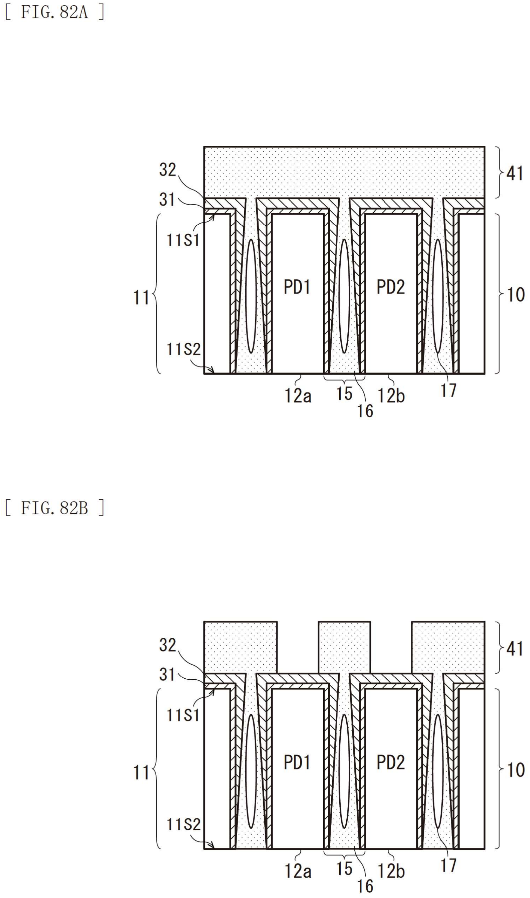

FIGs. 82A to 82D are each a diagram illustrating an example of a method of manufacturing the imaging device according to the seventh embodiment. First, as illustrated in FIG. 82A, for example, a silicon oxide film is formed as the first insulating layer 41 on the semiconductor substrate 11 in which the first photoelectric conversion section 12a, the second photoelectric conversion section 12b, and the like are formed. Then, as illustrated in FIG. 82B, the first insulating layer 41 is selectively removed by lithography and dry etching.

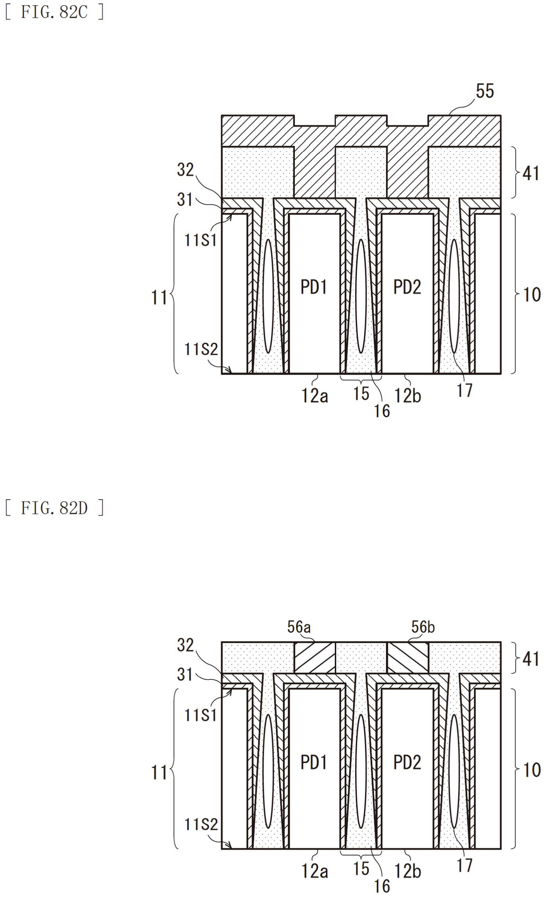

Next, as illustrated in FIG. 82C, the high refractive index section 55 including a high refractive material is formed. Then, a resist film is formed on the high refractive index section 55, and thereafter the structure 56a and the structure 56b are formed by EB (electron beam), as illustrated in FIG. 82D. It is to be noted that CMP processing may be adopted to form the structure 56a and the structure 56b after the formation of the high refractive index section 55 illustrated in FIG. 82C.

In the effective pixel region 101, the first light-guiding member 50a and the second light-guiding member 50b are formed in the first insulating layer 41. Thereafter, the light-blocking member 70, the color filter 25, the second insulating layer 42, the lens section 21, and the like, which are described above, are formed. The manufacturing method as described above makes it possible to manufacture the imaging device 1 including the structure 56a and the structure 56b illustrated in FIG. 81 or other drawings.

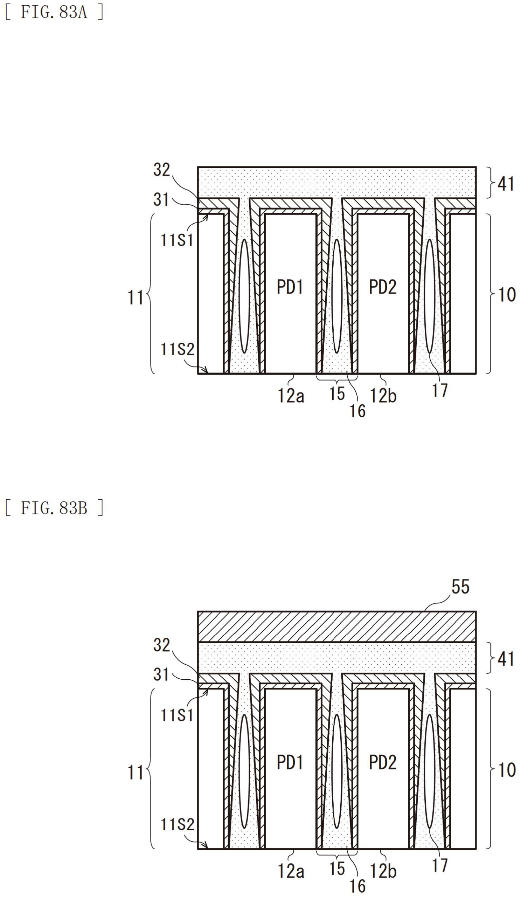

FIGs. 83A to 83E are each a diagram illustrating another example of the method of manufacturing the imaging device according to the seventh embodiment. First, as illustrated in FIG. 83A, for example, a silicon oxide film is formed as the first insulating layer 41 on the semiconductor substrate 11 in which the first photoelectric conversion section 12a, the second photoelectric conversion section 12b, and the like are formed. Then, as illustrated in FIG. 83B, the high refractive index section 55 including a high refractive material is formed on the first insulating layer 41.

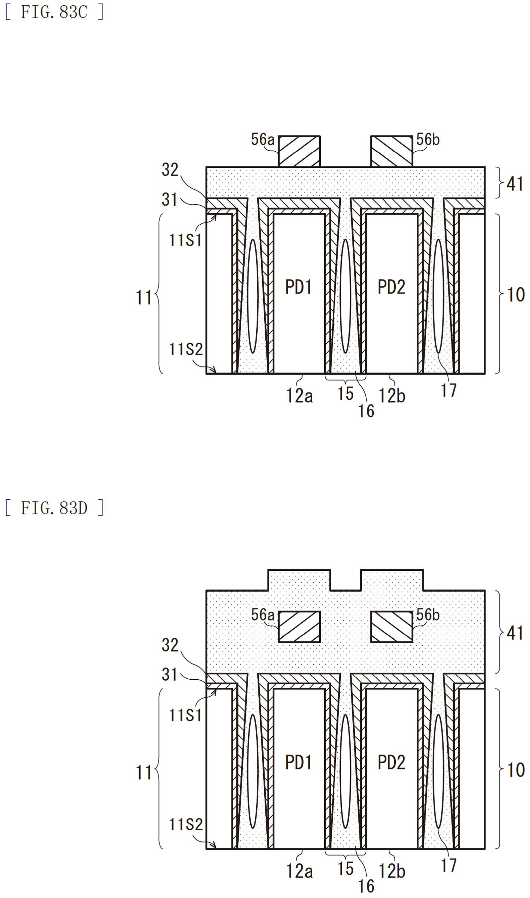

Next, the structure 56a and the structure 56b are formed by lithography and dry etching, as illustrated in FIG. 83C. It is to be noted that, in the effective pixel region 101, the first light-guiding member 50a and the second light-guiding member 50b are formed by lithography and dry etching.

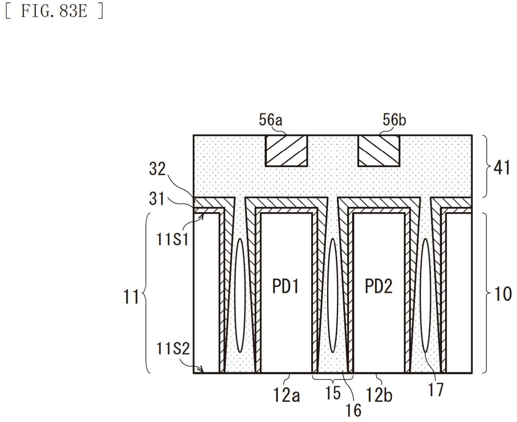

Next, as illustrated in FIG. 83D, for example, a silicon oxide film is formed as the first insulating layer 41 around the structure 56a and the structure 56b. Then, a resist film is formed on the first insulating layer 41, and thereafter the first insulating layer 41 is partially removed by EB (electron beam), as illustrated in FIG. 83E. It is to be noted that CMP processing may be adopted to partially remove the first insulating layer 41.

Then, the light-blocking member 70, the color filter 25, the second insulating layer 42, the lens section 21, and the like, which are described above, are formed. The manufacturing method as described above enables the imaging device 1 illustrated in FIG. 81 or other drawings to be manufactured. It is to be noted that the above-described manufacturing method is merely exemplary and another manufacturing method may also be employed.

### [Workings and Effects]

The photodetector according to the present embodiment includes a first region (effective pixel region 101) including a plurality of pixels each including a first photoelectric conversion section (e.g., first photoelectric conversion section 12a) provided in a semiconductor layer (semiconductor substrate 11), and a second region (dummy pattern region 102) provided around the first region. The second region includes a first structure (e.g., structure 56a) provided on the semiconductor layer and being configured by the same material as that of a first light-guiding member (e.g., first light-guiding member 50a), and a second light-blocking member (e.g., light-blocking member 70) provided to cover the first structure and having an uneven shape.

In the photodetector (imaging device 1) according to the present embodiment, the light-blocking member 70 having an uneven shape is provided in the dummy pattern region 102. It is therefore possible to suppress occurrence of flare. It becomes possible to achieve a photodetector that makes it possible to suppress a decrease in the accuracy of photodetection.

Next, description is given of modification examples of the present disclosure. Hereinafter, components similar to those of the foregoing embodiments are denoted by the same reference numerals, and descriptions thereof are omitted as appropriate.

### (Modification Example 18)

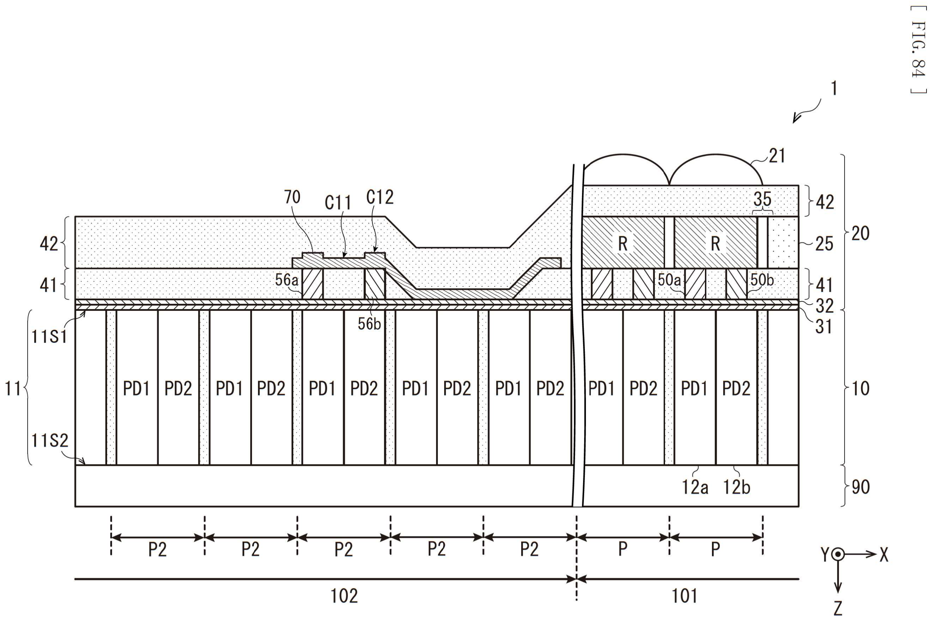

FIG. 84 is a diagram illustrating an example of a cross-sectional configuration of an imaging device according to Modification Example 18 of the present disclosure. A pitch between the structure 56a and the structure 56b (an arrangement interval between the structures 56a and 56b) may differ from a pitch between the first light-guiding member 50a and the second light-guiding member 50b (an arrangement interval between the first light-guiding member 50a and the second light-guiding member 50b).

The pitch between the structures 56a and 56b of the dummy pattern region 102 may be larger than the pitch between the first light-guiding member 50a and the second light-guiding member 50b of the effective pixel region 101, for example. In the example illustrated in FIG. 84, the pitch between the structures 56a and 56b is larger than the pitch between the first light-guiding member 50a and the second light-guiding member 50b in the X-axis direction (or the Y-axis direction).

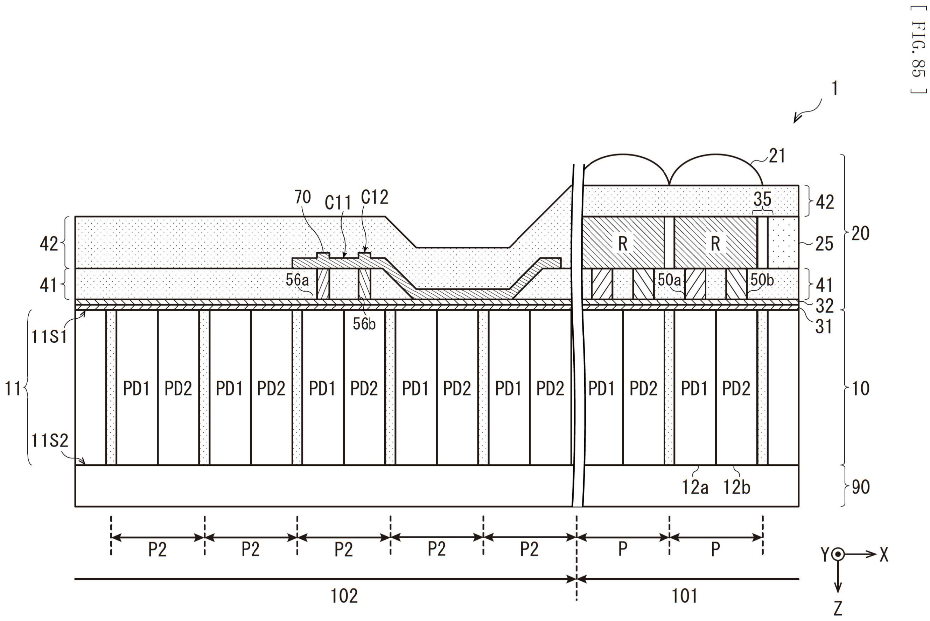

FIG. 85 is a diagram illustrating another example of the cross-sectional configuration of the imaging device according to Modification Example 18. The structure 56a (or the structure 56b) may be formed to have a magnitude (size) that differs from that of the first light-guiding member 50a (or the second light-guiding member 50b). For example, the magnitude (height, width, etc.) of the structure 56a may be smaller than the magnitude of the first light-guiding member 50a (or the second light-guiding member 50b).

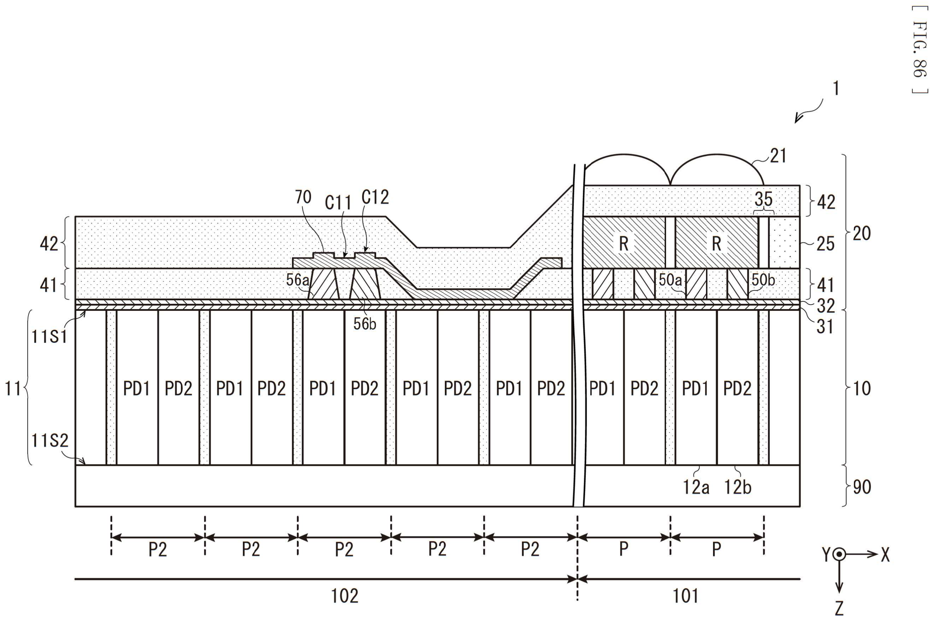

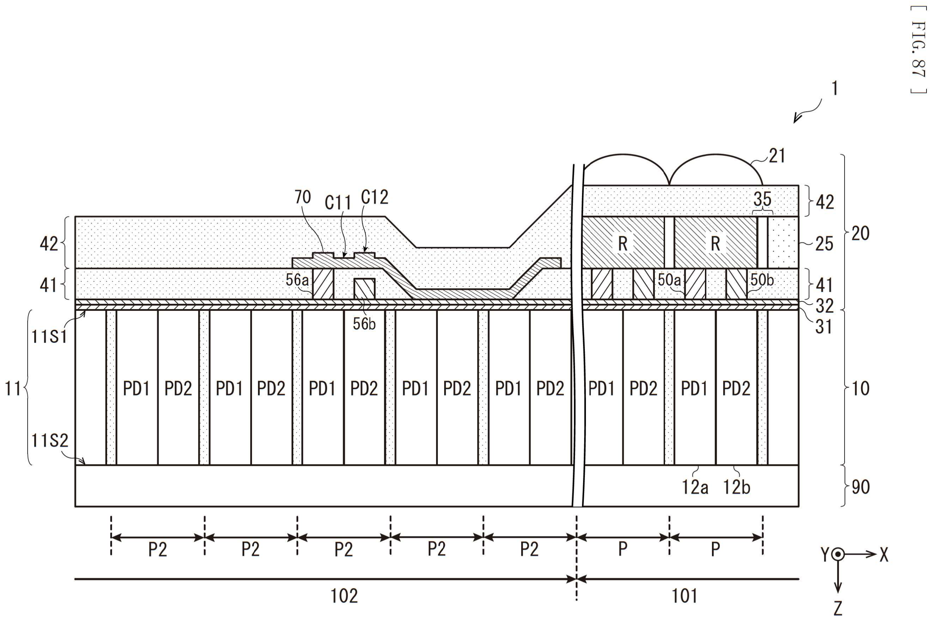

FIGs. 86 and 87 are each a diagram illustrating another example of the cross-sectional configuration of the imaging device according to Modification Example 18. The structure 56a and the structure 56b may each have a tapered shape. In the example illustrated in FIG. 86, the width of the structure 56a in the X-axis direction (and the Y-axis direction) becomes larger as being closer to the first photoelectric conversion section 12a. In addition, the width of the structure 56b in the X-axis direction (and the Y-axis direction) becomes larger as being closer to the second photoelectric conversion section 12b.

As illustrated in FIG. 87, the structure 56a and the structure 56b may have heights different from each other. In the example illustrated in FIG. 87, the structure 56a and the structure 56b have thicknesses (film thicknesses) different from each other. As an example, the height of the structure 56b (height (length) of the structure 56b in the Z-axis direction) may be smaller than the height of the structure 56a.

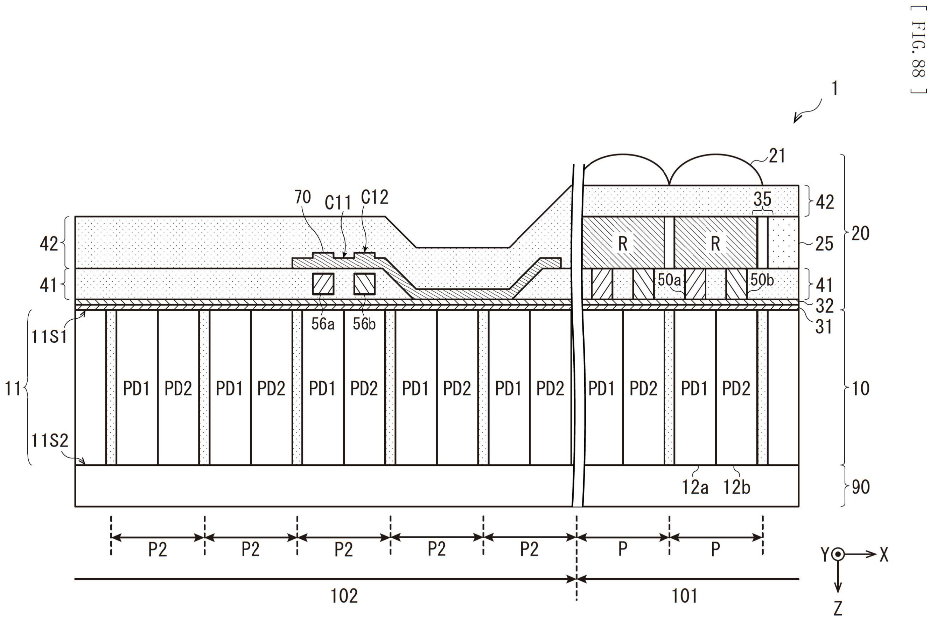

FIG. 88 is a diagram illustrating another example of the cross-sectional configuration of the imaging device according to Modification Example 18. The structure 56a and the structure 56b may be provided in the first insulating layer 41, and may not be in contact with the antireflection film 32. As in the example illustrated in FIG. 88, for example, the structure 56a and the structure 56b may be in a state of being floated away from the antireflection film 32 and the light-blocking member 70.

### (Modification Example 19)

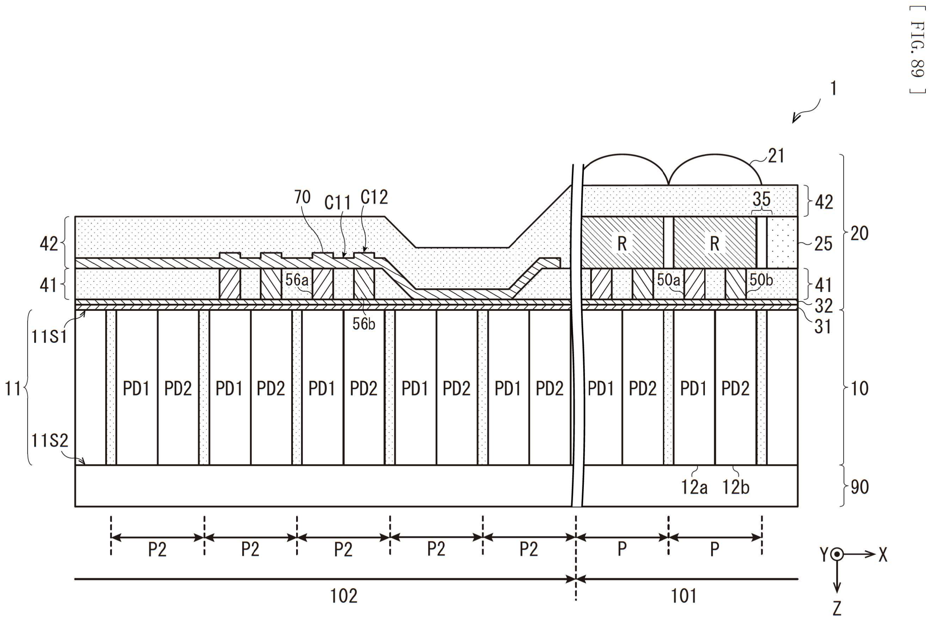

In the foregoing embodiments and modification examples, the description has been given of the configuration examples of the structures 56a and 56b and the light-blocking member 70. However, the configurations of the structures 56a and 56b and the light-blocking member 70 are not limited to those of the above-described examples. FIG. 89 is a diagram illustrating an example of a cross-sectional configuration of an imaging device according to Modification Example 19. As in the example schematically illustrated in FIG. 89, for example, the light-blocking member 70 may be provided across the entire region of the dummy pattern region 102. In addition, the numbers and arrangements of the recess C11 and the protrusion C12 of the light-blocking member 70 and the structures 56a and 56b are not limited to those of the illustrated example, and may be changed as appropriate.

### (Modification Example 20)

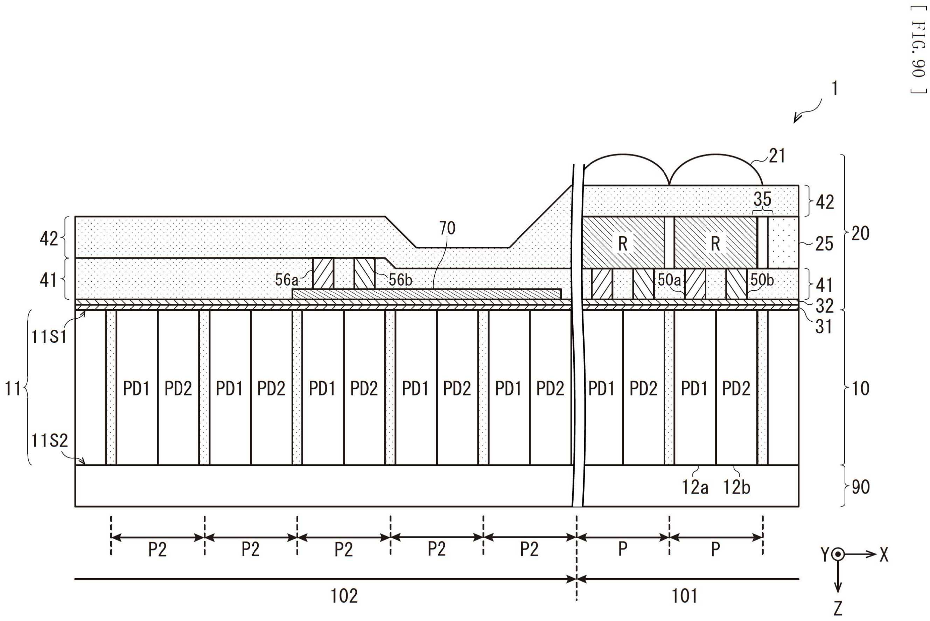

FIG. 90 is an explanatory diagram of a configuration example of an imaging device according to Modification Example 20. As in the example illustrated in FIG. 90, the light-blocking member 70 may be provided below the structure 56a and the structure 56b. For example, the structure 56a and the structure 56b are disposed on the light-blocking member 70 in the first insulating layer 41.

In the imaging device 1 according to the present modification example, the light-blocking member 70 is provided below the structure 56a and the structure 56b in the dummy pattern region 102. The structure 56a and the structure 56b are configured using a high refractive index material. Configuring the imaging device 1 in this manner makes it possible to suppress generation of unnecessary reflected light.

It can also be said that the imaging device 1 has a waveguide structure in which the structure 56a and the structure 56b guide light to the light-blocking member 70. It is possible, in the dummy pattern region 102, to guide light traveling toward the structure 56a and the structure 56b to the light-blocking member 70. It is therefore possible to suppress generation of unnecessary reflected light, thus making it possible to suppress mixing of a noise caused by reflected light into a pixel signal.

As described above, it is possible, in the imaging device 1, to suppress occurrence of flare, thus making it possible to suppress a decrease in image quality of an image. It becomes possible to suppress a decrease in the accuracy of phase difference detection using a pixel signal. In addition, providing the dummy pattern region 102 with the structure 56a (and the structure 56b) makes it possible to improve planarity of the first insulating layer 41 or the like.

The photodetector according to the present modification example includes, in the second region (dummy pattern region 102), the second light-blocking member (light-blocking member 70) provided on the semiconductor layer (semiconductor substrate 11), and a first member (e.g., structure 56a) provided on the second light-blocking member and being configured using the same material as that of the first light-guiding member (e.g., first light-guiding member 50a). It is therefore possible to suppress occurrence of flare. It becomes possible to achieve a photodetector that makes it possible to suppress a decrease in the accuracy of photodetection.

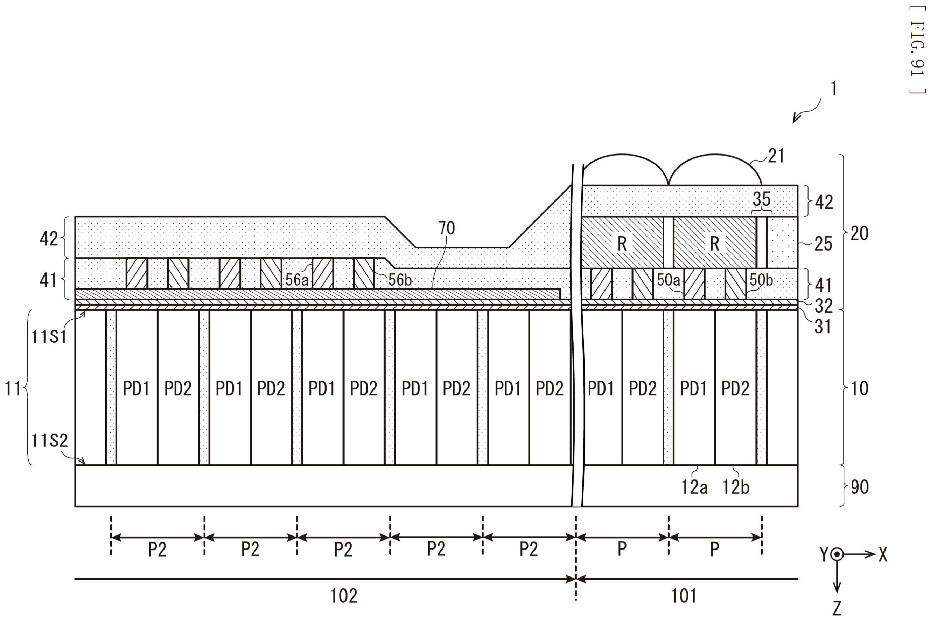

It is to be noted that the configuration of the imaging device 1 is not limited to the illustrated examples and may be changed as appropriate. As in the example illustrated in FIG. 91, for example, the light-blocking member 70 may be provided across the entire region of the dummy pattern region 102. In addition, the numbers and arrangements of the structures 56a and 56b are not limited to those of the illustrated examples, and may be set optionally.

The configurations of the structures 56a and 56b may be changed as appropriate in the same manner as the cases of the examples illustrated in FIGs. 84 to 88 or other drawings. For example, the pitch between the structure 56a and the structure 56b may differ from the pitch between the first light-guiding member 50a and the second light-guiding member 50b. In addition, for example, the structure 56a and the structure 56b may have sizes and shapes that are different from those of the first light-guiding member 50a and the second light-guiding member 50b.

### <9. Application Example>

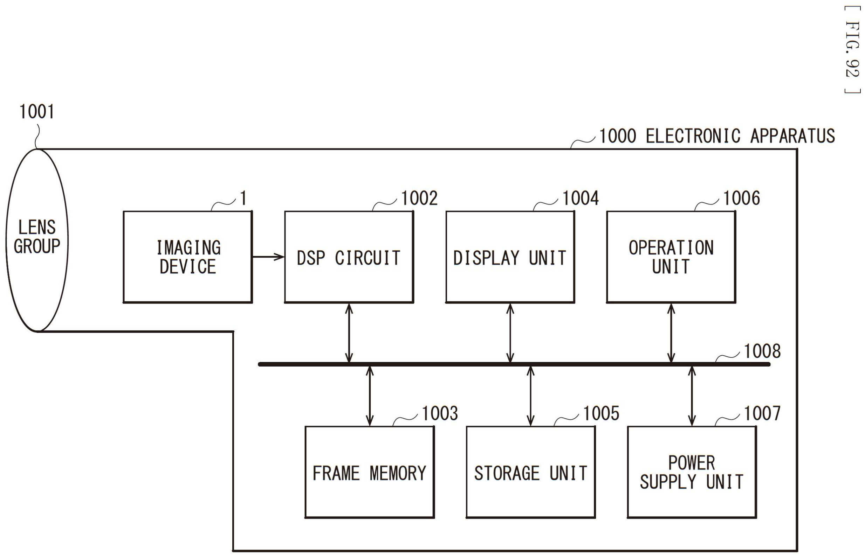

The above-described imaging device 1 or the like is applicable, for example, to any type of electronic apparatus with an imaging function including a camera system such as a digital still camera or a video camera, a mobile phone having an imaging function, and the like. FIG. 92 illustrates a schematic configuration of an electronic apparatus 1000.

The electronic apparatus 1000 includes, for example, a lens group 1001, the imaging device 1, a DSP (Digital Signal Processor) circuit 1002, a frame memory 1003, a display unit 1004, a recording unit 1005, an operation unit 1006, and a power supply unit 1007. They are coupled to each other via a bus line 1008.

The lens group 1001 takes in incident light (image light) from a subject, and forms an image on an imaging surface of the imaging device 1. The imaging device 1 converts the amount of incident light formed as an image on the imaging surface by the lens group 1001 into electric signals on a pixel-by-pixel basis, and supplies the DSP circuit 1002 with the electric signals as pixel signals.

The DSP circuit 1002 is a signal processing circuit that processes signals supplied from the imaging device 1. The DSP circuit 1002 outputs image data obtained by processing the signals from the imaging device 1. The frame memory 1003 temporarily holds the image data processed by the DSP circuit 1002 on a frame-by-frame basis.

The display unit 1004 includes, for example, a panel-type display device such as a liquid crystal panel or an organic EL (Electro Luminescence) panel, and records image data of a moving image or a still image captured by the imaging device 1 in a recording medium such as a semiconductor memory or a hard disk.

The operation unit 1006 outputs an operation signal for a variety of functions of the electronic apparatus 1000 in accordance with an operation by a user. The power supply unit 1007 appropriately supplies the DSP circuit 1002, the frame memory 1003, the display unit 1004, the recording unit 1005, and the operation unit 1006 with various kinds of power for operations of these supply targets.

### <10. Practical Application Examples>

### (Example of Practical Application to Mobile Body)

The technology (the present technology) according to the present disclosure is applicable to a variety of products. For example, the technology according to the present disclosure may be achieved as a device mounted on any type of mobile body such as an automobile, an electric vehicle, a hybrid electric vehicle, a motorcycle, a bicycle, a personal mobility, an aircraft, a drone, a vessel, or a robot.

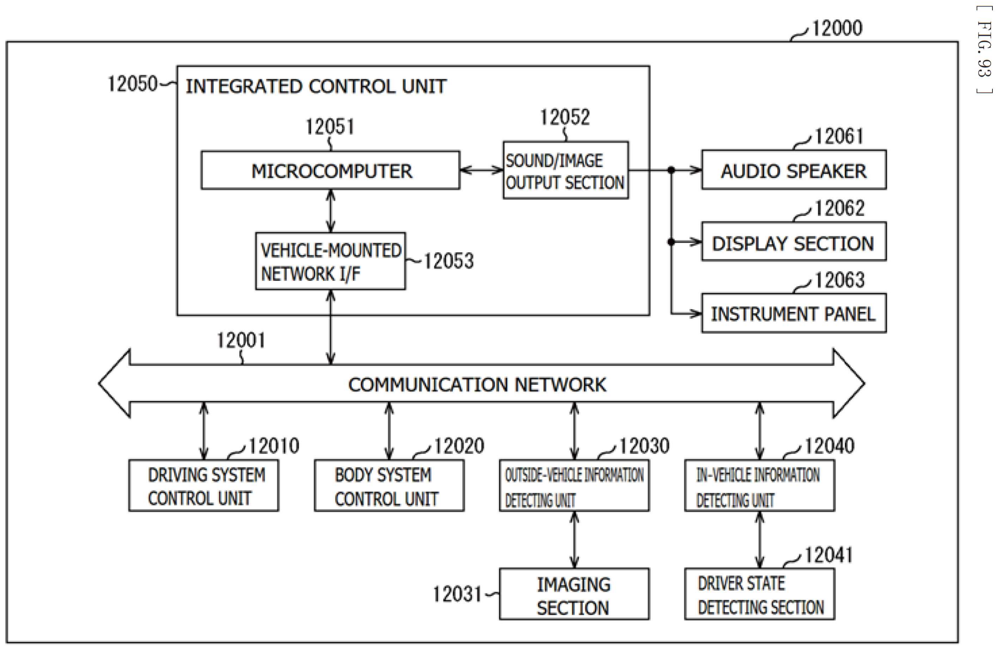

FIG. 93 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 93, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 93, an audio speaker 12061, a display section 12062, and an instrument panel 12063 are illustrated as the output device. The display section 12062 may, for example, include at least one of an on-board display and a head-up display.

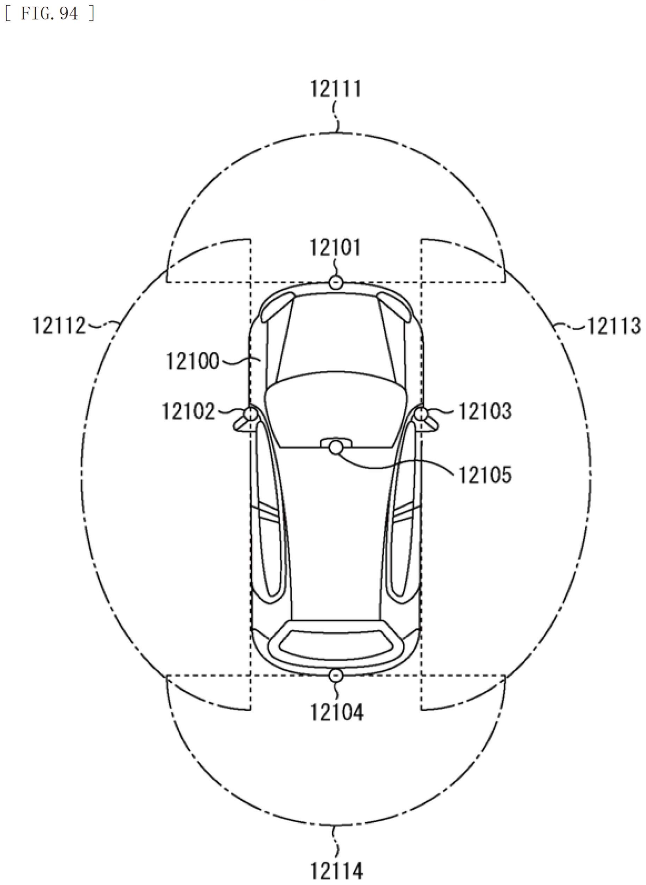

FIG. 94 is a diagram depicting an example of the installation position of the imaging section 12031.

In FIG. 94, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 94 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The description has been given hereinabove of the mobile body control system to which the technology according to an embodiment of the present disclosure is applicable. The technology according to an embodiment of the present disclosure is applicable to the imaging section 12031, for example, of the configurations described above. Specifically, for example, the imaging device 1 or the like can be applied to the imaging section 12031. Applying the technology according to an embodiment of the present disclosure to the imaging section 12031 enables obtainment of a photographed image having high definition, thus making it possible to perform highly accurate control utilizing the photographed image in the mobile body control system.

### (Example of Practical Application to Endoscopic Surgery System)

The technology according to an embodiment of the present disclosure (present technology) is applicable to various products. For example, the technology according to an embodiment of the present disclosure may be applied to an endoscopic surgery system.

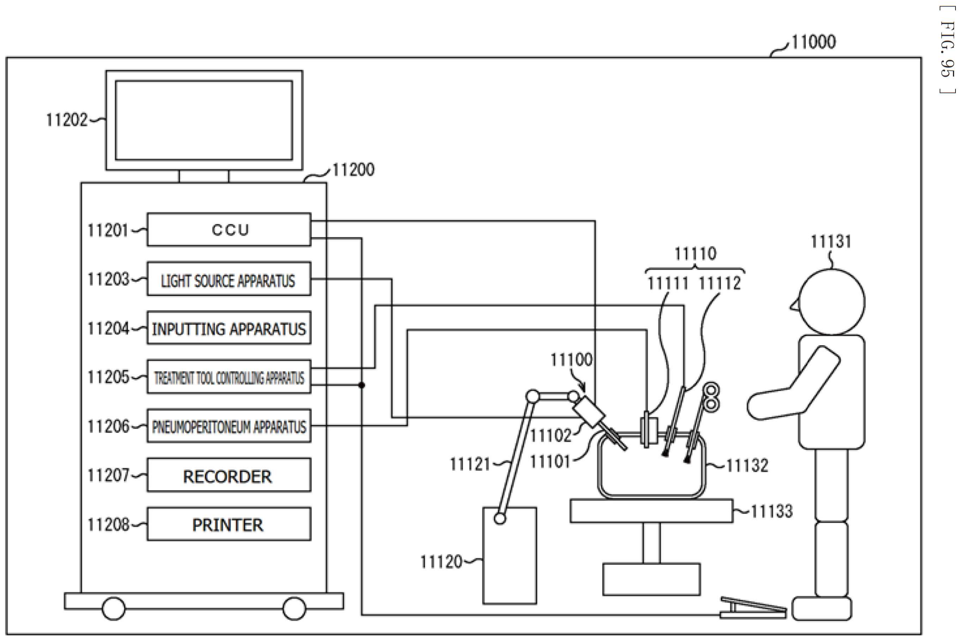

FIG. 95 is a view depicting an example of a schematic configuration of an endoscopic surgery system to which the technology according to an embodiment of the present disclosure (present technology) can be applied.

In FIG. 95, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

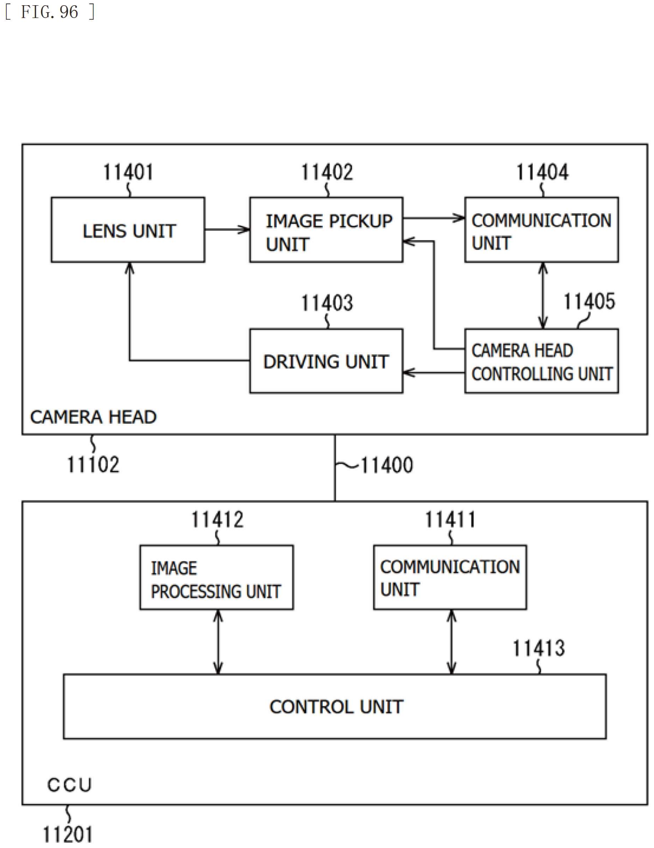

FIG. 96 is a block diagram depicting an example of a functional configuration of the camera head 11102 and the CCU 11201 depicted in FIG. 95.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

The description has been given hereinabove of one example of the endoscopic surgery system, to which the technology according to an embodiment of the present disclosure is applicable. The technology according to an embodiment of the present disclosure is suitably applicable to, for example, the image pickup unit 11402 provided in the camera head 11102 of the endoscope 11100 of the configurations described above. Applying the technology according to an embodiment of the present disclosure to the image pickup unit 11402 enables the image pickup unit 11402 to have high sensitivity, thus making it possible to provide the endoscope 11100 having high definition.

Although the description has been given hereinabove of the present disclosure with reference to the embodiments, the modification examples, the application example, and the practical application examples, the present technology is not limited to the foregoing embodiments and the like, and may be modified in a wide variety of ways. For example, although the foregoing modification examples have been described as modification examples of the foregoing embodiments, the configurations of the respective modification examples may be combined as appropriate.

A photodetector according to an embodiment of the present disclosure includes: a lens on which light is incident; a first photoelectric conversion section that photoelectrically converts light transmitted through the lens; a second photoelectric conversion section provided next to the first photoelectric conversion section and photoelectrically converting light transmitted through the lens; and a first light-guiding member provided above the first photoelectric conversion section and having a refractive index higher than a refractive index of an adjacent medium. It is therefore possible to cause the light-guiding member (e.g., first light-guiding member 50a) to appropriately guide incident light. It is possible to implement a photodetector that is able to suppress deterioration in accuracy of photodetection.

It is to be noted that the effects described herein are merely exemplary and are not limited to the description, and may further include other effects. In addition, the present disclosure may also have the following configurations.
(1) A photodetector including:
   a lens on which light is incident;
   a first photoelectric conversion section that photoelectrically converts light transmitted through the lens;
   a second photoelectric conversion section provided next to the first photoelectric conversion section and photoelectrically converting light transmitted through the lens; and
   a first light-guiding member provided above the first photoelectric conversion section and having a refractive index higher than a refractive index of an adjacent medium.
(2) The photodetector according to (1), further including a color filter, in which
   the first light-guiding member is provided between the color filter and the first photoelectric conversion section.
(3) The photodetector according to (1) or (2), further including a color filter provided above the first photoelectric conversion section and the second photoelectric conversion section, in which
   the first light-guiding member is provided between the lens and the color filter.
(4) The photodetector according to any one of (1) to (3), further including an insulating layer provided above the first photoelectric conversion section and the second photoelectric conversion section, in which
   the first light-guiding member is provided in the insulating layer, and
   the refractive index of the first light-guiding member is higher than a refractive index of the insulating layer.
(5) The photodetector according to any one of (1) to (4), in which the refractive index of the first light-guiding member is higher than a refractive index of silicon dioxide (SiO₂).
(6) The photodetector according to any one of (1) to (5), further including a second light-guiding member provided above the second photoelectric conversion section and having a refractive index higher than a refractive index of an adjacent medium.
(7) The photodetector according to (6), further including a color filter, in which
   the first light-guiding member is provided between the color filter and the first photoelectric conversion section, and
   the second light-guiding member is provided between the color filter and the second photoelectric conversion section.
(8) The photodetector according to (6) or (7), further including the color filter provided above the first photoelectric conversion section and the second photoelectric conversion section, in which
   the first light-guiding member and the second light-guiding member are provided between the lens and the color filter.
(9) The photodetector according to any one of (6) to (8), further including an insulating layer provided around the first light-guiding member and the second light-guiding member, in which
   the refractive index of the first light-guiding member and the refractive index of the second light-guiding member are each higher than the refractive index of the insulating layer.
(10) The photodetector according to any one of (6) to (9), in which the refractive index of the first light-guiding member and the refractive index of the second light-guiding member are each higher than the refractive index of silicon dioxide (SiO₂).
(11) The photodetector according to any one of (6) to (10), in which the first light-guiding member and the second light-guiding member each include a metal oxide.
(12) The photodetector according to any one of (6) to (11), in which a size of the first light-guiding member and a size of the second light-guiding member are different from each other.
(13) The photodetector according to any one of (6) to (12), further including a light-receiving section including a plurality of the first photoelectric conversion sections and a plurality of the second photoelectric conversion sections, in which
   a center of the second light-guiding member is positioned closer to a center of the light-receiving section than a center of the first light-guiding member, and
   the size of the first light-guiding member is smaller than the size of the second light-guiding member.
(14) The photodetector according to any one of (6) to (13), in which the first light-guiding member and the second light-guiding member each have a quadrangular shape.
(15) The photodetector according to any one of (6) to (14), in which the first light-guiding member and the second light-guiding member each have a circular shape.
(16) The photodetector according to any one of (6) to (15), in which the first light-guiding member and the second light-guiding member each have a tapered shape.
(17) The photodetector according to any one of (6) to (16), in which
   the first photoelectric conversion section photoelectrically converts light incident via the first light-guiding member, and
   the second photoelectric conversion section photoelectrically converts light incident via the second light-guiding member.
(18) The photodetector according to any one of (1) to (17), further including a pixel including at least one of the first photoelectric conversion section or the second photoelectric conversion section, in which
   the pixel includes a pixel usable for detection of a phase difference.
(19) The photodetector according to any one of (1) to (18), further including a pixel including the first photoelectric conversion section and the second photoelectric conversion section, in which
   the pixel is configured to output, as a signal to be used for detection of a phase difference, a first signal based on electric charge generated by the first photoelectric conversion section and a second signal based on electric charge generated by the second photoelectric conversion section.
(20) The photodetector according to any one of (1) to (19), further including:
   a plurality of pixels each including the first photoelectric conversion section provided in a semiconductor layer; and
   a first light-blocking member provided on a light incident side of the semiconductor layer, in which
   at least a portion of the first light-blocking member is provided at a boundary between the plurality of pixels adjacent to each other.
(21) The photodetector according to according to any one of (1) to (20), in which a width of the first light-guiding member on a side opposite to a side of the first photoelectric conversion section is larger than a width of the first light-guiding member on the side of the first photoelectric conversion section.
(22) The photodetector according to according to any one of (1) to (21), further including the second light-guiding member provided above the second photoelectric conversion section, the second light-guiding member having a refractive index higher than a refractive index of an adjacent medium, in which
   the width of the first light-guiding member on the side opposite to the side of the first photoelectric conversion section is larger than the width of the first light-guiding member on the side of the first photoelectric conversion section, and
   a width of the second light-guiding member on a side opposite to a side of the second photoelectric conversion section is larger than a width of the second light-guiding member on the side of the second photoelectric conversion section.
(23) The photodetector according to according to any one of (1) to (22), further including:
   a first region including a plurality of pixels each including the first photoelectric conversion section provided in the semiconductor layer; and
   a second region provided around the first region, in which
   the second region includes
      a first structure provided on the semiconductor layer and being configured using a material same as the first light-guiding member, and
      a second light-blocking member provided to cover the first structure and having an uneven shape.
(24) The photodetector according to according to any one of (1) to (22), further including:
   a first region including a plurality of pixels each including the first photoelectric conversion section provided in the semiconductor layer; and
   a second region provided around the first region, in which
   the second region includes
      a second light-blocking member provided on the semiconductor layer, and
      a first structure provided on the second light-blocking member and being configured using a material same as the first light-guiding member.
(25) An electronic apparatus including:
   an optical system; and
   a photodetector that receives light transmitted through the optical system,
   the photodetector including
      a lens on which light is incident,
      a first photoelectric conversion section that photoelectrically converts light transmitted through the lens,
      a second photoelectric conversion section provided next to the first photoelectric conversion section and photoelectrically converting light transmitted through the lens, and
      a first light-guiding member provided above the first photoelectric conversion section and having a refractive index higher than a refractive index of an adjacent medium.

The present application claims the benefit of Japanese Priority Patent Application JP2022-210858 filed with the Japan Patent Office on December 27, 2022, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. A photodetector comprising:
a lens on which light is incident;
a first photoelectric conversion section that photoelectrically converts light transmitted through the lens;
a second photoelectric conversion section provided next to the first photoelectric conversion section and photoelectrically converting light transmitted through the lens; and
a first light-guiding member provided above the first photoelectric conversion section and having a refractive index higher than a refractive index of an adjacent medium.

2. The photodetector according to claim 1, further comprising a color filter, wherein
the first light-guiding member is provided between the color filter and the first photoelectric conversion section.

3. The photodetector according to claim 1, further comprising a color filter provided above the first photoelectric conversion section and the second photoelectric conversion section, wherein
the first light-guiding member is provided between the lens and the color filter.

4. The photodetector according to claim 1, further comprising an insulating layer provided above the first photoelectric conversion section and the second photoelectric conversion section, wherein
the first light-guiding member is provided in the insulating layer, and
the refractive index of the first light-guiding member is higher than a refractive index of the insulating layer.

5. The photodetector according to claim 1, wherein the refractive index of the first light-guiding member is higher than a refractive index of silicon dioxide (SiO₂).

6. The photodetector according to claim 1, further comprising a second light-guiding member provided above the second photoelectric conversion section and having a refractive index higher than a refractive index of an adjacent medium.

7. The photodetector according to claim 6, further comprising a color filter, wherein
the first light-guiding member is provided between the color filter and the first photoelectric conversion section, and
the second light-guiding member is provided between the color filter and the second photoelectric conversion section.

8. The photodetector according to claim 6, further comprising a color filter provided above the first photoelectric conversion section and the second photoelectric conversion section, wherein
the first light-guiding member and the second light-guiding member are provided between the lens and the color filter.

9. The photodetector according to claim 6, further comprising an insulating layer provided around the first light-guiding member and the second light-guiding member, wherein
the refractive index of the first light-guiding member and the refractive index of the second light-guiding member are each higher than a refractive index of the insulating layer.

10. The photodetector according to claim 6, wherein the refractive index of the first light-guiding member and the refractive index of the second light-guiding member are each higher than a refractive index of silicon dioxide (SiO₂).

11. The photodetector according to claim 6, wherein the first light-guiding member and the second light-guiding member each include a metal oxide.

12. The photodetector according to claim 6, wherein a size of the first light-guiding member and a size of the second light-guiding member are different from each other.

13. The photodetector according to claim 6, further comprising a light-receiving section including a plurality of the first photoelectric conversion sections and a plurality of the second photoelectric conversion sections, wherein
a center of the second light-guiding member is positioned closer to a center of the light-receiving section than a center of the first light-guiding member, and
a size of the first light-guiding member is smaller than a size of the second light-guiding member.

14. The photodetector according to claim 6, wherein the first light-guiding member and the second light-guiding member each have a quadrangular shape.

15. The photodetector according to claim 6, wherein the first light-guiding member and the second light-guiding member each have a circular shape.

16. The photodetector according to claim 6, wherein the first light-guiding member and the second light-guiding member each have a tapered shape.

17. The photodetector according to claim 6, wherein
the first photoelectric conversion section photoelectrically converts light incident via the first light-guiding member, and
the second photoelectric conversion section photoelectrically converts light incident via the second light-guiding member.

18. The photodetector according to claim 1, further comprising a pixel including at least one of the first photoelectric conversion section or the second photoelectric conversion section, wherein
the pixel comprises a pixel usable for detection of a phase difference.

19. The photodetector according to claim 1, further comprising a pixel including the first photoelectric conversion section and the second photoelectric conversion section, wherein
the pixel is configured to output, as a signal to be used for detection of a phase difference, a first signal based on electric charge generated by the first photoelectric conversion section and a second signal based on electric charge generated by the second photoelectric conversion section.

20. The photodetector according to claim 1, further comprising:
a plurality of pixels each including the first photoelectric conversion section provided in a semiconductor layer; and
a first light-blocking member provided on a light incident side of the semiconductor layer, wherein
at least a portion of the first light-blocking member is provided at a boundary between the plurality of pixels adjacent to each other.

21. The photodetector according to claim 1, wherein a width of the first light-guiding member on a side opposite to a side of the first photoelectric conversion section is larger than a width of the first light-guiding member on the side of the first photoelectric conversion section.

22. The photodetector according to claim 1, further comprising a second light-guiding member provided above the second photoelectric conversion section, the second light-guiding member having a refractive index higher than a refractive index of an adjacent medium, wherein
a width of the first light-guiding member on a side opposite to a side of the first photoelectric conversion section is larger than a width of the first light-guiding member on the side of the first photoelectric conversion section, and
a width of the second light-guiding member on a side opposite to a side of the second photoelectric conversion section is larger than a width of the second light-guiding member on the side of the second photoelectric conversion section.

23. The photodetector according to claim 1, further comprising:
a first region including a plurality of pixels each including the first photoelectric conversion section provided in a semiconductor layer; and
a second region provided around the first region, wherein
the second region includes
a first structure provided on the semiconductor layer and being configured using a material same as the first light-guiding member, and
a second light-blocking member provided to cover the first structure and having an uneven shape.

24. The photodetector according to claim 1, further comprising:
a first region including a plurality of pixels each including the first photoelectric conversion section provided in a semiconductor layer; and
a second region provided around the first region, wherein
the second region includes
a second light-blocking member provided on the semiconductor layer, and
a first structure provided on the second light-blocking member and being configured using a material same as the first light-guiding member.

25. An electronic apparatus comprising:
an optical system; and
a photodetector that receives light transmitted through the optical system,
the photodetector including
a lens on which light is incident,
a first photoelectric conversion section that photoelectrically converts light transmitted through the lens,
a second photoelectric conversion section provided next to the first photoelectric conversion section and photoelectrically converting light transmitted through the lens, and
a first light-guiding member provided above the first photoelectric conversion section and having a refractive index higher than a refractive index of an adjacent medium.
